(19) Europäisches Patentamt / European Patent Office / Office européen des brevets

(11) **EP 4 415 500 A1**

(12) **EUROPEAN PATENT APPLICATION**
published in accordance with Art. 153(4) EPC

(43) Date of publication:
**14.08.2024 Bulletin 2024/33**

(21) Application number: **22957807.5**

(22) Date of filing: **09.09.2022**

(51) International Patent Classification (IPC):
**H10K 50/10** *(2023.01)*     **G09G 3/32** *(2016.01)*

(52) Cooperative Patent Classification (CPC):
**G09G 3/32; H10K 50/10**

(86) International application number:
**PCT/CN2022/118241**

(87) International publication number:
**WO 2024/050839 (14.03.2024 Gazette 2024/11)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicants:
• **BOE Technology Group Co., Ltd.**
**Chaoyang District,**
**Beijing 100015 (CN)**
• **Chengdu BOE Optoelectronics Technology Co., Ltd.**
**Chengdu, Sichuan 611731 (CN)**

(72) Inventors:
• **LIU, Biao**
**Beijing 100176 (CN)**

• **MA, Hongwei**
**Beijing 100176 (CN)**
• **ZHANG, Yi**
**Beijing 100176 (CN)**
• **SHANG, Tinghua**
**Beijing 100176 (CN)**
• **DONG, Xiangdan**
**Beijing 100176 (CN)**
• **WANG, Rong**
**Beijing 100176 (CN)**
• **CHU, Zhiwen**
**Beijing 100176 (CN)**

(74) Representative: **Durán-Corretjer, S.L.P.**
**Còrsega, 329**
**(Paseo de Gracia/Diagonal)**
**08037 Barcelona (ES)**

(54) **DISPLAY SUBSTRATE AND DISPLAY APPARATUS**

(57)    A display substrate and a display apparatus. The display substrate comprises a display area (100) and a binding area (200) connected to the display area (100). The display area (100) comprises a plurality of data signal lines (71) and K rows and L columns of sub-pixels (P), K and L being both positive integers greater than 1. A plurality of first spaces (R1) are present between K sub-pixel rows; a plurality of second spaces (R2) are present between L sub-pixel columns; each first space (R1) is located between adjacent two sub-pixel rows; and each second space (R2) is located between adjacent two sub-pixel columns. At least one first space (R1) is provided with a first data connection line (68); at least one second space (R2) is provided with at least one second data connection line (74); one end of the first data connection line (68) is electrically connected to one of the data signal lines (71), and the other end is electrically connected to one second data connection line (74); and one end of the second data connection line (74) is electrically connected to the first data connection line (68), and the other end is electrically connected to the binding area (200).

FIG. 7a

**Description**

Technical Field

The present disclosure relates to, but is not limited to, the field of display technologies, and particularly to a display substrate and a display apparatus.

Background

An Organic Light Emitting Diode (OLED for short) and a Quantum dot Light Emitting Diode (QLED for short) are active light emitting display devices and have advantages such as self-luminescence, a wide viewing angle, a high contrast ratio, low power consumption, an extremely high response speed, lightness and thinness, flexibility, and a low cost. With constant development of display technologies, a flexible display apparatus (Flexible Display) that uses an OLED or a QLED as a light emitting device and performs signal control through a Thin Film Transistor (TFT for short) has become a mainstream product in the field of display at present.

Summary

The following is a summary of subject matters described herein in detail. The summary is not intended to limit the protection scope of claims.

In a first aspect, an embodiment of the present disclosure provides a display substrate including a display region and a bonding region connected with the display region, wherein the display region includes multiple data signal lines and K rows and L columns of sub-pixels, wherein both K and L are positive integers greater than 1; multiple first spaces are included between K sub-pixel rows and multiple second spaces are included between L sub-pixel columns, wherein a first space is located between two adjacent sub-pixel rows, a second space is located between two adjacent sub-pixel columns, at least one first space is provided with a first data connection line, at least one second space is provided with at least one second data connection line, on a plane parallel to the display substrate, the first data connection line extends along a first direction, the second data connection line extends along a second direction, and the first direction intersects with the second direction; one end of the first data connection line is electrically connected with one of the data signal lines, and the other end is electrically connected with one of second data connection lines; one end of the second data connection line is electrically connected with the first data connection line, and the other end is electrically connected with the bonding region.

In an exemplary implementation mode, the first space is further provided with a fourth data connection line and the second space is further provided with a third data connection line; a same second space is provided with at least one second data connection line and at least one third data connection line; the fourth data connection line extends along the first direction, one end is electrically connected with a data signal line, and the other end is connected with the third data connection line; the third data connection line extends along the second direction, one end is connected with the fourth data connection line, and the other end is electrically connected with the bonding region; wherein the first data connection line and the second data connection line are connected through a via, and the third data connection line and the fourth data connection line are of an integrally formed structure.

In an exemplary implementation mode, the first data connection line and the fourth data connection line are located in different first spaces.

In an exemplary implementation mode, in the same second space, a quantity of third data connection lines is one, a quantity of second data connection lines is two, in a plane where the display substrate is located, in the first direction, two second data connection lines are located on both sides of a third data connection line, and two second data connection lines in the same second space are connected with different first data connection lines; or, in the same second space, a quantity of third data connection lines is two, a quantity of second data connection lines is one, in the plane where the display substrate is located, in the first direction, two third data connection lines are located on both sides of a second data connection line, and two third data connection lines in the same second space are connected with different fourth data connection lines.

In an exemplary implementation mode, in a same second space, a quantity of the second data connection lines is three, and the three second data connection lines are respectively connected with three different first data connection lines.

In an exemplary implementation mode, at least one sub-pixel includes a pixel drive circuit, in a plane perpendicular to the display substrate, the display substrate includes a base substrate, and a first semiconductor layer, a first conductive layer, a second conductive layer, a second semiconductor layer, a third conductive layer, a fourth conductive layer, and a fifth conductive layer which are sequentially stacked on the base substrate; the first semiconductor layer includes: active layers of multiple low temperature poly silicon transistors located in the pixel drive circuit; the first conductive layer includes: control electrodes of the multiple poly silicon transistors and a first electrode plate of a storage capacitor located in the pixel drive circuit; the second conductive layer includes: a second electrode plate of the storage capacitor located in the pixel drive circuit; the second semiconductor layer includes: active layers of multiple oxide transistors located in the pixel drive circuit; the third conductive layer includes: control electrodes of the multiple oxide transistors located in the pixel drive circuit; the fourth conductive layer includes the first data connection line, and first electrodes and second electrodes of the multiple low temperature poly silicon transistors and first electrodes and second electrodes of the multiple oxide transistors located in the pixel drive circuit; and the fifth conductive layer includes a data signal line, a first power supply line, and the second data connection line.

In an exemplary implementation mode, the display substrate further includes a light emitting element, the multiple low temperature poly silicon transistors include a seventh transistor for resetting an anode of the light emitting element, the third conductive layer further includes a switch connection electrode, the fourth conductive layer further includes multiple second initial signal lines, in a plane where the fourth conductive layer is located, a main body portion of a second initial signal line is in a polyline shape extending along the first direction, the multiple second initial signal lines are arranged in an array along the first direction and the second direction, the second initial signal line is connected with an active layer of the seventh transistor in the first semiconductor layer through a via and multiplexed as a first electrode of the seventh transistor; in a same sub-pixel row, two adjacent second initial signal lines are connected with a same switch connection electrode through a switch via.

In an exemplary implementation mode, the switch connection electrode extends along the first direction, and there is an overlapping region between an orthographic projection of the switch connection electrode on the base substrate and an orthographic projection of one of the second spaces on the base substrate.

In an exemplary implementation mode, the fourth conductive layer further includes a fourth data connection line and a third data connection line, an orthographic projection of the fourth data connection line on the base substrate is at least partially overlapped with an orthographic projection of one of the first spaces on the base substrate, and the orthographic projection of the fourth data connection line on the base substrate is not overlapped with an orthographic projection of the first data connection line on the base substrate; an orthographic projection of the third data connection line on the base substrate is at least partially overlapped with an orthographic projection of one of the second spaces on the base substrate; the third data connection line extends along the second direction, one end is connected with the fourth data connection line, and the other end is electrically connected with the bonding region; the fourth data connection line extends along the first direction, one end is connected with the third data connection line, and the other end is electrically connected with one of the data signal lines in the fifth conductive layer through a via. In an exemplary implementation mode, in a same second space, an orthographic projection of the second data connection line on the base substrate is not overlapped with an orthographic projection of the third data connection line on the base substrate.

In an exemplary implementation mode, in a same second space, a quantity of third data connection lines is one, a quantity of second data connection lines is two, and an orthographic projection of a third data connection line on the base substrate is located between orthographic projections of two second data connection lines on the base substrate; or, in a same second space, a quantity of third data connection lines is two, a quantity of second data connection lines is one, and an orthographic projection of a second data connection line on the base substrate is located between orthographic projections of two third data connection lines on the base substrate.

In an exemplary implementation mode, there is an overlapping region between orthographic projections of the second data connection line and the third data connection line on the base substrate and an orthographic projection of the switch connection electrode on the base substrate, and there is no overlapping region between the orthographic projections of the second data connection line and the third data connection line on the base substrate and an orthographic projection of the second initial signal line on the base substrate.

In an exemplary implementation mode, the pixel drive circuit further includes: a first transistor to a sixth transistor, and a storage capacitor; on a plane parallel to the display substrate, in a same pixel drive circuit, in the first direction, the sixth transistor is located on one side of the storage capacitor, and the fifth transistor and the fourth transistor are located on the other side of the storage capacitor; in the second direction, the fifth transistor, the sixth transistor, and the seventh transistor are located on a same side of the storage capacitor, the fourth transistor, the first transistor, and the second transistor are located on the other side of the storage capacitor, and the seventh transistor is located on a side of the sixth transistor away from the storage capacitor, the first transistor is located on a side of the second transistor away from the storage capacitor, and there is an overlapping region between an orthographic projection of the storage capacitor on the base substrate and an orthographic projection of the third transistor on the base substrate; a seventh transistor in an i-th row of sub-pixels is disposed in an (i-1)-th row of sub-pixels, wherein i=2, 3, ..., K; in the second direction, in two sub-pixel rows adjacent to the first data connection line, a first transistor of a previous sub-pixel row and a fifth transistor and a sixth transistor of a next sub-pixel row are located on both sides of the first data connection line, and a seventh transistor of the next sub-pixel row and the first transistor of the previous sub-pixel row are located on a same side of the first data connection line; in two sub-pixel rows adjacent to the fourth data connection line, a first transistor of a previous sub-pixel row, and a fifth transistor and a sixth transistor of a next sub-pixel row are located on both sides of the fourth data connection line, and a seventh transistor of the next sub-pixel row and the first transistor of the previous sub-pixel row are located on a same side of the fourth data connection line; in the first direction, a total number of second data connection lines and third data connection lines is three, three data connection lines are arranged along the first direction line, two data connection lines located on both sides are symmetrical with respect to a data connection line located at a middle position, and in a same sub-pixel row, a first transistor to a seventh transistor and a storage capacitor in two sub-pixel columns adjacent to a second data connection line and a third data connection line located in a same second space are symmetrical with respect to a data connection line located at a middle position.

In an exemplary implementation mode, in the fourth conductive layer, the fourth data connection line is of an integrally formed structure with a first electrode of a fourth transistor in one of pixel drive circuits, and the first electrode of the fourth transistor integrally formed with the fourth data connection line is of a strip structure or a polyline structure, and extends along the second direction, one terminal is connected with the fourth data connection line, and the other terminal is electrically connected with a data signal line in the fifth conductive layer through a via; one end of the fourth data connection line is connected with the first electrode of the fourth transistor, and the other end is connected with the third data connection line; the first data connection line is of an integrally formed structure with a first electrode of one of fourth transistors, and the first electrode of the fourth transistor integrally formed with the first data connection line is of a strip structure or a polyline structure, and extends along the second direction, one terminal is connected with the first data connection line, and the other terminal is electrically connected with a data signal line in the fifth conductive layer through a via; one end of the first data connection line is connected with the first electrode of the fourth transistor, and the other end is electrically connected with a second data connection line in the fifth conductive layer through a via.

In an exemplary implementation mode, in a same second space, a quantity of second data connection lines is three, and orthographic projections of three second data connection lines on the base substrate are not overlapped, the three second data connection lines are electrically connected with first data connection lines in three different first spaces in the fourth conductive layer through three different vias, respectively.

In an exemplary implementation mode, the display substrate further includes a light emitting element, the multiple low temperature poly silicon transistors include a seventh transistor for resetting the light emitting element, and the fourth conductive layer further includes an initial signal connection line and multiple second initial signal lines; a second initial signal line is connected with an active layer of a seventh transistor in the first semiconductor layer through a via and multiplexed as a first electrode of the seventh transistor; in a plane where the fourth conductive layer is located, a main body portion of the second initial signal line is in a polyline shape extending along the first direction, and the multiple second initial signal lines are arranged along the second direction; the initial signal connection line extends along the second direction and is integrally formed with the multiple second initial signal lines.

In an exemplary implementation mode, among the three second data connection lines, there is an overlapping region between an orthographic projection of a second data connection line at a middle position on the base substrate and an orthographic projection of the initial signal connection line on the base substrate, and there is an overlapping region between orthographic projections of second data connection lines located on both sides on the base substrate and an orthographic projection of the second initial signal line on the base substrate.

In an exemplary implementation mode, the pixel drive circuit further includes: a first transistor to a sixth transistor, and a storage capacitor; on a plane parallel to the display substrate, in a same pixel drive circuit, in the first direction, the sixth transistor is located on one side of the storage capacitor, and the fifth transistor and the fourth transistor are located on the other side of the storage capacitor; in the second direction, the fifth transistor, the sixth transistor, and the seventh transistor are located on a same side of the storage capacitor, the fourth transistor, the first transistor, and the second transistor are located on the other side of the storage capacitor, and the seventh transistor is located on a side of the sixth transistor away from the storage capacitor, the first transistor is located on a side of the second transistor away from the storage capacitor, and there is an overlapping region between an orthographic projection of the storage capacitor on the base substrate and an orthographic projection of the third transistor on the base substrate; a seventh transistor in an i-th row of sub-pixels is disposed in an (i-1)-th row of sub-pixels, wherein i=2, 3, ..., K; in the second direction, in two sub-pixel rows adjacent to the first data connection line, a first transistor of a previous sub-pixel row and a fifth transistor and a sixth transistor of a next sub-pixel row are located on both sides of the first data connection line, and a seventh transistor of the next sub-pixel row and the first transistor of the previous sub-pixel row are located on a same side of the first data connection line; in the first direction, three second data connection lines are arranged in sequence, second data connection lines located on both sides are symmetrical with respect to a second data connection line located at a middle position, and in a same sub-pixel row, a first transistor to a seventh transistor and a storage capacitor in two sub-pixel columns adjacent to three second data connection lines are symmetrical with respect to a second data connection line located at a middle position.

In an exemplary implementation mode, in the fourth conductive layer, the first data connection line is of an integrally formed structure with a first electrode of one of fourth transistors, and the first electrode of the fourth transistor integrally formed with the first data connection line is of a strip structure or a polyline structure, and extends along the second direction, one terminal is connected with the first data connection line, and the other terminal is electrically connected with a data signal line in the fifth conductive layer through a via; one end of the first data connection line is connected with the first electrode of the fourth transistor, and the other end is electrically connected with a second data connection line in the fifth conductive layer through a via.

In an exemplary implementation mode, there is an overlapping region between an orthographic projection of one end of the first data connection line on the base substrate and an orthographic projection of one of second data connection lines on the base substrate, the one end of the first data connection line is electrically connected with the second data connection line through a via in the overlapping region of projections, there is an overlapping region between an orthographic projection of the other end on the base substrate and an orthographic projection of one of the data signal lines on the base substrate, and the other end is electrically connected with the data signal line through a via in the overlapping region of projections.

In a second aspect, an embodiment of the present disclosure further provides a display apparatus, including the display substrate according to any one of the embodiments described above.

In a third aspect, an embodiment of the present disclosure further provides a preparation method of a display substrate, wherein the display substrate includes a display region and a bonding region connected with the display region, the display region includes multiple data signal lines and K rows and L columns of sub-pixels, both K and L are positive integers greater than 1; multiple first spaces are included between K sub-pixel rows and multiple second spaces are included between L sub-pixel columns, a first space is located between two adjacent sub-pixel rows, a second space is located between two adjacent sub-pixel columns, at least one first space is provided with a first data connection line, at least one second space is provided with at least one second data connection line, on a plane parallel to the display substrate, the first data connection line extends along a first direction, the second data connection line extends along a second direction, and the first direction intersects with the second direction; The preparation method includes: electrically connecting one end of the first data connection line with one of the data signal lines, and electrically connecting the other end with one of second data connection lines; electrically connecting one end of the second data connection line with the first data line, and electrically connecting the other end with the bonding region.

After drawings and detailed description are read and understood, other aspects may be comprehended.

Brief Description of Drawings

Accompanying drawings are intended to provide a further understanding of technical solutions of the present disclosure and constitute a part of the specification, and are used for explaining the technical solutions of the present disclosure together with the embodiments of the present disclosure, and do not constitute limitations on the technical solutions of the present disclosure. A shape and a size of each component in the drawings do not reflect actual scales, and are only intended to schematically illustrate contents of the present disclosure.

FIG. 1 is a schematic diagram of a structure of a display apparatus.
FIG. 2 is a schematic diagram of a structure of a display substrate.
FIG. 3 is a schematic diagram of a planar structure of a display region in a display substrate.
FIG. 4 is a schematic diagram of a sectional structure of a display region in a display substrate.
FIG. 5 is a schematic diagram of an equivalent circuit of a pixel drive circuit.
FIG. 6 is a working timing diagram of a pixel drive circuit.
FIG. 7a shows a schematic diagram of a structure of a display substrate according to an exemplary embodiment of the present disclosure.
FIG. 7b shows a schematic diagram of a structure of a display substrate according to an exemplary embodiment of the present disclosure.
FIG. 8a shows a schematic diagram of a structure of a display substrate according to an exemplary embodiment of the present disclosure.
FIG. 8b shows a schematic diagram of a structure of a display substrate according to an exemplary embodiment of the present disclosure.
FIG. 8c shows a schematic diagram of a structure of a display substrate according to an exemplary embodiment of the present disclosure.
FIG. 9 shows a schematic diagram of a display substrate according to an exemplary embodiment of the present disclosure after a pattern of a shielding layer is formed.
FIG. 10a shows a schematic diagram of a display substrate according to an exemplary embodiment of the present disclosure after a pattern of a first semiconductor layer is formed.
FIG. 10b shows a schematic diagram of a first semiconductor layer in a display substrate according to an exemplary embodiment of the present disclosure.
FIG. 11a shows a schematic diagram of a display substrate according to an exemplary embodiment of the present disclosure after a pattern of a first conductive layer is formed.

FIG. 11b shows a schematic diagram of a first conductive layer in a display substrate according to an exemplary embodiment of the present disclosure.

FIG. 12a shows a schematic diagram of a display substrate according to an exemplary embodiment of the present disclosure after a pattern of a second conductive layer is formed.

FIG. 12b shows a schematic diagram of a second conductive layer in a display substrate according to an exemplary embodiment of the present disclosure.

FIG. 13a shows a schematic diagram of a display substrate according to an exemplary embodiment of the present disclosure after a pattern of a second semiconductor layer is formed.

FIG. 13b shows a schematic diagram of a second semiconductor layer in a display substrate according to an exemplary embodiment of the present disclosure.

FIG. 14a shows a schematic diagram of a display substrate according to an exemplary embodiment of the present disclosure after a pattern of a third conductive layer is formed.

FIG. 14b shows a schematic diagram of a third conductive layer in a display substrate according to an exemplary embodiment of the present disclosure.

FIG. 15 shows a schematic diagram of a display substrate according to an exemplary embodiment of the present disclosure after a pattern of a sixth insulation layer is formed.

FIG. 16a shows a schematic diagram of a display substrate according to an exemplary embodiment of the present disclosure after a pattern of a fourth conductive layer is formed.

FIG. 16b shows a schematic diagram of a fourth conductive layer in a display substrate according to an exemplary embodiment of the present disclosure.

FIG. 16c shows a schematic diagram of a display substrate according to an exemplary embodiment of the present disclosure after a pattern of a fourth conductive layer is formed.

FIG. 16d shows a schematic diagram of a fourth conductive layer in a display substrate according to an exemplary embodiment of the present disclosure.

FIG. 17a shows a schematic diagram after a pattern of a first planarization layer is formed according to an exemplary embodiment of the present disclosure.

FIG. 17b shows a schematic diagram after a pattern of a first planarization layer is formed according to an exemplary embodiment of the present disclosure.

FIG. 18a shows a schematic diagram of a display substrate according to an exemplary embodiment of the present disclosure after a pattern of a fifth conductive layer is formed.

FIG. 18b shows a schematic diagram of a fifth conductive layer in a display substrate according to an exemplary embodiment of the present disclosure.

FIG. 18c shows a schematic diagram of a display substrate according to an exemplary embodiment of the present disclosure after a pattern of a fifth conductive layer is formed.

FIG. 19a shows a schematic diagram of a display substrate according to an exemplary embodiment of the present disclosure after a pattern of a first semiconductor layer is formed.

FIG. 19b shows a schematic diagram of a first semiconductor layer in a display substrate according to an exemplary embodiment of the present disclosure.

FIG. 20a shows a schematic diagram of a display substrate according to an exemplary embodiment of the present disclosure after a pattern of a first conductive layer is formed.

FIG. 20b shows a schematic diagram of a first conductive layer in a display substrate according to an exemplary embodiment of the present disclosure.

FIG. 21 shows a schematic diagram of a display substrate according to an exemplary embodiment of the present disclosure after a pattern of a second conductive layer is formed.

FIG. 22 shows a schematic diagram of a display substrate according to an exemplary embodiment of the present disclosure after a pattern of a second semiconductor layer is formed.

FIG. 23a shows a schematic diagram of a display substrate according to an exemplary embodiment of the present disclosure after a pattern of a third conductive layer is formed.

FIG. 23b shows a schematic diagram of a third conductive layer in a display substrate according to an exemplary embodiment of the present disclosure.

FIG. 24 shows a schematic diagram of a display substrate according to an exemplary embodiment of the present disclosure after a pattern of a sixth insulation layer is formed.

FIG. 25a shows a schematic diagram of a display substrate according to an exemplary embodiment of the present disclosure after a pattern of a fourth conductive layer is formed.

FIG. 25b shows a schematic diagram of a fourth conductive layer in a display substrate according to an exemplary embodiment of the present disclosure.

FIG. 25c shows a schematic diagram of a display substrate according to an exemplary embodiment of the present disclosure after a pattern of a fourth conductive layer is formed.

FIG. 25d shows a schematic diagram of a fourth conductive layer in a display substrate according to an exemplary embodiment of the present disclosure.

FIG. 26a shows a schematic diagram of a display substrate according to an exemplary embodiment of the present disclosure after a pattern of a first planarization layer is formed.

FIG. 26b shows a schematic diagram of a display substrate according to an exemplary embodiment of the present disclosure after a pattern of a first planarization layer is formed.

FIG. 27a shows a schematic diagram of a display substrate according to an exemplary embodiment of the present disclosure after a pattern of a fifth conductive layer is formed.

FIG. 27b shows a schematic diagram of a fifth conductive layer in a display substrate according to an exemplary embodiment of the present disclosure.

FIG. 27c shows a schematic diagram of a display substrate according to an exemplary embodiment of the present disclosure after a pattern of a fifth conductive layer is formed.

Detailed Description

The embodiments of the present disclosure will be described below in with reference to the drawings in detail. Implementation modes may be implemented in multiple different forms. Those of ordinary skill in the art may easily understand such a fact that modes and contents may be transformed into various forms without departing from the purpose and scope of the present disclosure. Therefore, the present disclosure should not be explained as being limited to contents recorded in following implementation modes only. The embodiments in the present disclosure and features in the embodiments may be randomly combined with each other in case of no conflict. In order to keep following description of the embodiments of the present disclosure clear and concise, detailed description of part of known functions and known components are omitted in the present disclosure. The drawings in the embodiments of the present disclosure relate only to structures involved in the embodiments of the present disclosure, and other structures may be referred to usual designs.

Scales of the drawings in the present disclosure may be used as a reference in actual processes, but are not limited thereto. For example, a thickness and a pitch of each film layer, and a width and a pitch of each signal line may be adjusted according to an actual situation. The drawings described in the present disclosure are only schematic diagrams of structures, and one mode of the present disclosure is not limited to shapes or numerical values or the like shown in the drawings.

Ordinal numerals "first", "second", "third", etc., in the specification are set not to form limitations in number but only to avoid confusion of constituent elements.

In the specification, for convenience, expressions "central", "above", "below", "front", "back", "vertical", "horizontal", "top", "bottom", "inside", "outside", etc., indicating orientations or positional relationships are used for explaining positional relationships between constituent elements with reference to the drawings, only for convenience of describing the specification and simplifying the description, and do not indicate or imply that a referred apparatus or element must have a specific orientation and be constructed and operated in a specific orientation, and thus should not be understood as limitations on the present disclosure. The positional relationships between the constituent elements are changed as appropriate according to a direction of describing each constituent element. Therefore, appropriate replacements may be made according to situations, not limited to the expressions described in the specification.

In the specification, unless otherwise specified and defined, terms "mounting", "mutual connection", and "connection" should be generally understood. For example, it may be a fixed connection, or a detachable connection, or an integrated connection. It may be a mechanical connection or an electrical connection. It may be a direct connection, or an indirect connection through an intermediate, or communication inside two elements. Those of ordinary skill in the art may understand specific meanings of the above terms in the present disclosure according to specific situations.

In the specification, a transistor refers to an element that at least includes three terminals, i.e., a gate electrode, a drain electrode, and a source electrode. The transistor has a channel region between the drain electrode (drain electrode terminal, drain region, or drain electrode) and the source electrode (source electrode terminal, source region, or source electrode), and a current can flow through the drain electrode, the channel region, and the source electrode. It is to be noted that in the specification, the channel region refers to a region through which a current mainly flows.

In the specification, a first electrode may be a drain electrode, and a second electrode may be a source electrode. Or, the first electrode may be a source electrode, and the second electrode may be a drain electrode. In a case that transistors with opposite polarities are used, or in a case that a direction of a current is changed during work of a circuit, or the like, functions of the "source electrode" and the "drain electrode" are sometimes interchanged. Therefore, in the specification, the "source electrode" and the "drain electrode" may be interchanged, and a "source terminal" and a "drain terminal" may be interchanged. In an embodiment of the present disclosure, a gate electrode may be referred to as a control electrode.

In the specification, an "electrical connection" includes a case that constituent elements are connected together through an element with a certain electrical action. The "element with a certain electrical action" is not particularly limited as long as electrical signals between the connected constituent elements may be sent and received. Examples of the "element with a certain electrical action" not only include an electrode and a wiring, but also include a switching element such as a transistor, a resistor, an inductor, a capacitor, another element with various functions, etc.

In the specification, "parallel" refers to a state in which an angle formed by two straight lines is -10° or more and 10° or less, and thus also includes a state in which the angle is -5° or more and 5° or less. In addition, "perpendicular" refers to a state in which an angle formed by two straight lines is 80° or more and 100° or less, and thus also includes a state in which the angle is 85° or more and 95° or less.

In the specification, a "thin film" and a "layer" are interchangeable. For example, a "conductive layer" may be replaced with a "conductive film" sometimes. Similarly, an "insulation film" may be replaced with an "insulation layer" sometimes.

A triangle, rectangle, trapezoid, pentagon, or hexagon, etc. in the specification is not strictly defined, and it may be an approximate triangle, rectangle, trapezoid, pentagon, or hexagon, etc. There may be some small deformation caused by tolerance, and there may be a chamfer, an arc edge, deformation, etc.

In an embodiment of the present disclosure, "about" refers to that a boundary is not strictly limited and a numerical value within a range of process and measurement errors is allowed.

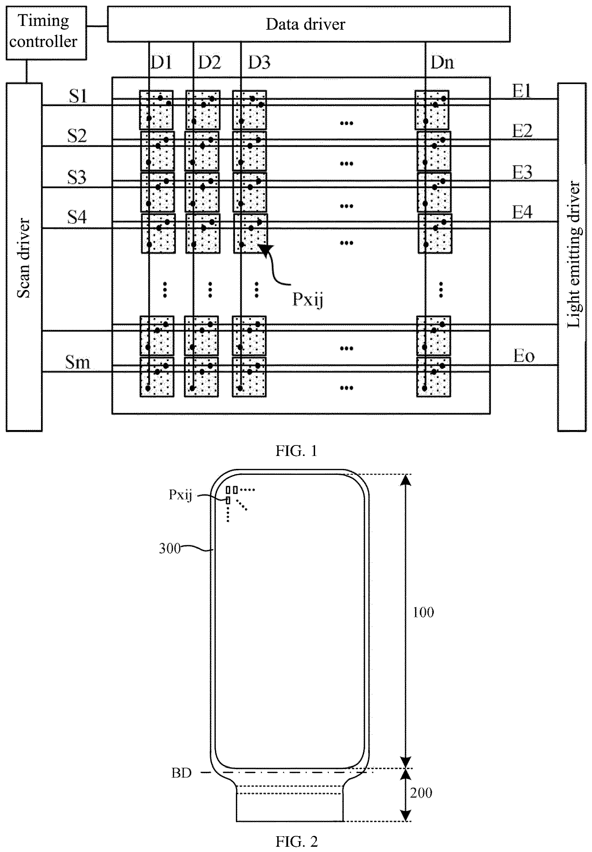

FIG. 1 is a schematic diagram of a structure of a display apparatus. As shown in FIG. 1, the display apparatus may include a timing controller, a data driver, a scan driver, a light emitting driver, and a pixel array. The timing controller is connected with the data driver, the scan driver, and the light emitting driver, respectively, the data driver is connected with multiple data signal lines (D1 to Dn) respectively, the scan driver is connected with multiple scan signal lines (S1 to Sm) respectively, and the light emitting driver is connected with multiple light emitting signal lines (E1 to Eo) respectively. The pixel array may include multiple sub-pixels Pxij, wherein i and j may be natural numbers, at least one sub-pixel Pxij may include a circuit unit and a light emitting device connected with the circuit unit, and the circuit unit may include at least one scan signal line, at least one data signal line, at least one light emitting signal line, and a pixel drive circuit. In an exemplary implementation mode, the timing controller may provide a grayscale value and a control signal suitable for a specification of the data signal driver to the data signal driver, may provide a clock signal, a scan start signal, etc. suitable for a specification of the scan driver to the scan driver, and may provide a clock signal, an emission stop signal, etc. suitable for a specification of the light emitting driver to the light emitting driver. The data driver may generate a data voltage to be provided to the data signal lines D1, D2, D3, ..., and Dn using the grayscale value and the control signal that are received from the timing controller. For example, the data driver may sample the grayscale value using the clock signal and apply a data voltage corresponding to the grayscale value to the data signal lines D1 to Dn by taking a pixel row as a unit, wherein n may be a natural number. The scan driver may generate a scan signal to be provided to the scan signal lines S1, S2, S3, ..., and Sm by receiving the clock signal, the scan start signal, etc. from the timing controller. For example, the scan driver may sequentially provide a scan signal with an on-level pulse to the scan signal lines S1 to Sm. For example, the scan driver may be constructed in a form of a shift register and may generate a scan signal in a manner in which a scan start signal provided in a form of an on-level pulse is transmitted to a next-stage circuit sequentially under control of the clock signal, wherein m may be a natural number. The light emitting driver may generate an emission signal to be provided to the light emitting signal lines E1, E2, E3, ..., and Eo by receiving a clock signal, an emission stop signal, etc., from the timing controller. For example, the light emitting driver may sequentially provide an emission signal with an off-level pulse to the light emitting signal lines E1 to Eo. For example, the light emitting driver may be constructed in a form of a shift register and generate an emission signal in a manner of sequentially transmitting an emission stop signal provided in a form of an off-level pulse to a next-stage circuit under control of the clock signal, wherein o may be a natural number.

FIG. 2 is a schematic diagram of a structure of a display substrate. As shown in FIG. 2, the display substrate may include a display region 100, a bonding region 200 located on a side of the display region 100, and a bezel region 300 located on another side of the display region 100. In an exemplary implementation mode, the display region 100 may be a planar region including multiple sub-pixels Pxij that form a pixel array, the multiple sub-pixels Pxij are configured to display a dynamic picture or a static image, and the display region 100 may be referred to as an Active Area (AA). In an exemplary implementation mode, the display substrate may be a flexible base substrate, so that the display substrate may be deformable, for example, curled, bent, folded, or rolled. In an exemplary implementation mode, the display substrate may further include a display region boundary BD, and the display region boundary BD may be an edge of the display region 100 on a side close to the bonding region 200.

In an exemplary implementation mode, the bonding region 200 may include a fanout region, a bending region, a drive chip region, and a bonding pin region disposed sequentially along a direction away from the display region, wherein the fanout region is connected to the display region and includes multiple data fanout lines, and a data fanout line is configured to connect a data signal line (Data Line) of the display region in a Fanout routing manner. The fanout region occupies relatively large space, resulting in a relatively large width of a lower bezel. The bending region is connected to the fanout region and may include a composite insulation layer provided with a groove, and is configured to enable the bonding region to be bent to a back of the display region. The drive chip region may include an Integrated Circuit (IC for short) and is configured to be connected with multiple data fanout lines. The bonding pin region may include a Bonding Pad, and is configured to be bonded and connected with an external Flexible Printed Circuit board (FPC for short).

In an exemplary implementation mode, the bezel region 300 may include a circuit region, a power supply line region, and a crack dam region, and a cutting region which are sequentially disposed along the direction away from the display region. The circuit region is connected to the display region 100 and may at least include a gate drive circuit, and the gate drive circuit is connected with a first scan signal line, a second scan signal line, a third scan signal line, and a light emitting control line of a pixel drive circuit in the display region. The power supply line region is connected to the circuit region and may at least include a power supply lead line, and the power supply lead line extends along a direction parallel to an edge of the display region and is connected with a cathode in the display region. The crack dam region is connected to the power supply line region and may at least include multiple cracks disposed on the composite insulation layer. The cutting region is connected to the crack dam region and may at least include a cutting groove disposed on the composite insulation layer, and the cutting groove is configured such that a cutting device cuts along the cutting groove respectively after preparation of all film layers of the display substrate are completed.

In an exemplary implementation mode, the fanout region in the bonding region 200 and the power supply line region in the bezel region 300 may be provided with a first dam spacer and a second dam spacer, the first dam spacer and the second dam spacer may extend along the direction parallel to the edge of the display region, thus forming an annular structure surrounding the display region, wherein the edge of the display region is an edge of the display region at a side of the bonding region or the bezel region.

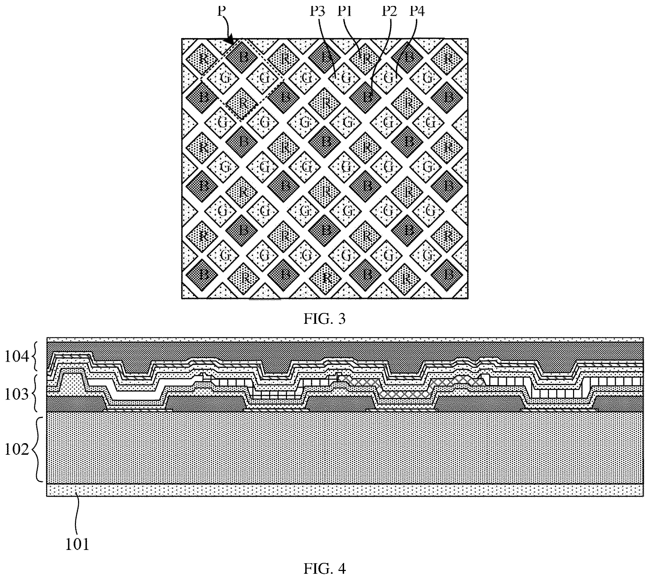

FIG. 3 is a schematic diagram of a planar structure of a display region in a display substrate. As shown in FIG. 3, the display substrate may include multiple pixel units P arranged in a matrix. At least one pixel unit P may include a first sub-pixel P1 emitting light of a first color, a second sub-pixel P2 emitting light of a second color, and a third sub-pixel P3 and a fourth sub-pixel P4 emitting light of a third color. Each sub-pixel may include a circuit unit and a light emitting device, wherein the circuit unit may at least include a pixel drive circuit which is connected with a scan signal line, a data signal line, and a light emitting signal line respectively, and the pixel drive circuit is configured to receive a data voltage transmitted by the data signal line and output a corresponding current to the light emitting device under control of the scan signal line and the light emitting signal line. The light emitting device in each sub-pixel is connected with a pixel drive circuit of a sub-pixel where the light emitting device is located, and is configured to emit light with corresponding brightness in response to a current output by the pixel drive circuit of the sub-pixel where the light emitting device is located.

In an exemplary implementation mode, the first sub-pixel P1 may be a red sub-pixel (R) emitting red light, the second sub-pixel P2 may be a blue sub-pixel (B) emitting blue light, and the third sub-pixel P3 and the fourth sub-pixel P4 may be green sub-pixels (G) emitting green light. In an exemplary implementation mode, a shape of a sub-pixel may be a rectangle, a diamond, a pentagon, or a hexagon. Four sub-pixels may be arranged in a manner of diamond to form an RGBG pixel arrangement. In another exemplary implementation mode, the four sub-pixels may be arranged side by side horizontally, side by side vertically, or in a manner to form a square, which is not limited here in the present disclosure.

In an exemplary implementation mode, a pixel unit may include three sub-pixels, and the three sub-pixels may be arranged side by side horizontally, side by side vertically, or in a manner like a Chinese character "品", which is not limited here in the present disclosure.

FIG. 4 is a schematic diagram of a sectional structure of a display region in a display substrate, illustrating a structure of four sub-pixels in the display region. As shown in FIG. 4, on a plane perpendicular to the display substrate, the display substrate may include a drive circuit layer 102 disposed on a base substrate 101, a light emitting structure layer 103 disposed on a side of the drive circuit layer 102 away from the base substrate 101, and an encapsulation structure layer 104 disposed on a side of the light emitting structure layer 103 away from the base substrate 101. In some possible implementation modes, the display substrate may include another film layer, such as a touch structure layer, which is not limited here in the present disclosure.

In an exemplary implementation mode, the base substrate 101 may be a flexible base substrate, or may be a rigid base substrate. The drive circuit layer 102 of each sub-pixel may include a pixel drive circuit composed of multiple transistors and a storage capacitor. The light emitting structure layer 103 of each sub-pixel may include a light emitting device composed of multiple film layers, wherein the multiple film layers may at least include an anode, a pixel definition layer, an organic emitting layer, and a cathode. The anode is connected with the pixel drive circuit, the organic emitting layer is connected with the anode, the cathode is connected with the organic emitting layer, and the organic emitting layer emits light of a corresponding color under drive of the anode and the cathode. The encapsulation layer 104 may include a first encapsulation layer, a second encapsulation layer, and a third encapsulation layer that are stacked, wherein the first encapsulation layer and the third encapsulation layer may be made of an inorganic material, the second encapsulation layer may be made of an organic material, and the second encapsulation layer is disposed between the first encapsulation layer and the third encapsulation layer to form a laminated structure of an inorganic material/an organic material/an inorganic material, which may ensure that external water vapor cannot enter the light emitting structure layer 103.

In an exemplary implementation mode, the organic emitting layer may include an Emitting Layer (EML), and any one or more of following layers: a Hole Injection Layer (HIL), a Hole Transport Layer (HTL), an Electron Block Layer (EBL), a Hole Block Layer (HBL), an Electron Transport Layer (ETL), and an Electron Injection Layer (EIL). In an exemplary implementation mode, one or more layers of hole injection layers, hole transport layers, electron block layers, hole block layers, electron transport layers, and electron injection layers of all sub-pixels may be a common layer connected together. Emitting layers of adjacent sub-pixels may be overlapped slightly, or may be isolated from each other.

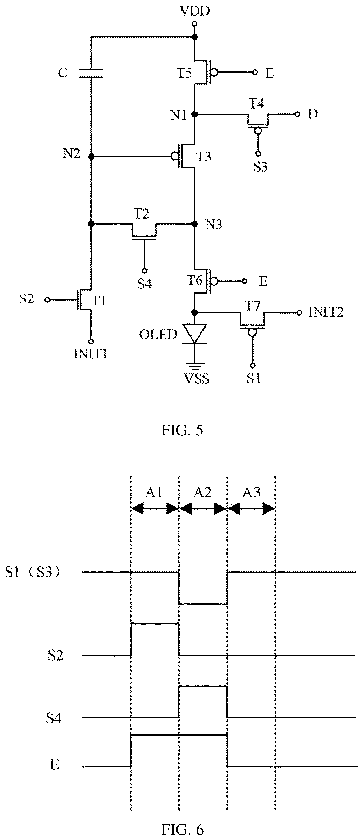

FIG. 5 is a schematic diagram of an equivalent circuit of a pixel drive circuit. In an exemplary implementation mode, the pixel drive circuit may have a structure of 3T1C, 4T1C, 5T1C, 5T2C, 6T1C, 7T1C, or 8T1C. As shown in FIG. 5, the pixel drive circuit may include seven transistors (a first transistor T1 to a seventh transistor T7) and one storage capacitor C, and the pixel drive circuit is respectively connected with ten signal lines (a data signal line D, a first scan signal line S1, a second scan signal line S2, a third scan signal line S3, a fourth scan signal line S4, a light emitting signal line E, a first initial signal line INIT1, a second initial signal line INIT2, a first power supply line VDD, and a second power supply line VSS).

In an exemplary implementation mode, the pixel drive circuit may include a first node N1, a second node N2, and a third node N3. Among them, the first node N1 is respectively connected with a first electrode of the third transistor T3, a second electrode of the fourth transistor T4, and a second electrode of the fifth transistor T5, the second node N2 is respectively connected with a second electrode of the first transistor T1, a control electrode of the third transistor T3, and a second end of the storage capacitor C, and the third node N3 is respectively connected with a second electrode of the second transistor T2, a second electrode of the third transistor T3, and a first electrode of the sixth transistor T6.

In an exemplary implementation mode, a first end of the storage capacitor C is connected with the first power supply line VDD, and the second end of the storage capacitor C is connected with the second node N2, i.e., the second end of the storage capacitor C is connected with the control electrode of the third transistor T3.

In an exemplary implementation mode, a control electrode of the first transistor T1 is connected with the second scan signal line S2, a first electrode of the first transistor T1 is connected with the first initial signal line INIT1, and the second electrode of the first transistor T1 is connected with the second node N2. When a turned-on scan signal is applied to the second scan signal line S2, the first transistor T1 transmits a first initialization voltage to the second end of the storage capacitor C to achieve initialization of the storage capacitor C.

In an exemplary implementation mode, a control electrode of the second transistor T2 is connected with the fourth scan signal line S4, a first electrode of the second transistor T2 is connected with the second electrode of the first transistor T1, and the second electrode of the second transistor T2 is connected with the third node N3. When a turned-on scan signal is applied to the fourth scan signal line S4, the second transistor T2 enables the control electrode of the third transistor T3 to be connected with the second electrode of the third transistor T3.

In an exemplary implementation mode, the control electrode of the third transistor T3 is connected with the second node N2, namely the control electrode of the third transistor T3 is connected with the second end of the storage capacitor C, the first electrode of the third transistor T3 is connected with the first node N1, and the second electrode of the third transistor T3 is connected with the third node N3. The third transistor T3 may be referred to as a drive transistor, and the third transistor T3 determines a magnitude of a drive current flowing between the first power supply line VDD and a light emitting device according to a potential difference between the control electrode and the first electrode of the third transistor T3.

In an exemplary implementation mode, a control electrode of the fourth transistor T4 is connected with the third scan signal line S3, a first electrode of the fourth transistor T4 is connected with the data signal line D, and the second electrode of the fourth transistor T4 is connected with the first node N1. When a turned-on scan signal is applied to the third scan signal line S3, the fourth transistor T4 enables a data voltage of the data signal line D to be input to the first node N1.

In an exemplary implementation mode, a control electrode of the fifth transistor T5 is connected with the light emitting signal line EM, a first electrode of the fifth transistor T5 is connected with the first power supply line VDD, and the second electrode of the fifth transistor T5 is connected with the first node N1. A control electrode of the sixth transistor T6 is connected with the light emitting signal line E, the first electrode of the sixth transistor T6 is connected with the third node N3, and a second electrode of the sixth transistor T6 is connected with a first electrode of the light emitting device. When a turned-on light emitting signal is applied to the light emitting signal line E, the fifth transistor T5 and the sixth transistor T6 enable the light emitting device to emit light by forming a drive current path between the first power supply line VDD and the light emitting device.

In an exemplary implementation mode, a control electrode of the seventh transistor T7 is connected with the first scan signal line S1, a first electrode of the seventh transistor T7 is connected with the second initial signal line INIT2, and a second electrode of the seventh transistor T7 is connected with the first electrode of the light emitting device.

When a turned-on scan signal is applied to the first scan signal line S1, the seventh transistor T7 transmits a second initial voltage to the first electrode of the light emitting device so as to initialize a charge amount accumulated in the first electrode of the light emitting device or release a charge amount accumulated in the first electrode of the light emitting device.

In an exemplary implementation mode, the light emitting device may be an OLED, including a first electrode (anode), an organic emitting layer, and a second electrode (cathode) which are stacked, or may be a QLED, including a first electrode (anode), a quantum dot emitting layer, and a second electrode (cathode) which are stacked.

In an exemplary implementation mode, a second electrode of the light emitting device is connected with the second power supply line VSS, a signal of the second power supply line VSS is a low-level signal, and a signal of the first power supply line VDD is a high-level signal continuously provided.

In an exemplary implementation mode, the first transistor T1 to the seventh transistor T7 may be P-type transistors, or may be N-type transistors. Use of a same type of transistors in a pixel drive circuit may simplify a process flow, reduce a process difficulty of a display panel, and improve a yield of products. In some possible implementation modes, the first transistor T1 to the seventh transistor T7 may include a P-type transistor and an N-type transistor.

In an exemplary implementation mode, for the first transistor T1 to the seventh transistor T7, a low temperature poly silicon transistor may be adopted, or an oxide transistor may be adopted, or a low temperature poly silicon transistor and a metal oxide transistor may be adopted. Low Temperature Poly Silicon (LTPS for short) is adopted for an active layer of a low temperature poly silicon transistor and a metal oxide semiconductor (Oxide) is adopted for an active layer of a metal oxide transistor. A low temperature poly silicon transistor has advantages such as a high migration rate and fast charging, and an oxide transistor has advantages such as a low drain current. The low temperature poly silicon transistor and the metal oxide transistor are integrated on one display substrate to form a Low Temperature Polycrystalline Oxide (LTPO for short) display substrate, such that advantages of the low temperature poly silicon transistor and the metal oxide transistor may be utilized, low-frequency drive may be achieved, power consumption may be reduced, and display quality may be improved.

FIG. 6 is a working timing diagram of a pixel drive circuit. An exemplary embodiment of the present disclosure will be described below through a working process of the pixel drive circuit exemplified in FIG. 5. The pixel drive circuit in FIG. 5 includes seven transistors (a first transistor T1 to a seventh transistor T7) and one storage capacitor C, wherein the first transistor T1 and the second transistor T2 are N-type oxide transistors, and the third transistor T3 to the seven transistor T7 are P-type low temperature poly silicon transistors. In an exemplary implementation mode, the working process of the pixel drive circuit may include following stages.

In a first stage A1, referred to as a reset stage, a signal of the second scan signal line S2 is a turned-on signal (high-level), and signals of the first scan signal line S1, the third scan signal line S3, the fourth scan signal line S4, and the light emitting signal line E are turned-off signals. The turned-on signal of the second scan signal line S2 enables the first transistor T1 to be turned on, and a signal of the first initial signal line INIT1 is provided to the second node N2 through the first transistor T1 to initialize (reset) the storage capacitor C, thereby clearing an original charge in the storage capacitor. The turned-off signals of the first scan signal line S1, the third scan signal line S3, the fourth scan signal line S4, and the light emitting signal line E enable the second transistor T2, the fourth transistor T4, the fifth transistor T5, the sixth transistor T6, and the seventh transistor T7 to be turned off, and an OLED does not emit light in this stage.

In a second stage A2, referred to as a data writing stage or a threshold compensation stage, signals of the first scan signal line S1, the third scan signal line S3, and the fourth scan signal line S4 are turned-on signals, signals of the second scan signal line S2 and the light emitting signal line E are turned-off signals, and the data signal line D outputs a data voltage. In this stage, the second end of the storage capacitor C is at a low level, so the third transistor T3 is turned on. The turned-on signals of the first scan signal terminal S1, the third scan signal terminal S3, and the fourth scan signal terminal S4 enable the second transistor T2, the fourth transistor T4, and the seventh transistor T7 to be turned on. The second transistor T2 and the fourth transistor T4 are turned on, so that the data voltage output by the data signal line D is provided to the second node N2 through the first node N1, the turned-on third transistor T3, the third node N3, and the turned-on second transistor T2, and a difference between the data voltage output by the data signal line D and a threshold voltage of the third transistor T3 is charged into the storage capacitor C. A voltage at the second end (the second node N2) of the storage capacitor C is Vd-IVthl, wherein Vd is the data voltage output by the data signal line D, and Vth is the threshold voltage of the third transistor T3. The seventh transistor T7 is turned on, so that a signal of the second initial signal line INIT2 is provided to a first electrode of the OLED to initialize (reset) the first electrode of the OLED and clear its internal pre-stored voltage, thereby completing initialization and ensuring that the OLED does not emit light. A turned-off signal of the second scan signal line S2 enables the first transistor T1 to be turned off, and a turned-off signal of the light emitting signal line E enables the fifth transistor T5 and the sixth transistor T6 to be turned off.

In a third stage A3, referred to as a light emitting stage, a signal of the light emitting signal line E is a turned-on signal, and signals of the first scan signal line S1, the second scan signal line S2, the third scan signal line S3, and the fourth scan signal line S4 are turned-off signals. The turned-on signal of the light emitting signal line E enables the fifth transistor T5 and the sixth transistor T6 to be turned on, and a power voltage output by the first power supply line VDD provides a drive voltage to the first electrode of the OLED through the turned-on fifth transistor T5, the third transistor T3, and the sixth transistor T6 to drive the OLED to emit light.

In a drive process of the pixel drive circuit, a drive current flowing through the third transistor T3 (drive transistor) is determined by a voltage difference between a gate electrode and a first electrode of the third transistor T3. The voltage of the second node N2 is Vdata-IVthl, so the drive current of the third transistor T3 is as follows.

$$I = K*(Vgs-Vth)^2 = K*[(Vdd-Vd+|Vthl|)-Vth]^2 = K*[(Vdd-Vd]^2$$

Herein, I is the drive current flowing through the third transistor T3, i.e., a drive current for driving the OLED, K is a constant, Vgs is the voltage difference between the gate electrode and the first electrode of the third transistor T3, Vth is the threshold voltage of the third transistor T3, Vd is the data voltage output by the data signal line D, and Vdd is the power voltage output by the first power supply line VDD.

With development of OLED display technologies, consumers' requirements for a display effect of a display product are getting higher and higher. An extremely narrow bezel has become a new trend in development of display products. Therefore, bezel narrowing or even a borderless design has attracted more and more attention in a design of an OLED display product. At present, it is difficult to narrow a lower bezel of a display apparatus (a bezel on a side of a bonding region). In order to reduce a width of the lower bezel, a solution of reducing a length of a fanout region or a bending region is mainly adopted for some display substrates, but under a condition of existing process capacity, the lower bezel is still much larger than a left bezel and a right bezel.

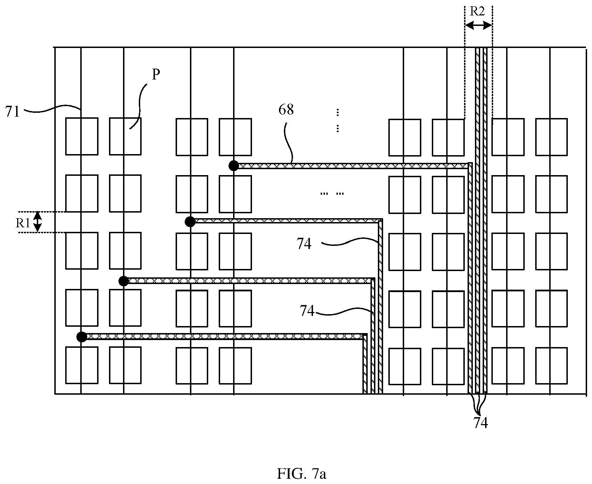

An exemplary embodiment of the present disclosure provides a display substrate, as shown in FIGs. 7a to 8c, which may include a display region and a bonding region connected with the display region, the display region may include multiple data signal lines 71 and K rows and L columns of sub-pixels P, wherein both K and L are positive integers greater than 1; there are multiple first spaces R1 between K sub-pixel rows and there are multiple second spaces R2 between L sub-pixel columns, wherein a first space is located between two adjacent sub-pixel rows, a second space R2 is located between two adjacent sub-pixel columns, at least one first space R1 is provided with a first data connection line 68, and at least one second space R2 is provided with at least one second data connection line 74. On a plane parallel to the display substrate, the first data connection line 68 extends along a first direction X, the second data connection line 74 extends along a second direction Y, and the first direction X intersects with the second direction Y; one end of the first data connection line 68 is electrically connected with one of the data signal lines 71 and the other end is electrically connected with one of second data connection lines; one end of the second data connection line 74 is electrically connected with the first data connection line 68 and the other end is electrically connected with the bonding region.

According to the display substrate provided by the embodiment of the present disclosure, the display region of the display substrate includes multiple data signal lines and K rows and L columns of sub-pixels, wherein both K and L are positive integers greater than 1; multiple first spaces R1 are included between K sub-pixel rows, multiple second spaces are included between L sub-pixel columns, a first space is located between two adjacent sub-pixel rows, a second space is located between two adjacent sub-pixel columns, at least one first space is provided with a first data connection line, and at least one second space is provided with at least one second data connection line; one end of the first data connection line is electrically connected with one of the data signal lines, and the other end is electrically connected with one of second data connection lines; one end of the second data connection line is electrically connected with the first data connection line and the other end is electrically connected with the bonding region. The first data connection line and the second data connection line are introduced into the display region, so that a bezel of the display substrate is reduced to a great extent, which is beneficial to achievement of a narrow bezel of a display product.

In an embodiment of the present disclosure, a Fanout in AA (FIAA for short) structure in which data fanout lines (i.e., the first data connection line 68 and the second data connection line 74) are located in a display region is adopted. One end of multiple data fanout lines is located in the display region of a display substrate and is correspondingly connected with multiple data signal lines in the display region. The other end of multiple data fanout lines extends to a bonding region and is correspondingly connected with an integrated circuit. Since there is no need to set a fan-shaped diagonal line in the bonding region, a width of a fanout region is reduced, effectively reducing a width of a lower bezel of the display substrate.

In an exemplary implementation mode, one end of the first data connection line 68 may be electrically connected with one of the data signal lines 71 through a via, and the other end may be electrically connected with one of the second data connection lines through a via; or, one end of the first data connection line 68 and one of the data signal lines 71 may be of an integrally formed structure disposed in a same layer, and the other end and one of the second data connection lines may be of an integrally formed structure disposed in a same layer.

In an exemplary implementation mode, the second data connection line 74 and the first data connection line 68 may be connected through a via, or the second data connection line 74 and the first data connection line 68 may be of an integrally formed structure disposed in a same layer.

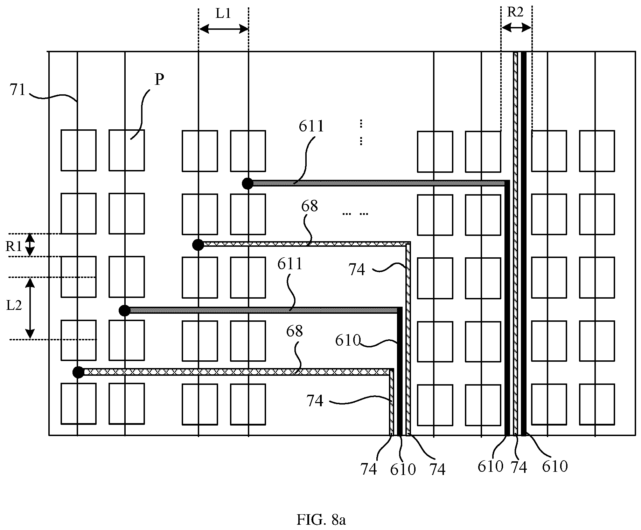

In an exemplary implementation mode, as shown in FIGs. 8a to 8c, the first space R1 is further provided with a fourth data connection line 611, and the second space R2 is further provided with a third data connection line 610; a same second space R2 is provided with at least one third data connection line 610 and at least one second data connection line 74; the fourth data connection line 611 extends along a first direction X, one end is electrically connected with a data signal line, and the other end is connected with the third data line connection line 610; the third data connection line 610 extends along a second direction Y, one end is connected with the fourth data connection line 611, and the other end is electrically connected with the bonding region.

In an exemplary implementation mode, as shown in FIGs. 8a to 8c and 25d to 27c, the first data connection line 68 and the second data connection line 74 may be connected through a via, and the third data connection line 610 and the fourth data connection line 611 may be of an integrally formed structure.

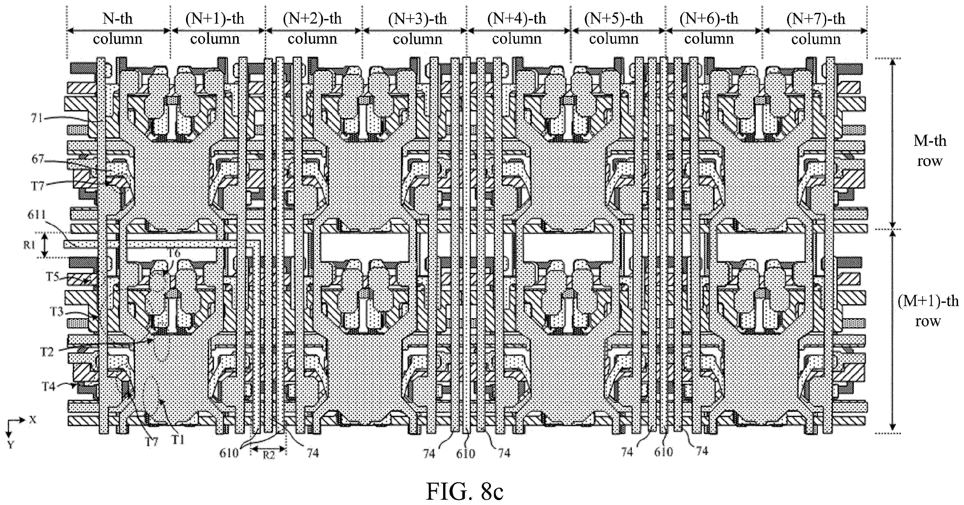

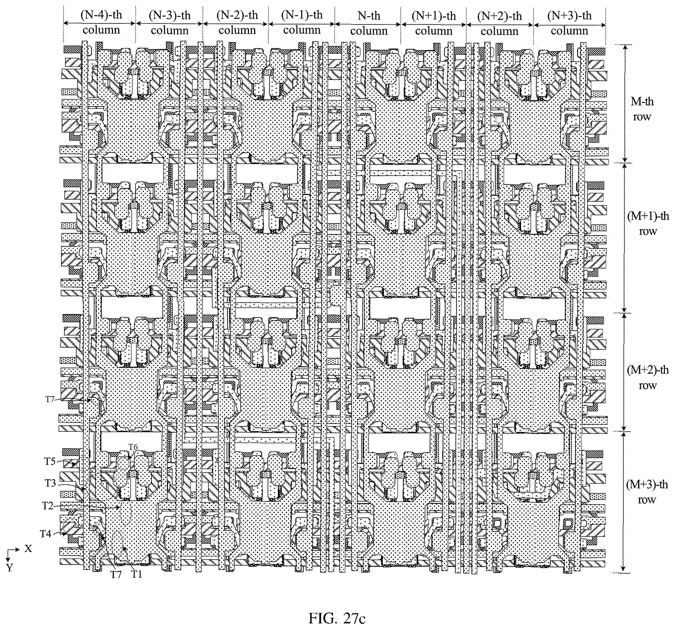

In an exemplary implementation mode, as shown in FIGs. 8c and 27c, the first data connection line 68 and the fourth data connection line 611 may be located in different first spaces R1, or the first data connection line 68 and the fourth data connection line 611 may be located in different first spaces R1 in a same first space R1, and there is no overlapping region between orthographic projections of the first data connection line 68 and the fourth data connection line 611 on the base substrate, and there is no overlapping region between orthographic projections of the first data connection line 68 and the third data connection line 610 on the base substrate.

In an exemplary implementation mode, as shown in FIGs. 8a to 8c, in a same second space R2, a quantity of third data connection lines 610 is one, a quantity of second data connection lines 74 is two, in a plane where the display substrate is located, two second data connection lines 74 are located on both sides of a third data connection line 610 in the first direction X, and two second data connection lines 74 in the same second space R2 are connected with different first data connection lines 68; or, in the same second space R2, a quantity of third data connection lines 610 is two, a quantity of second data connection line 74 is one, in the plane where the display substrate is located, two third data connection lines 610 are located on both sides of a second data connection line 74 in the first direction X, and the two third data connection lines 610 in the same second space R2 are connected with different fourth data connection lines 611.

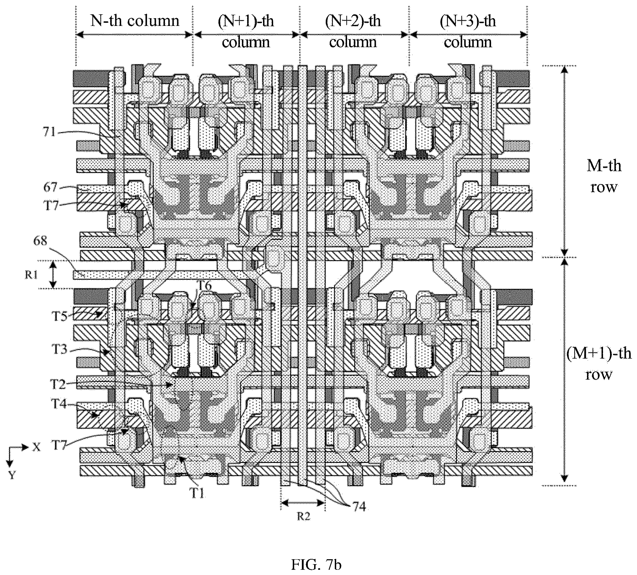

In an exemplary implementation mode, as shown in FIGs. 7a and 7b, in a same second space R2, a quantity of second data connection lines 74 is three, and three second data connection lines 74 are respectively connected with three different first data connection lines 68.

In an exemplary implementation mode, at least one sub-pixel includes a pixel drive circuit, in a plane perpendicular to the display substrate, the display substrate includes a base substrate and a first semiconductor layer, a first conductive layer, a second conductive layer, a second semiconductor layer, a third conductive layer, a fourth conductive layer, and a fifth conductive layer which are sequentially stacked on the base substrate; the first semiconductor layer includes: active layers of multiple low temperature poly silicon transistors located in the pixel drive circuit; the first conductive layer includes: control electrodes of the multiple poly silicon transistors and a first electrode plate of a storage capacitor located in the pixel drive circuit; the second conductive layer includes: a second electrode plate of the storage capacitor located in the pixel drive circuit; the second semiconductor layer includes: active layers of multiple oxide transistors located in the pixel drive circuit; the third conductive layer includes: control electrodes of multiple oxide transistors located in the pixel drive circuit; the fourth conductive layer includes a first data connection line 68, and first electrodes and second electrodes of multiple low temperature poly silicon transistors and first electrodes and second electrodes of multiple oxide transistors located in the pixel drive circuit; and the fifth conductive layer includes a data signal line, a first power supply line, and a second data connection line 74.

In the display substrate provided by the embodiment of the present disclosure, central compression is adopted for pixels, i.e., a pitch between adjacent sub-pixel may be kept unchanged, so that a Fanout routing enters the display region and is placed in a gap (i.e., the first space and the second space described above) compressed by a pixel drive circuit. Source Drain (SD) metal layers (i.e., the fourth conductive layer and/or the fifth conductive layer described above) are adopted for Fanout routings (including data fanout lines) both in a horizontal direction (including the first data connection line described above and a fourth data connection line involved below) and in a vertical direction (including the second data connection line described above and a third data connection line involved below). Without increasing a quantity of Backplate (BP) Masks, Fanout In AA (a Fanout routing is manufactured in an AA, FIAA for short) is adopted to achieve a narrow bezel and an LTPO Pixel Per Inch (PPI) can be increased to 430.

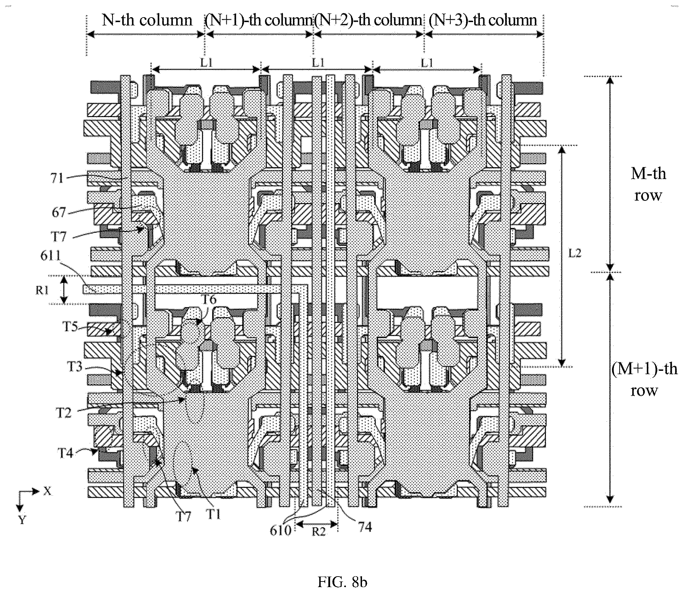

In an exemplary implementation mode, a pitch may be a distance between midpoints of two adjacent sub-pixels P. As shown in FIGs. 8a and 8b, L1 may be a pitch of two adjacent columns of sub-pixels along the first direction X and L2 may be a pitch of two adjacent rows of sub-pixels along the second direction Y.

In an exemplary implementation mode, pixel center compression may be understood as compressing a distance between elements or a size of an element in a pixel drive circuit to form the first space R1 and the second space R2 described above to place data fanout lines, thereby reducing a lower bezel of the display substrate while keeping a pitch of adjacent sub-pixels unchanged, so that a resolution of the display substrate will not decrease.

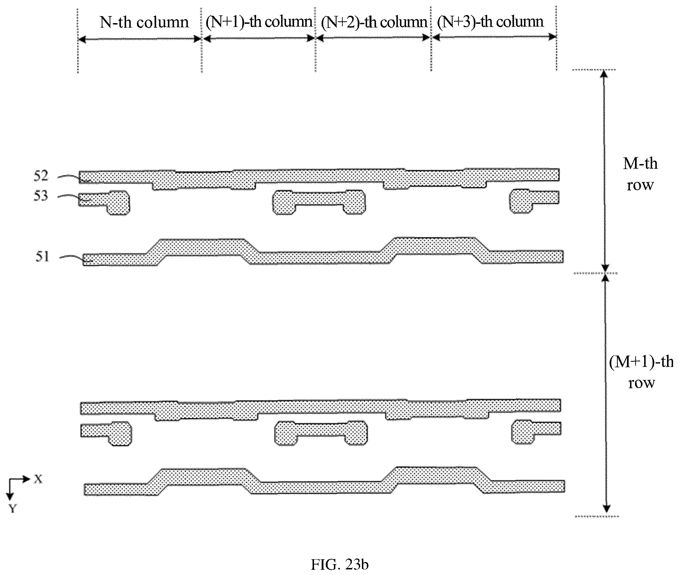

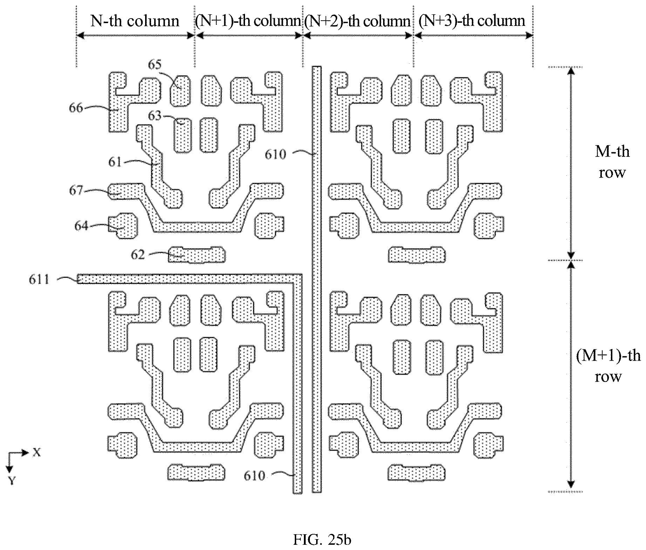

In an exemplary implementation mode, the display substrate further includes a light emitting element, a seventh transistor for resetting an anode voltage of the light emitting element is included in multiple low temperature poly silicon transistors, as shown in FIG. 23b, the third conductive layer further includes a switch connection electrode 53, as shown in FIG. 25b, the fourth conductive layer further includes multiple second initial signal lines 67, in a plane where the fourth conductive layer is located, a main body portion of the second initial signal line 67 is in a polyline shape extending along the first direction X, multiple second initial signal lines 67 are arranged in an array along the first direction X and the second direction Y, a second initial signal line 67 is connected with an active layer of the seventh transistor in the first semiconductor layer through a via and is multiplexed as a first electrode of the seventh transistor; in a same sub-pixel row, two adjacent second initial signal lines 67 are connected with a same switch connection electrode 53 through a switch via.

In an exemplary implementation mode, as shown in FIGs. 8b to 8c and 23b, the switch connection electrode 53 extends along the first direction X, and there is an overlapping region between an orthographic projection of the switch connection electrode 53 on the base substrate and an orthographic projection of one of second spaces R2 on the base substrate.

In an exemplary implementation mode, as shown in FIGs. 8a to 8c, the fourth conductive layer further includes a fourth data connection line 611 and a third data connection line 610, an orthographic projection of the fourth data connection line 611 on the base substrate is at least partially overlapped with an orthographic projection of one of first spaces R1 on the base substrate, and the orthographic projection of the fourth data connection line 611 on the base substrate is not overlapped with an orthographic projection of the first data connection line 68 on the base substrate; an orthographic projection of the third data connection line 610 on the base substrate is at least partially overlapped with an orthographic projection of one of second spaces R2 on the base substrate. In an exemplary implementation mode, the third data connection line 610 extends along the second direction Y, one end is connected with the fourth data connection line 611, and the other end is electrically connected with the bonding region; the fourth data connection line 611 extends along the first direction X, one end is connected with the third data connection line 610, and the other end is electrically connected with one of data signal lines in the fifth conductive layer through a via. In an exemplary implementation mode, in a same second space R2, an orthographic projection of the second data connection line 74 on the base substrate is not overlapped with an orthographic projection of the third data connection line 610 on the base substrate.

In an exemplary implementation mode, as shown in FIG. 8c, in a same second space R2, a quantity of third data connection lines 610 is one, a quantity of second data connection lines 74 is two, and an orthographic projection of a third data connection line 610 on the base substrate is located between orthographic projections of two second data connection lines 74 on the base substrate. Or, in a same second space R2, a quantity of third data connection lines 610 is two, a quantity of second data connection lines 74 is one, and an orthographic projection of a second data connection line 74 on the base substrate is located between orthographic projections of two third data connection lines 610 on the base substrate.

In an exemplary implementation mode, as shown in FIGs. 8b and 8c, there is an overlapping region between orthographic projections of a second data connection line 74 and a third data connection line 610 on the base substrate and an orthographic projection of the switch connection electrode 53 on the base substrate, and there is no overlapping region between the orthographic projections of the second data connection line 74 and the third data connection line 610 on the base substrate and an orthographic projection of a second initial signal line 67 on the base substrate.

In an exemplary implementation mode, as shown in FIGs. 8b and 8c, the pixel drive circuit further includes a first transistor T1 to a sixth transistor T6, and a storage capacitor; on a plane parallel to the display substrate, in a same pixel drive circuit, in the first direction X, the sixth transistor T6 is located on one side of the storage capacitor, and the fifth transistor T5 and the fourth transistor T4 are located on the other side of the storage capacitor; in the second direction Y, the fifth transistor T5, the sixth transistor T6, and the seventh transistor T7 are located on a same side of the storage capacitor, the fourth transistor T4, the first transistor T1, and the second transistor T2 are located on the other side of the storage capacitor, and the seventh transistor T7 is located on a side of the sixth transistor T6 away from the storage capacitor, the first transistor T1 is located on a side of the second transistor T2 away from the storage capacitor, and there is an overlapping region between an orthographic projection of the storage capacitor on the base substrate and an orthographic projection of the third transistor T3 on the base substrate; a seventh transistor T7 in an i-th row of sub-pixels is disposed in an (i-1)-th row of sub-pixels, wherein i=2, 3, ..., K; in the second direction Y, in two sub-pixel rows adjacent to a first data connection line 68, a first transistor T1 of a previous sub-pixel row and a fifth transistor T5 and a sixth transistor T6 of a next sub-pixel row are located on both sides of the first data connection line 68, and a seventh transistor T7 of the next sub-pixel row and the first transistor T1 of the previous sub-pixel row are located on a same side of the first data connection line 68; in two sub-pixel rows adjacent to a fourth data connection line 611, a first transistor of a previous sub-pixel row, a fifth transistor and a sixth transistor of a next sub-pixel row are located on both sides of the fourth data connection line 611, and a seventh transistor of the next sub-pixel row and the first transistor of the previous sub-pixel row are located on a same side of the fourth data connection line 611; in the first direction X, a total quantity of second data connection lines and third data connection lines 610 is three, three data connection lines are arranged along the first direction line X, two data connection lines located on both sides are symmetrical with respect to a data connection line located at a middle position, and in a same sub-pixel row, a first transistor T1 to a seventh transistor T7 and a storage capacitor in two sub-pixel columns adjacent to a second connection line 74 and a third data connection line 610 located in a same second space are symmetrical with respect to a data connection lines located at a middle position.

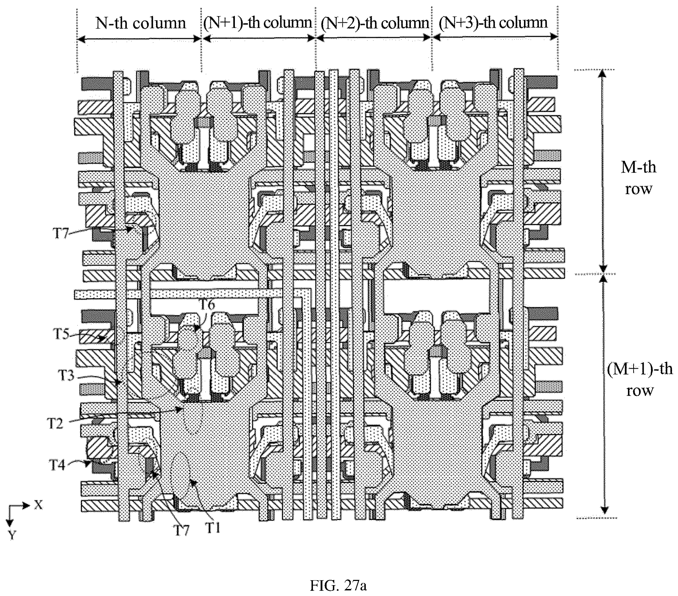

In an exemplary implementation mode, as shown in FIGs. 8b, 8c, and 27a to 27c, in the fourth conductive layer, a fourth data connection line 611 and a first electrode of a fourth transistor T4 in one of pixel drive circuits are of an integrally formed structure, and a first electrode 64 of a fourth transistor integrally formed with the fourth data connection line 611 (a fourth connection electrode 64 described below) is of a strip structure or a polyline structure, and extends along the second direction Y, one terminal is connected with the fourth data connection line 611, and the other terminal is electrically connected with a data signal line in the fifth conductive layer through a via; one terminal of the fourth data connection line 611 is connected with the first electrode 64 of the fourth transistor, and the other terminal is connected with a third data connection line 610; a first data connection line 68 and a first electrode 64 of one of fourth transistors are of an integrally formed structure, and the first electrode 64 of the fourth transistor integrally formed with the first data connection line 68 is of a strip structure or a polyline structure, and extends along the second direction Y, one terminal is connected with the first data connection line 68, and the other terminal is electrically connected with a data signal line in the fifth conductive layer through a via; one terminal of the first data connection line 68 is connected with the first electrode 64 of the fourth transistor, and the other terminal is electrically connected with a second data connection line 74 in the fifth conductive layer through a via.

In an exemplary implementation mode, as shown in FIG. 7b, in a same second space R2, a quantity of second data connection lines 74 is three, and orthographic projections of three second data connection lines 74 on the base substrate are not overlapped, the three second data connection lines 74 are electrically connected with first data connection lines 68 in three different first spaces R1 in the fourth conductive layer through three different vias, respectively.

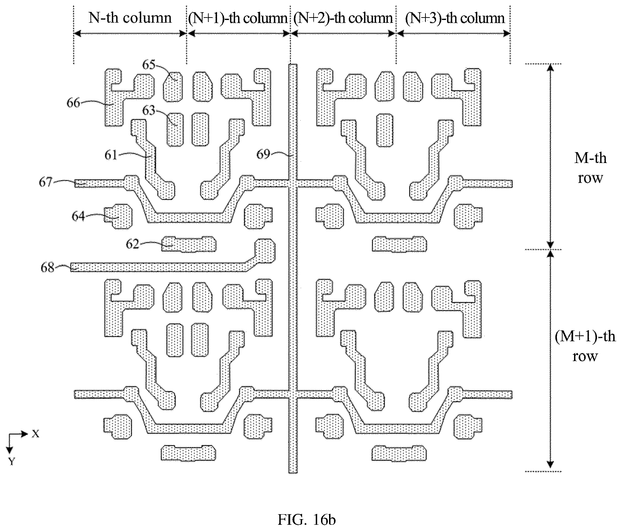

In an exemplary implementation mode, as shown in FIGs. 7b and 16b, the display substrate further includes a light emitting element, a seventh transistor T7 for resetting an anode voltage of the light emitting element is included in multiple low temperature poly silicon transistors, and the fourth conductive layer further includes an initial signal connection line 69 and multiple second initial signal lines 67; a second initial signal line 67 is connected with an active layer of a seventh transistor T7 in the first semiconductor layer through a via and is multiplexed as a first electrode of the seventh transistor T7; in a plane where the fourth conductive layer is located, a main body portion of the second initial signal line 67 is in a polyline shape extending along the first direction X, and multiple second initial signal lines 67 are arranged along the second direction Y; the initial signal connection line 69 extends along the second direction Y and is integrally formed with the multiple second initial signal lines 67.

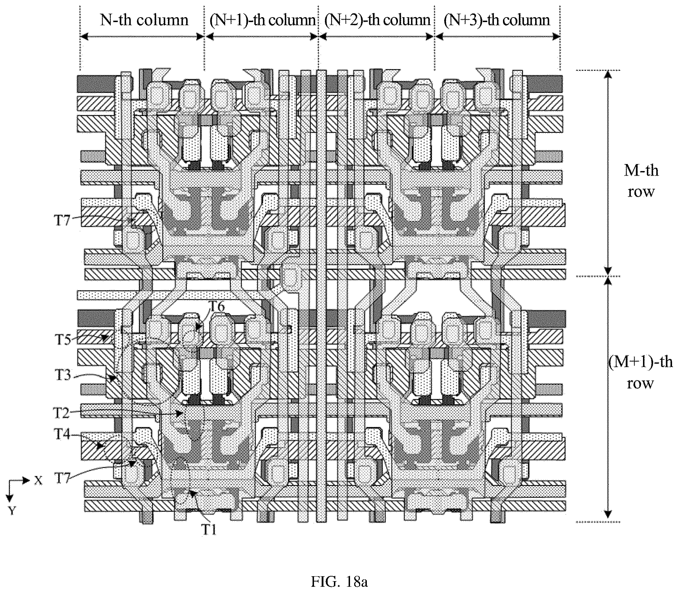

In an exemplary implementation mode, as shown in FIGs. 7b and 18a to 18b, among the three second data connection lines 74, there is an overlapping region between an orthographic projection of a second data connection line 74 at a middle position on the base substrate and an orthographic projection of the initial signal connection line 69 on the base substrate, and there is an overlapping region between orthographic projections of second data connection lines 74 located on both sides on the base substrate and an orthographic projection of a second initial signal line 67 on the base substrate.

In an exemplary implementation mode, the pixel drive circuit further includes: a first transistor T1 to a sixth transistor T6 and a storage capacitor; on a plane parallel to the display substrate, in a same pixel drive circuit, in the first direction X, the sixth transistor T6 is located on one side of the storage capacitor, and the fifth transistor T5 and the fourth transistor T4 are located on the other side of the storage capacitor; in the second direction Y, the fifth transistor T5, the sixth transistor T6, and the seventh transistor T7 are located on a same side of the storage capacitor, the fourth transistor T4, the first transistor T1, and the second transistor T2 are located on the other side of the storage capacitor, and the seventh transistor T7 is located on a side of the sixth transistor T6 away from the storage capacitor, the first transistor T1 is located on a side of the second transistor T2 away from the storage capacitor, and there is an overlapping region between an orthographic projection of the storage capacitor on the base substrate and an orthographic projection of the third transistor T3 on the base substrate; a seventh transistor T7 in an i-th row of sub-pixels is disposed in an (i-1)-th row of sub-pixels, wherein i=2, 3, ..., K; in the second direction Y, in two sub-pixel rows adjacent to a first data connection line 68, a first transistor T1 of a previous sub-pixel row and a fifth transistor T5 and a sixth transistor T6 of a next sub-pixel row are located on both sides of the first data connection line 68, and a seventh transistor T7 of the next sub-pixel row and the first transistor T1 of the previous sub-pixel row are located on a same side of the first data connection line 68; in the first direction X, three second data connection lines 74 are arranged in sequence, second data connection lines 74 located on both sides are symmetrical with respect to a second data connection line 74 located at a middle position, and in a same sub-pixel row, a first transistor T1 to a seventh transistor T7 and a storage capacitor in two sub-pixel columns adjacent to three second data connection lines 74 are symmetrical with respect to a second data connection line 74 located at a middle position.

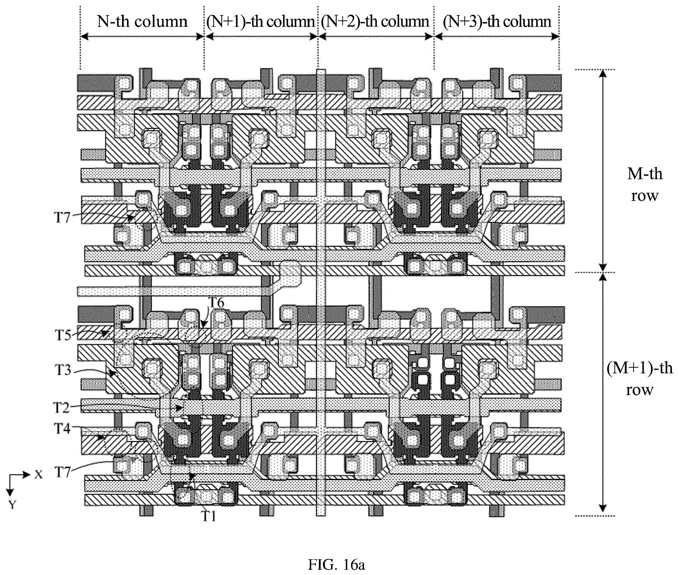

In an exemplary implementation mode, as shown in FIGs. 7b and 16a to 16d, in the fourth conductive layer, a first data connection line 68 and a first electrode 64 (a fourth connection electrode 64 described below) of one of fourth transistors are of an integrally formed structure, and the first electrode 64 of the fourth transistor integrally formed with the first data connection line 68 is of a strip structure or a polyline structure, and extends along the second direction Y, one terminal is connected with the first data connection line 68, and the other terminal is electrically connected with a data signal line in the fifth conductive layer through a via; one end of the first data connection line 68 is connected with the first electrode 64 of the fourth transistor, and the other end is electrically connected with a second data connection line 74 in the fifth conductive layer through a via.

In an exemplary implementation mode, as shown in FIGs. 7a to 8c, one end of a first data connection line 68, of which an orthographic projection on the base substrate has an overlapping region with an orthographic projection of one of second data connection lines 74 on the base substrate, and is electrically connected with the second data connection line 74 through a via in the overlapping region of projections, and the other end, of which an orthographic projection on the base substrate has an overlapping region with an orthographic projection of one of data signal lines 71 on the base substrate, and is electrically connected with the data signal line 71 through a via.

Exemplary description is made below through a preparation process of a display substrate. A "patterning process" mentioned in the present disclosure includes photoresist coating, mask exposure, development, etching, photoresist stripping, etc., for a metal material, an inorganic material, or a transparent conductive material, and includes organic material coating, mask exposure, development, etc., for an organic material. Deposition may be any one or more of sputtering, evaporation, and chemical vapor deposition, coating may be any one or more of spray coating, spin coating, and inkjet printing, and etching may be any one or more of dry etching and wet etching, the present disclosure is not limited thereto. A "thin film" refers to a layer of thin film made of a material on a base substrate (or underlayment substrate) using deposition, coating, or another process. If the "thin film" does not need a patterning process in an entire manufacturing process, the "thin film" may also be called a "layer". If the "thin film" needs the patterning process in the entire manufacturing process, the "thin film" is called a "thin film" before the patterning process and is called a "layer" after the patterning process. At least one "pattern" is contained in the "layer" after the patterning process. "A and B are disposed in a same layer" mentioned in the present disclosure means that A and B are formed simultaneously through a same patterning process, and a "thickness" of a film layer is a size of the film layer in a direction perpendicular to a display substrate. In an exemplary embodiment of the present disclosure, "an orthographic projection of B being within a range of an orthographic projection of A" or "an orthographic projection of A containing an orthographic projection of B" means that a boundary of the orthographic projection of B falls within a range of a boundary of the orthographic projection of A, or the boundary of the orthographic projection of A is overlapped with the boundary of the orthographic projection of B.

In an exemplary implementation mode, taking 8 sub-pixels (2 sub-pixel rows and 4 sub-pixel columns) in a display region (AA) as an example, a preparation process of a display substrate may include following operations.

(101) A base substrate is prepared on a glass carrier plate. In an exemplary implementation mode, the base substrate may be a flexible base substrate, or may be a rigid base substrate. The rigid base substrate may include, but is not limited to, one or more of glass and quartz. The flexible base substrate may be, but is not limited to, one or more of polyethylene terephthalate, polyether ether ketone, polystyrene, polycarbonate, polyarylate, polyarylester, polyimide, polyvinyl chloride, polyethylene, and textile fiber. In an exemplary implementation mode, the flexible base substrate may include a first flexible material layer, a first inorganic material layer, an adhesive layer, a second flexible material layer, and a second inorganic material layer which are stacked. Materials of the first flexible material layer and the second flexible material layer may be Polyimide (PI), Polyethylene Terephthalate (PET), or a polymer soft thin film subjected to surface treatment, etc. Materials of the first inorganic material layer and the second inorganic material layer may be Silicon Nitride (SiNx), Silicon Oxide (SiOx), or the like, so as to improve a water-oxygen resistance capability of the base substrate. The first inorganic material layer and the second inorganic material layer are also referred to as barrier layers. A material of the adhesive layer may be amorphous silicon (a-si). In an exemplary implementation mode, taking a laminated structure PI1/Barrier1/a-si/PI2/Barrier2 as an example, the preparation process may include: coating a layer of polyimide on the glass carrier plate, and forming a first flexible material (PI1) layer after curing to form a film; subsequently, depositing a layer of barrier thin film on the first flexible layer to form a first barrier (Barrier1) layer covering the first flexible layer; then depositing a layer of amorphous silicon thin film on the first barrier layer to form an amorphous silicon (a-si) layer covering the first barrier layer; then coating a layer of polyimide on the amorphous silicon layer, and forming a second flexible material (PI2) layer after curing to form a film; then depositing a layer of barrier thin film on the second flexible layer to form a second barrier (Barrier2) layer covering the second flexible layer, to complete preparation of the base substrate.

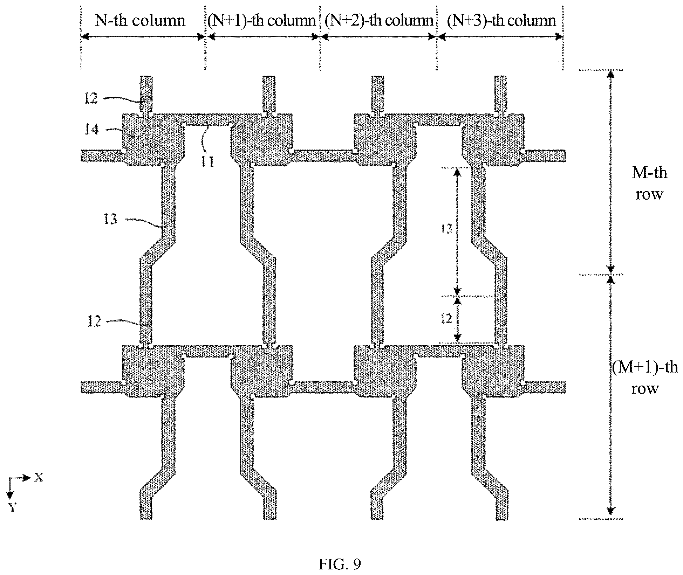

(102) A pattern of a shielding layer is formed. In an exemplary implementation mode, forming the pattern of the shielding layer may include: depositing a conductive thin film of the shielding layer on the base substrate, patterning the conductive thin film of the shielding layer through a patterning process, and forming the pattern of the shielding layer on the base substrate, as shown in FIG. 9, which is a planar structure view of the pattern of the shielding layer in eight sub-pixels.

In an exemplary implementation mode, a pattern of a shielding layer of each sub-pixel may include a first shielding structure 11, a second shielding structure 12, a third shielding structure 13, and a shielding block 14. A shape of the shielding block 14 may be a rectangle, and corners of the rectangular may be provided with chamfers. The first shielding structure 11 may be in a strip shape extending along the first direction X and the first shielding structure 11 is disposed on a side of the shielding block 14 in the first direction X and connected with the shielding block 14. The second shielding structure 12 may be in a strip shape extending along the second direction Y, and the second shielding structure 12 is disposed on a side of the shielding block 14 in a direction opposite to the second direction Y, and is connected with the shielding block 14. The third shielding structure 13 may be in a shape of a polyline extending along the second direction Y, and the third shielding structure 13 is disposed on a side of the shielding block 14 in the second direction Y and is connected with the shielding block 14.

In an exemplary implementation mode, a first shielding structure 11 of each sub-pixel is connected with a shielding block 14 of an adjacent sub-pixel in the first direction X, so that shielding layers in one sub-pixel row are connected into a whole to form an interconnected integrated structure.

In an exemplary implementation mode, a second shielding structure 12 of each sub-pixel is connected with a third shielding structure 13 of an adjacent sub-pixel in the second direction Y, so that shielding layers in one sub-pixel column are connected into a whole to form an interconnected integrated structure.

In an exemplary implementation mode, shielding layers in sub-pixel rows and sub-pixel columns are connected into a whole, which may ensure that shielding layers in the display substrate have a same potential, which is beneficial to improving uniformity of a panel, avoiding poor display of the display substrate, and ensuring a display effect of the display substrate.

In an exemplary implementation mode, a shielding layer of an N-th column and a shielding layer of an (N+1)-th column may be mirror symmetrical with respect to a first centerline, the shielding layer of the (N+1)-th column and a shielding layer of an (N+2)-th column may be mirror symmetrical with respect to a second centerline, the shielding layer of the (N+2)-th column and a shielding layer of an (N+3)-th column may be mirror symmetrical with respect to a third centerline, and the first centerline, the second centerline, and the third centerline may be straight lines extending along the second direction Y between adjacent sub-pixel columns, respectively.

In an exemplary implementation mode, shapes of shielding layers in multiple sub-pixel rows may be the same.

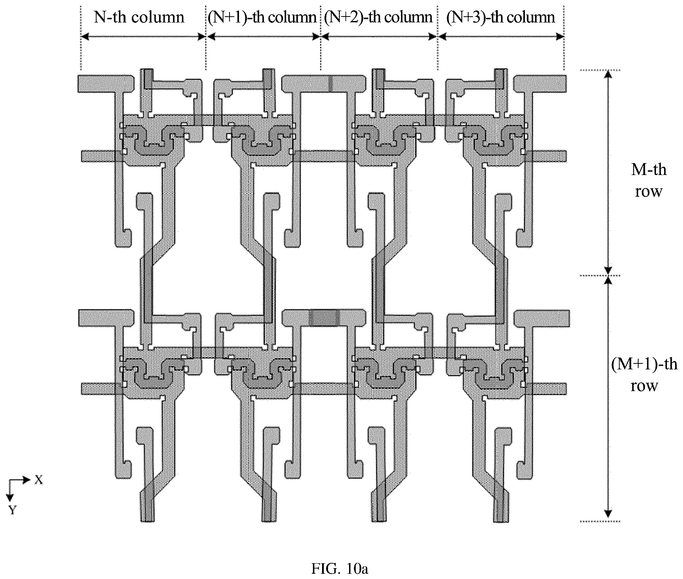

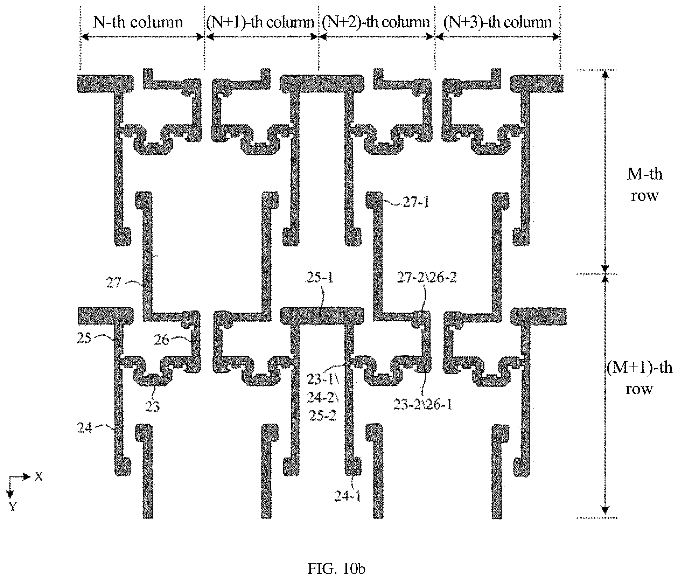

(103) A pattern of a first semiconductor layer is formed. In an exemplary implementation mode, forming the pattern of the first semiconductor layer may include: depositing sequentially a first insulation thin film and a first semiconductor thin film on the base substrate, on which the aforementioned pattern is formed, and patterning the first semiconductor thin film through a patterning process to form a first insulation layer covering the pattern of the shielding layer, and the pattern of the first semiconductor layer disposed on the first insulation layer, as shown in FIGs. 10a and 10b. FIG. 10a is a planar structure view of eight sub-pixels, and FIG. 10b is a planar schematic view of the first semiconductor layer in FIG. 10a.

In an exemplary implementation mode, a pattern of a first semiconductor layer of each sub-pixel may include an active layer 23 of a third transistor T3 to an active layer 27 of a seventh transistor T7, and the active layer 23 of the third transistor T3 to the active layer 27 of the seventh transistor T7 are of an interconnected integrated structure.

In an exemplary implementation mode, in the first direction X, the active layer 24 of the fourth transistor T4 and the active layer 25 of the fifth transistor T5 are located on a same side of the active layer 23 of the third transistor T3, and the active layer 26 of the sixth transistor T6 is located on the other side of the active layer 23 of the third transistor T3; in the second direction Y, the active layer 24 of the fourth transistor T4 and the active layer 25 of the fifth transistor T5 are located on both sides of the active layer 23 of the third transistor T3, and the active layer 25 of the fifth transistor T5, the active layer 26 of the sixth transistor T6, and the active layer 27 of the seventh transistor T7 are located on a same side of the active layer 23 of the third transistor T3, and the active layer 27 of the seventh transistor T7 is located on a side of the active layer 26 of the sixth transistor T6 away from the active layer 23 of the third transistor T3.

In an exemplary implementation mode, taking a sub-pixel in an M-th row and an N-th column as an example for explanation: in the first direction X, the active layer 24 of the fourth transistor T4 and the active layer 25 of the fifth transistor T5 are located on a side of the active layer 23 of the third transistor T3 away from a sub-pixel in an (N+1)-th column, and the active layer 26 of the sixth transistor T6 is located on a side of the active layer 23 of the third transistor T3 away from a sub-pixel in an (N-1)-th column; in the second direction Y, the active layer 24 of the fourth transistor T4 is located on a side of the active layer 23 of the third transistor T3 away from a sub-pixel in an (M-1)-th row, the active layer 25 of the fifth transistor T5, the active layer 26 of the sixth transistor T6, and the active layer 27 of the seventh transistor T7 are located on a side of the active layer 23 of the third transistor T3 away from a sub-pixel in an (M+1)-th row, and the active layer 27 of the seventh transistor T7 is located on a side of the active layer 26 of the sixth transistor T6 away from the active layer 23 of the third transistor T3.

In an exemplary implementation mode, the active layer 23 of the third transistor T3 may be in a "Q" shape, the active layer 24 of the fourth transistor T4 and the active layer 27 of the seventh transistor T7 may be in an "I" shape, and the active layer 25 of the fifth transistor T5 and the active layer 26 of the sixth transistor T6 may be in an "L" shape.

In an exemplary implementation mode, an active layer of each transistor may include a first region, a second region, and a channel region located between the first region and the second region. In an exemplary implementation mode, a first region 23-1 of the active layer 23 of the third transistor T3 may serve as a second region 24-2 of the active layer 24 of the fourth transistor T4 and a second region 25-2 of the active layer 25 of the fifth transistor T5, a second region 23-2 of the active layer 23 of the third transistor T3 may serve as a first region 26-1 of the active layer 26 of the sixth transistor T6, a second region 26-2 of the active layer 26 of the sixth transistor T6 may serve as a second region 27-2 of the active layer 27 of the seventh transistor T7, and a first region 24-1 of the active layer 24 of the fourth transistor T4, a first region 25-1 of the active layer 25 of the fifth transistor T5, and a first region 27-1 of the active layer 27 of the seventh transistor T7 may be disposed separately.

In an exemplary implementation mode, an orthographic projection of the active layer 23 of the third transistor T3 on the base substrate is at least partially overlapped with an orthographic projection of a shielding block 14 on the base substrate. In an exemplary implementation mode, an orthographic projection of the channel region of the active layer 23 of the third transistor T3 on the base substrate is within a range of the orthographic projection of the shielding block 14 on the base substrate.

In an exemplary implementation mode, a first region 25-1 of an active layer 25 of a fifth transistor T5 of an N-th column and a first region 25-1 of an active layer 25 of a fifth transistor T5 of an (N-1)-th column are connected with each other, and a first region 25-1 of an active layer 25 of a fifth transistor T5 of an (N+1)-th column and a first region 25-1 of an active layer 25 of a fifth transistor T5 of an (N+2)-th column are connected with each other. In an exemplary implementation mode, since a first region of an active layer of a fifth transistor in each sub-pixel is connected with a first power supply line formed subsequently, by forming first regions of active layers of fifth transistors of adjacent sub-pixels into an interconnected integrated structure, first electrodes of the fifth transistors in the adjacent sub-pixels may be ensured to have a same potential, which is beneficial to improving display uniformity of a panel and avoiding poor display of the display substrate, thereby ensuring a display effect of the display substrate.

In an exemplary implementation mode, a first semiconductor layer in an N-th column and a first semiconductor layer in an (N+1)-th column may be mirror symmetrical with respect to a first centerline, the first semiconductor layer in the (N+1)-th column and a first semiconductor layer in an (N+2)-th column may be mirror symmetrical with respect to a second centerline, and the first semiconductor layer in the (N+2)-th column and a first semiconductor layer in an (N+3)-th column may be mirror symmetrical with respect to a third centerline.

In an exemplary implementation mode, a first region 27-1 of an active layer 27 of a seventh transistor T7 in a sub-pixel of an i-th row may be disposed in a sub-pixel of an (i-1)-th row, i=2, 3, ..., M+1.

In an exemplary implementation mode, the first semiconductor layer may be made of polycrystalline Silicon (p-Si), i.e., the third transistor T3 to the seventh transistor T7 may be LTPS thin film transistors. In an exemplary implementation mode, the patterning the first semiconductor thin film through the patterning process may include: forming an amorphous silicon (a-si) thin film on the first insulation thin film, dehydrogenating the amorphous silicon thin film, and crystallizing the dehydrogenated amorphous silicon thin film to form a poly silicon thin film. Subsequently, the poly silicon thin film is patterned to form the pattern of the first semiconductor layer.

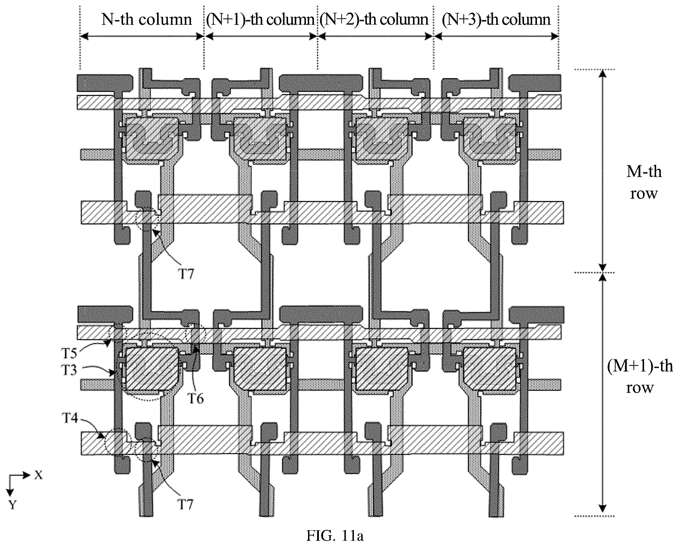

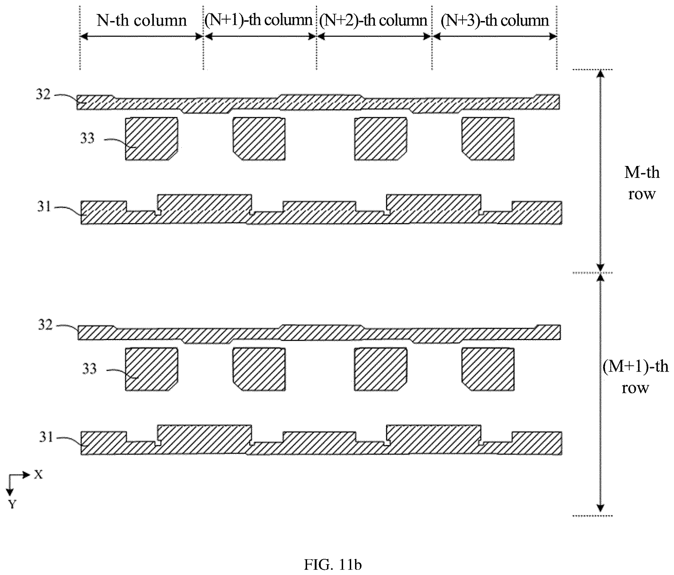

(104) A pattern of a first conductive layer is formed. In an exemplary implementation mode, forming the pattern of the first conductive layer may include: sequentially depositing a second insulation thin film and a first conductive thin film on the base substrate on which the above-mentioned patterns are formed, and patterning the first conductive thin film through a patterning process to form a second insulation layer that covers the pattern of the first semiconductor layer and the pattern of the first conductive layer disposed on the second insulation layer, as shown in FIG. 11a and FIG. 11b, and FIG. 11b is a planar schematic diagram of the first conductive layer in FIG. 11a. In an exemplary implementation mode, the first conductive layer may be referred to as a first gate metal (GATE1) layer.

In an exemplary implementation mode, the pattern of the first conductive layer may at least include a first scan signal line 31, a light emitting control line 32, and a first electrode plate 33 of a storage capacitor, the first scan signal line 31 and a main body portion of the light emitting control line 32 may extend along the first direction X, and in a same sub-pixel, the light emitting control line 32, the first electrode plate 33 of the storage capacitor, and the first scan signal line 31 are arranged along the second direction Y.

In an exemplary implementation mode, in the second direction Y, the first scan signal line 31 and the light emitting control line 32 are located on both sides of the first electrode plate 33 of the storage capacitor. For example, in the second direction, the light emitting control line 32, the first electrode plate 33, and the first scan signal line 31 are sequentially arranged.

Taking a sub-pixel in an M-th row and an N-th row as an example for explanation: in the second direction Y, a light emitting control line 32 may be located on a side of a first electrode plate 33 of a storage capacitor in a present sub-pixel close to a sub-pixel of an (M-1)-th row; a first scan signal line 31 may be located on a side of the first electrode plate 33 of the storage capacitor in the present sub-pixel close to a sub-pixel of an (M+1)-th row.

In an exemplary implementation mode, the first electrode plate 33 may be located between the light emitting control line 32 and the first scan signal line 31, the first electrode plate 33 may be in a rectangular shape, corners of the rectangular shape may be provided with chamfers, and there is an overlapping region between an orthographic projection of the first electrode plate 33 on the base substrate and an orthographic projection of the active layer of the third transistor T3 on the base substrate. In an exemplary embodiment, the first electrode plate 33 may simultaneously serve as an electrode plate of the storage capacitor and a control electrode of the third transistor T3.

In an exemplary implementation mode, a region where the light emitting control line 32 is overlapped with the active layer of the fifth transistor T5 serves as a control electrode of the fifth transistor T5, a region where the light emitting control line 32 is overlapped with the active layer of the sixth transistor T6 serves as a control electrode of the sixth transistor T6, a region where the first scan signal line 31 is overlapped with the active layer of the fourth transistor T4 serves as a control electrode of the fourth transistor T4, and a region where the first scan signal line 31 is overlapped with the active layer of the seventh transistor T7 serves as a control electrode of the seventh transistor T7.

In an exemplary implementation mode, the first scan signal line 31 and the light emitting control line 32 may be designed with an equal width or with non-equal widths, thereby not only a layout of a pixel structure may be facilitated, but also a parasitic capacitance between signal lines may be reduced.

In an exemplary implementation mode, after the pattern of the first conductive layer is formed, the semiconductor layer may be subjected to a conductive treatment by using the first conductive layer as a shield. The semiconductor layer, in a region which is shielded by the first conductive layer, forms channel regions of the third transistor T3 to the seventh transistor T7, and the semiconductor layer, in a region which is not shielded by the first conductive layer, is made to be conductive, that is, first regions and second regions of the active layer 23 of the third transistor T3 to the active layer 27 of the seventh transistor T7 are all made to be conductive.

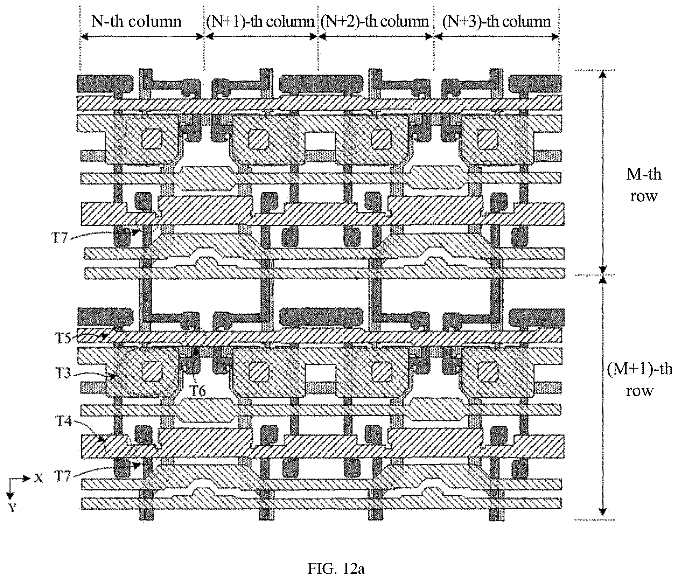

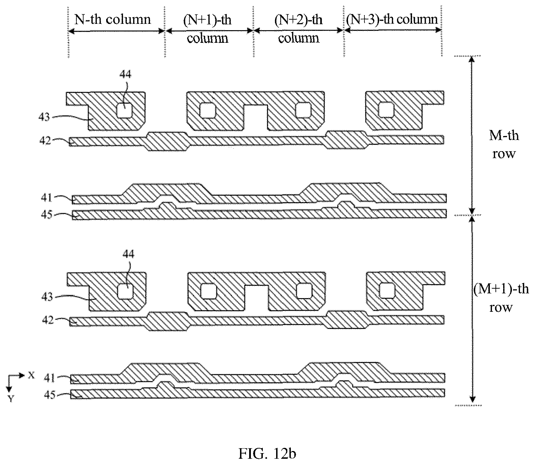

(105) A pattern of a second conductive layer is formed. In an exemplary implementation mode, forming the pattern of the second conductive layer may include: depositing sequentially a third insulation thin film and a second conductive thin film on the base substrate, on which the aforementioned patterns are formed, and patterning the second conductive thin film through a pattern process to form a third insulation layer covering the first conductive layer and the pattern of the second conductive layer disposed on the third insulation layer, as shown in FIG. 12a to FIG. 12b, wherein FIG. 12a is a planar structure view of eight sub-pixels, and FIG. 12b is a planar schematic view of the second conductive layer in FIG. 12a. In an exemplary implementation mode, the second conductive layer may be referred to as a second gate metal (GATE2) layer.

In an exemplary implementation mode, the pattern of the second conductive layer at least includes: a first shielding line 41, a second shielding line 42, and a second electrode plate 43 of the storage capacitor, and a first initial signal line 45, the first shielding line 41, the second shielding line 42, and a main body portion of the first initial signal line 45 may extend along the first direction X. The second electrode plate 43 of the storage capacitor serves as the other electrode plate of the storage capacitor. In the second direction Y, the second shielding line 42 is located between the first shielding line 41 and the second electrode plate 43, and the first shielding line 41 is located between the second shielding line 42 and the first initial signal line 45. For example, in a same sub-pixel, the second electrode plate 43 of the storage capacitor, the second shielding line 42, the first shielding line 41, and the first initial signal line 45 are arranged in sequence along the second direction Y.

In an exemplary implementation mode, the first shielding line 41 is configured as a shielding layer of the first transistor T1 to shield a channel of the first transistor T1, and the second shielding line 42 is configured as a shielding layer of the second transistor T2 to shield a channel of the second transistor T2, thereby ensuring electrical performance of a first oxide transistor T1 and a second oxide transistor T2. In an exemplary implementation mode, signals of the first shielding line 41 and a second scan signal line 51 subsequently formed may be the same, i.e., the first shielding line 41 and the second scan signal line 51 subsequently formed are connected in parallel, and are connected with a same signal source, so that the first shielding line 41 may serve as a bottom gate electrode (i.e., a bottom control electrode) of the first transistor T1, forming a first transistor T1 with a double-gate structure; signals of the second shielding line 42 and a third scan signal line 52 formed subsequently may be the same, that is, the second shielding line 42 and the third scan signal line 52 formed subsequently are connected in parallel, and connected with a same signal source, so that the second shielding line 42 may serve as a bottom gate electrode (i.e., a bottom control electrode) of the second transistor T2, forming a second transistor T2 with a double-gate structure.

In an exemplary implementation mode, a profile of the second electrode plate 43 may be in a rectangular shape, and corners of the rectangular shape may be provided with chamfers. There is an overlapping region between an orthographic projection of the second electrode plate 43 on the base substrate and an orthographic projection of the first electrode plate 33 on the base substrate, and the first electrode plate 33 and the second electrode plate 43 constitute a storage capacitor of a pixel drive circuit. The second electrode plate 43 is provided with an opening 44, and the opening 44 may be located in a middle of the second electrode plate 43. The opening 44 may be rectangular, so that the second electrode plate 43 forms an annular structure. The opening 44 exposes the third insulation layer covering the first electrode plate 33, and the orthographic projection of the first electrode plate 33 on the base substrate contains an orthographic projection of the opening 44 on the base substrate. In an exemplary embodiment, the opening 44 is configured to accommodate a ninth via subsequently formed, the ninth via is located in the opening 44 and exposes the first electrode plate 33, so that a second electrode of the first transistor T1 subsequently formed is connected with the first electrode plate 33.

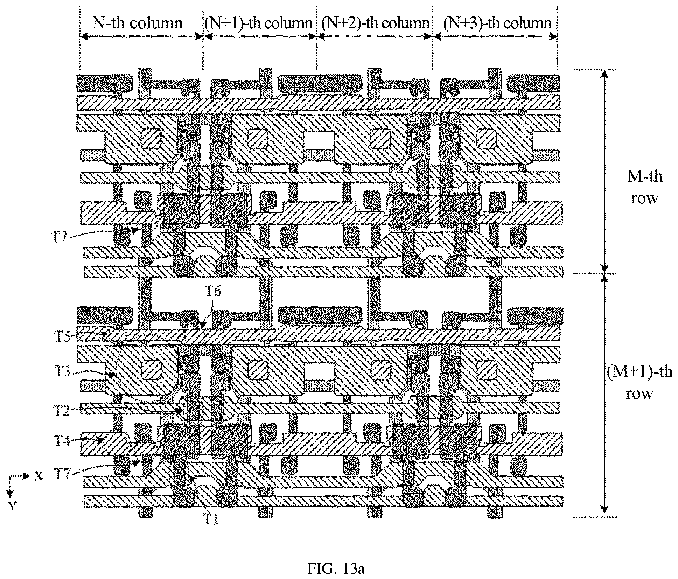

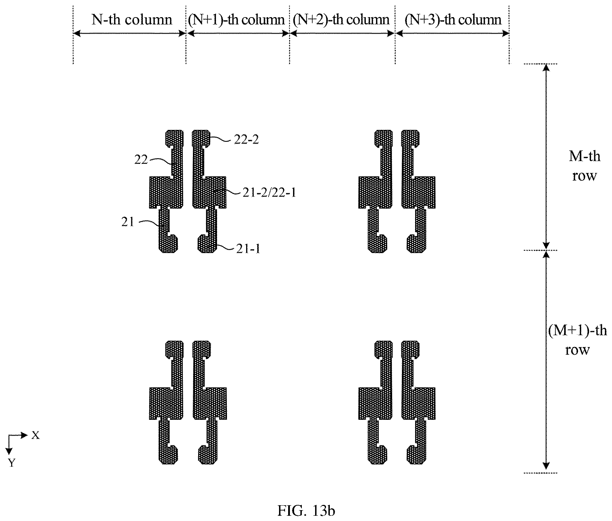

(106) A pattern of a second semiconductor layer is formed. In an exemplary implementation mode, forming the pattern of the second semiconductor layer may include: depositing sequentially a fourth insulation thin film and a second semiconductor thin film on the base substrate, on which the aforementioned patterns are formed, patterning the second semiconductor thin film through a patterning process to form a fourth insulation layer covering the base substrate and the pattern of the second semiconductor layer disposed on the fourth insulation layer, as shown in FIG. 13a to FIG. 13b, wherein FIG. 13a is a planar structure view of eight sub-pixels, and FIG. 13b is a planar schematic view of the second semiconductor layer in FIG. 13a.

In an exemplary implementation mode, a pattern of a second semiconductor layer in each sub-pixel at least includes: an active layer 21 of the first transistor T1 and an active layer 22 of the second transistor T2, and the active layer 21 of the first transistor T1 and the active layer 22 of the second transistor T2 are of an interconnected integrated structure.

In an exemplary implementation mode, the active layer 21 of the first transistor T1 and the active layer 22 of the second transistor T2 may be in an "I" shape, a second region 21-2 of the active layer 21 of the first transistor T1 may serve as a first region 22-1 of the active layer 22 of the second transistor T2, and a first region 21-1 of the active layer 21 of the first transistor T1 and a second region 22-2 of the second active layer 22 may be separately disposed.

In an exemplary implementation mode, a second semiconductor layer in an N-th column and a second semiconductor layer in an (N+1)-th column may be mirror symmetrical with respect to a first centerline, the second semiconductor layer in the (N+1)-th column and a second semiconductor layer in an (N+2)-th column may be mirror symmetrical with respect to a second centerline, and the second semiconductor layer in the (N+2)-th column and a second semiconductor layer in an (N+3)-th column may be mirror symmetrical with respect to a third centerline.

In an exemplary implementation mode, shapes of second semiconductor layers in multiple sub-pixel rows may be the same.

In an exemplary implementation mode, in a plane where the display substrate is located and in the first direction X, the active layer 21 of the first transistor T1 and the active layer 22 of the second transistor T2 are located on a side of the active layer 23 of the third transistor T3 away from the active layer 24 of the fourth transistor T4; in the second direction Y, the active layer 21 of the first transistor T1 and the active layer 22 of the second transistor T2 are located on a side of the active layer 23 of the third transistor T3 away from the active layer 25 of the fifth transistor T5, and the active layer 21 of the first transistor T1 is located on a side of the active layer 22 of the second transistor T2 away from the active layer 23 of the third transistor T3.

In an exemplary implementation mode, the second semiconductor layer may be made of an oxide, that is, the first transistor T1 and the second transistor T2 are oxide thin film transistors. In an exemplary implementation mode, the oxide may be any one or more of following: Indium Gallium Zinc Oxide (InGaZnO), Indium Gallium Zinc Oxynitride (InGaZnON), Zinc Oxide (ZnO), Zinc Oxynitride (ZnON), Zinc Tin Oxide (ZnSnO), Cadmium Tin Oxide (CdSnO), Gallium Tin Oxide (GaSnO), Titanium Tin Oxide (TiSnO), Copper Aluminum Oxide (CuAlO), Strontium Copper Oxide (SrCuO), Lanthanum Copper Sulfur Oxide (LaCuOS), Gallium Nitride (GaN), Indium Gallium Nitride (InGaN), Aluminum Gallium Nitride (AlGaN), and Indium Gallium Aluminum Nitride (InGaAlN). In some possible implementation modes, the second semiconductor thin film may be made of Indium Gallium Zinc Oxide (IGZO), wherein an electron mobility of Indium Gallium Zinc Oxide (IGZO) is higher than an electron mobility of amorphous silicon. Due to A leakage current of An IGZO TFT is relatively small, both the first transistor T1 and the second transistor T2 are N-type transistors, which may avoid leakage of electricity of a second node N2 in a light emitting stage.

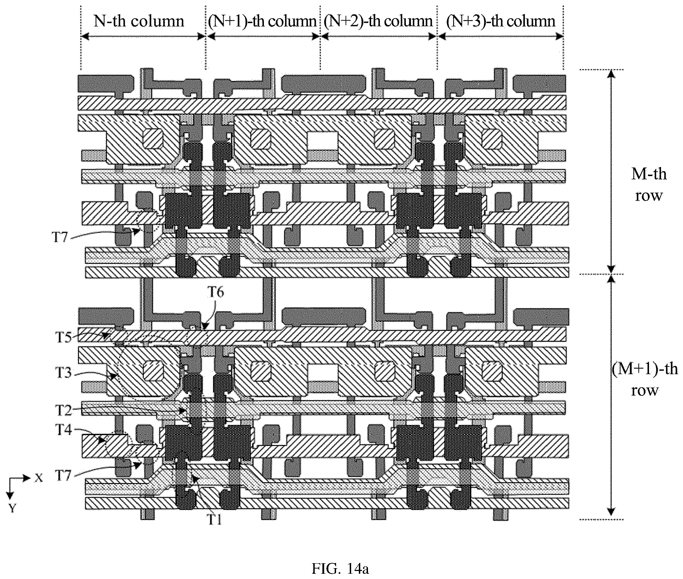

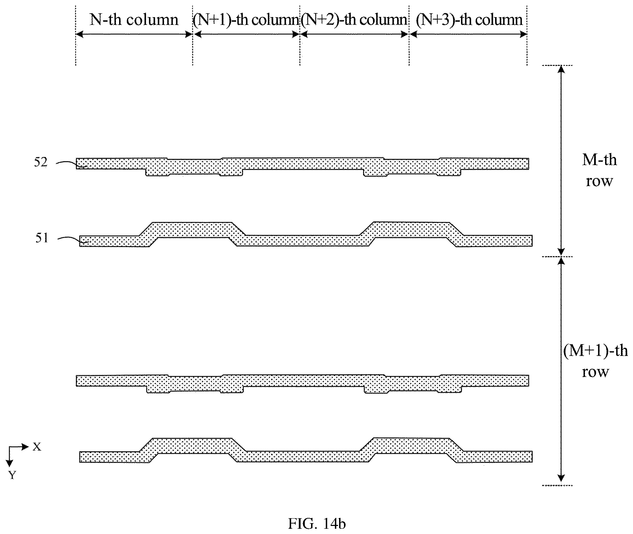

(107) A pattern of a third conductive layer is formed. In an exemplary implementation mode, forming the pattern of the third conductive layer may include: depositing sequentially a fifth insulation thin film and a third conductive thin film on the base substrate, on which the aforementioned patterns are formed, patterning the third conductive thin film through a patterning process to form a fifth insulation layer covering the second semiconductor layer and the pattern of the third conductive layer disposed on the fifth insulation layer, as shown in FIG. 14a to FIG. 14b, wherein FIG. 14a is a planar structure view of eight sub-pixels, and FIG. 14b is a planar schematic view of the third conductive layer in FIG. 14a. In an exemplary implementation mode, the third conductive layer may be referred to as a third gate metal (GATE3) layer.

In an exemplary implementation mode, the pattern of the third conductive layer at least includes a second scan signal line 51 and a third scan signal line 52, the second scan signal line 51 and a main body portion of the third scan signal line 52 may extend along the first direction X, and the third scan signal line 52 and the second scan signal line 51 are sequentially arranged along the second direction Y.

In an exemplary implementation mode, a region where the second scan signal line 51 is overlapped with the active layer 21 of the first transistor T1 serves as a control electrode of the first transistor T1, and a region where the third scan signal line 52 is overlapped with the active layer 22 of the second transistor T2 serves as a control electrode of the second transistor T2.

In an exemplary implementation mode, signals of the first shielding line 41 and the second scan signal line 51 may be the same, i.e., the first shielding line 41 and the second scan signal line 51 are connected in parallel and connected with a same signal source, so that the first shielding line 41 may serve as a bottom gate electrode (i.e., a bottom control electrode) of the first transistor T1, forming the first transistor T1 with a double-gate structure.

In an exemplary implementation mode, signals of the second shielding line 42 and the third scan signal line 52 may be the same, i.e., the second shielding line 42 and the third scan signal line 52 are connected in parallel and connected with a same signal source, so that the second shielding line 42 may serve as a bottom gate electrode (i.e., a bottom control electrode) of the second transistor T2, forming the second transistor T2 with a double-gate structure.

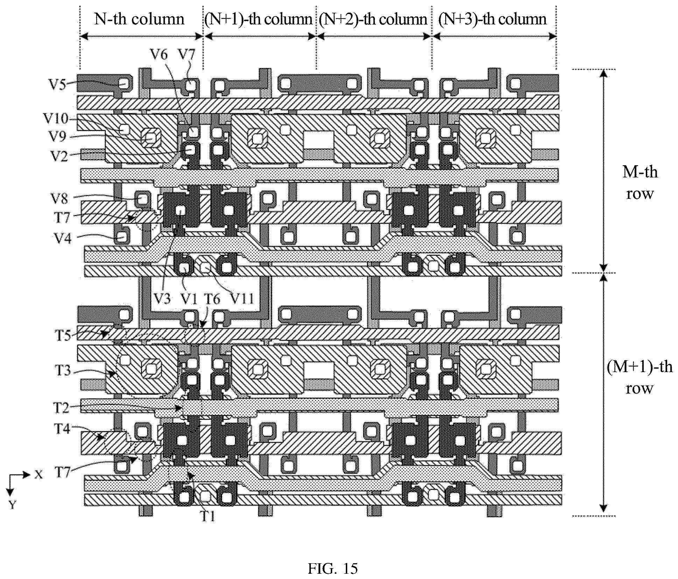

(108) A pattern of a sixth insulation layer is formed. In an exemplary implementation mode, forming the pattern of the sixth insulation layer may include: depositing a sixth insulation thin film on the base substrate on which the aforementioned patterns are formed, patterning the sixth insulation thin film through a patterning process to form a sixth insulation layer covering the third conductive layer, wherein the sixth insulation layer is provided with multiple vias, as shown in FIG. 15, and FIG. 15 is a planar structure view of eight sub-pixels.

In an exemplary implementation mode, multiple vias in each sub-pixel at least include: a first via V1, a second via V2, a third via V3, a fourth via V4, a fifth via V5, a sixth via V6, a seventh via V7, an eighth via V8, a ninth via V9, a tenth via V10, and an eleventh via V11.

In an exemplary implementation mode, an orthographic projection of the first via V1 on the base substrate is located within a range of an orthographic projection of the active layer 21 of the first transistor on the base substrate, the sixth insulation layer and the fifth insulation layer within the first via V1 are etched away, exposing a surface of the first region 21-1 of the active layer 21 of the first transistor T1. The first via V1 is configured such that a first electrode of the first transistor T1 subsequently formed is connected with the active layer 21 of the first transistor T1 through the via.

In an exemplary implementation mode, an orthographic projection of the second via V2 on the base substrate is located within a range of an orthographic projection of the active layer 22 of the second transistor T2 on the base substrate, the sixth insulation layer and the fifth insulation layer within the second via V2 are etched away, exposing a surface of the second region 22-2 of the active layer 22 of the second transistor T2. The second via V2 is configured such that a second electrode of the second transistor T2 subsequently formed is connected with the active layer 22 of the second transistor T2 through the via.

In an exemplary implementation mode, an orthographic projection of the third via V3 on the base substrate is located within a range of an orthographic projection of the active layer 22 of the second transistor T2 on the base substrate, the sixth insulation layer and the fifth insulation layer within the third via V3 are etched away, exposing a surface of the first region 22-1 of the active layer 22 of the second transistor T2 (which is also the second region 21-2 of the active layer 21 of the first transistor T1). The third via V3 is configured such that a second electrode of the first transistor T1 formed subsequently is connected with the active layer 21 of the first transistor T1 through the via, and a first electrode of the second transistor T2 formed subsequently is connected with the active layer 22 of the second transistor T2 through the via.

In an exemplary implementation mode, an orthographic projection of the fourth via V4 on the base substrate is located within a range of an orthographic projection of the active layer 24 of the fourth transistor on the base substrate, the sixth insulation layer, the fifth insulation layer, the fourth insulation layer, the third insulation layer, and the second insulation layer within the fourth via V4 are etched away, exposing the first region 24-1 of the active layer 24 of the fourth transistor T4. The fourth via V4 is configured such that a first electrode of the fourth transistor T4 subsequently formed is connected with the active layer 24 of the fourth transistor T4 through the via.

In an exemplary implementation mode, an orthographic projection of the fifth via V5 on the base substrate is located within a range of an orthographic projection of the active layer 25 of the fifth transistor T5 on the base substrate, the sixth insulation layer, the fifth insulation layer, the fourth insulation layer, the third insulation layer, and the second insulation layer within the fifth via V5 are etched away, exposing a surface of the first region 25-1 of the active layer 25 of the fifth transistor T5. The fifth via V5 is configured such that a first electrode of the fifth transistor T5 subsequently formed is connected with the active layer 25 of the fifth transistor T5 through the via.

In an exemplary implementation mode, an orthographic projection of the sixth via V6 on the base substrate is located within a range of an orthographic projection of the active layer 26 of the sixth transistor T6 on the base substrate, and the sixth insulation layer, the fifth insulation layer, the fourth insulation layer, the third insulation layer, and the second insulation layer within the sixth via V6 are etched away, exposing a surface of the first region 26-1 of the active layer 26 of the sixth transistor T6 (which is also a second region of the active layer 23 of the third transistor T3). The sixth via V6 is configured such that a first electrode of the sixth transistor T6 subsequently formed is connected with the active layer 26 of the sixth transistor T6 through the via and a second electrode of the third transistor T3 subsequently formed is connected with the active layer 23 of the third transistor T3 through the via.

In an exemplary implementation mode, an orthographic projection of the seventh via V7 on the base substrate is located within a range of an orthographic projection of the active layer 26 of the sixth transistor T6 on the base substrate, and the sixth insulation layer, the fifth insulation layer, the fourth insulation layer, the third insulation layer, and the second insulation layer within the seventh via V7 are etched away, exposing a surface of the second region 26-2 of the active layer 26 of the sixth transistor T6 (which is also the second region 27-2 of the active layer 27 of the seventh transistor T7). The seventh via V7 is configured such that a second electrode of the sixth transistor T6 subsequently formed is connected with the active layer 26 of the sixth transistor T6 through the via, and a second electrode of the seventh transistor T7 subsequently formed is connected with the active layer 27 of the seventh transistor T7 through the via.

In an exemplary implementation mode, an orthographic projection of the eighth via V8 on the base substrate is located within a range of an orthographic projection of the active layer 27 of the seventh transistor T7 on the base substrate, and the sixth insulation layer, the fifth insulation layer, the fourth insulation layer, the third insulation layer, and the second insulation layer within the eighth via V8 are etched away, exposing a surface of the first region 27-1 of the active layer 27 of the seventh transistor T7. The eighth via V8 is configured such that a first electrode of the seventh transistor T7 subsequently formed is connected with the active layer 27 of the seventh transistor T7 through the via.

In an exemplary implementation mode, an orthographic projection of the ninth via V9 on the base substrate is located within a range of an orthographic projection of the opening 44 on the base substrate, and the sixth insulation layer, the fifth insulation layer, the fourth insulation layer, and the third insulation layer within the ninth via V9 are etched away to expose a surface of the first electrode plate 33. The ninth via V9 is configured such that a second electrode of the first transistor T1 subsequently formed is connected with the first electrode plate 33 through the via.

In an exemplary implementation mode, the tenth via V10 is located within a range of an orthographic projection of the second electrode plate 43 on the base substrate, and the sixth insulation layer, the fifth insulation layer, and the fourth insulation layer within the tenth via V10 are etched away to expose a surface of the second electrode plate 43. The tenth via V10 is configured such that a sixth connection electrode subsequently formed is connected with the second electrode plate 43 through the via. In an exemplary embodiment, there may be multiple tenth vias V10 used as power supply vias, and the multiple tenth vias V10 may be sequentially arranged along the second direction Y or the first direction X, thereby increasing reliability of a connection between the first power supply line and the second electrode plate 43.

In an exemplary implementation mode, an orthographic projection of the eleventh via V11 on the base substrate is within a range of an orthographic projection of the first initial signal line 45 on the base substrate, the sixth insulation layer, the fifth insulation layer, and the fourth insulation layer within the eleventh via V11 are etched away, exposing a surface of the first initial signal line 45. The eleventh via V11 is configured such that a first electrode of the first transistor T1 subsequently formed is connected with the first initial signal line 45 through the via.

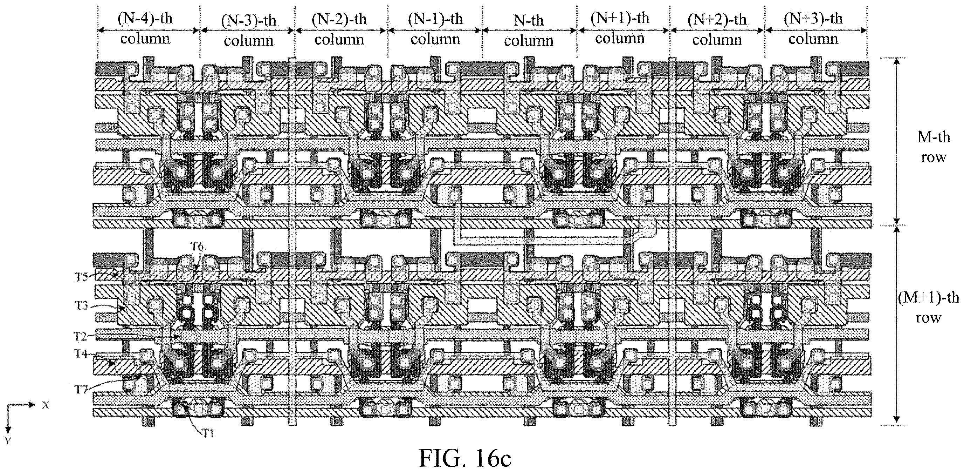

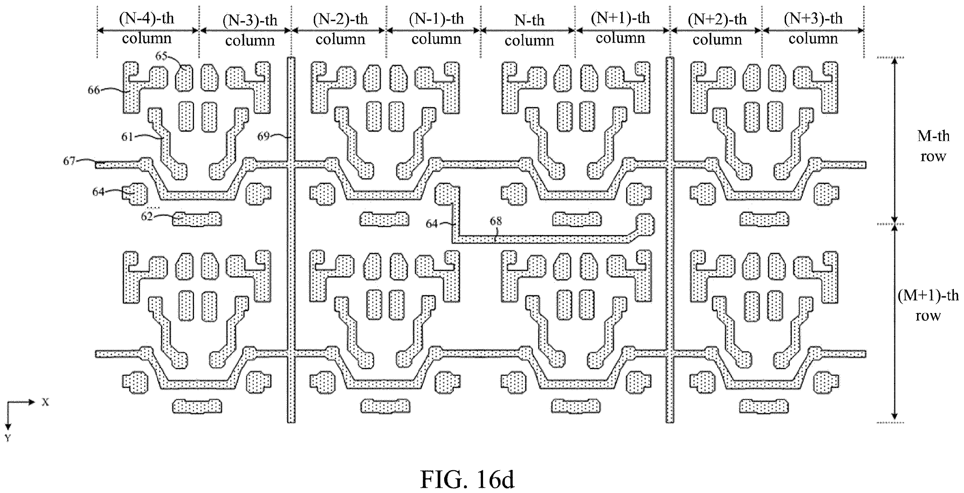

(109) A pattern of a fourth conductive layer is formed. In an exemplary embodiment, forming the pattern of the fourth conductive layer may include: depositing a fourth conductive thin film on the base substrate on which the aforementioned patterns are formed, patterning the fourth conductive thin film through a patterning process to form a fourth conductive layer disposed on the sixth insulation layer, as shown in FIG. 16a to FIG. 16d. FIG. 16a is a planar structure view of eight sub-pixels, FIG. 16b is a planar schematic view of the fourth conductive layer in FIG. 16a, FIG. 16c is a planar structure view of sixteen sub-pixels, and FIG. 16d is a planar schematic view of the fourth conductive layer in FIG. 16c. In an exemplary implementation mode, the fourth conductive layer may be referred to as a first source drain metal (SD1) layer.

In an exemplary implementation mode, the fourth conductive layer at least includes a first connection electrode 61, a second connection electrode 62, a third connection electrode 63, a fourth connection electrode 64, a fifth connection electrode 65, a sixth connection electrode 66, a second initial signal line 67, a first data connection line 68, and an initial signal connection line 69.

In an exemplary implementation mode, the first connection electrode 61 is in a shape of a polyline in which a main body portion extends along the second direction Y, and a first terminal thereof is connected with the second region 21-2 of the active layer 21 of the first transistor T1 (which is also the first region 22-1 of the active layer 22 of the second transistor T2 ) through the third via V3, and a second terminal thereof is connected with the first electrode plate 33 through the ninth via V9, so that the first electrode plate 33, the second electrode of the first transistor T1, and the first electrode of the second transistor T2 have a same potential. In an exemplary embodiment, the first connection electrode 61 may be used as the second electrode of the first transistor T1 and the first electrode of the second transistor T2.

In an exemplary implementation mode, the second connection electrode 62 may be in a strip shape in with a main body portion extending along the first direction X, the second connection electrode 62 is connected with the first region 21-1 of the active layer 21 of the first transistor T1 through the first via V1, and is connected with the first initial signal line 45 in a row of sub-pixels through an eleventh via V11 in the row of sub-pixels. In an exemplary embodiment, the second connection electrode 62 may serve as the first electrode of the first transistor T1, and the second connection electrode 62 is configured to be connected with the first initial signal line 45 and the active layer 21 of the first transistor T1.

In an exemplary implementation mode, an N-th column and an (N+1)-th column share a same second connection electrode 62, and an (N+2)-th column and an (N+3)-th column share a same second connection electrode 62. In an exemplary implementation mode, since a second connection electrode 62 in each sub-pixel is connected with the first initial signal line 45, by sharing a same second connection electrode 62 with adjacent sub-pixels to form an interconnected integrated structure, it may be ensured that second connection electrodes 62 of the adjacent sub-pixels have a same potential, which is beneficial to improving uniformity of a panel, avoiding poor display of the display substrate, and ensuring a display effect of the display substrate.

In an exemplary implementation mode, one terminal of the third connection electrode 63 is connected with the second region 22-2 of the active layer 22 of the second transistor T2 through the second via V2, and the other terminal of the third connection electrode 63 is connected with the second region 23-2 of the active layer 23 of the third transistor T3 (which is also the first region 26-1 of the active layer 26 of the sixth transistor T6) through the sixth via V6. In an exemplary embodiment, the third connection electrode 63 may simultaneously serve as the second electrode of the second transistor T2, the second electrode of the third transistor T3, and the first electrode of the sixth transistor T6, so that the second electrode of the second transistor T2, the second electrode of the third transistor T3, and the first electrode of the sixth transistor T6 have a same potential.

In an exemplary implementation mode, the fourth connection electrode 64 is connected with the first region 24-1 of the active layer 24 of the fourth transistor T4 through the fourth via V4. In an exemplary embodiment, the fourth connection electrode 64 may serve as the first electrode of the fourth transistor T4, and is configured to be connected with a data signal line formed subsequently.

In an exemplary implementation mode, the sixth connection electrode 66 is connected with the first region 25-1 of the active layer 25 of the fifth transistor T5 through the fifth via V5, and the sixth connection electrode 66 is connected with the second electrode plate 43 through the tenth via V10. In an exemplary embodiment, the sixth connection electrode 66 may serve as the first electrode of the fifth transistor T5, and is configured to be connected with a first power supply line formed subsequently.

In an exemplary implementation mode, the fifth connection electrode 65 is connected with the second region 26-2 of the active layer 26 of the sixth transistor T6 (which is also the second region 27-2 of the active layer 27 of the seventh transistor T7) through the seventh via V7. In an exemplary embodiment, the fifth connection electrode 65 may serve as the second electrode of the sixth transistor T6 and the second electrode of the seventh transistor T7, and the fifth connection electrode 65 is configured to be connected with an anode connection electrode of a light emitting element formed subsequently.

In an exemplary implementation mode, the second initial signal line 67 may be in a polyline shape in which a main body portion extends along the first direction X, the second initial signal line 67 is connected with first regions 27-1 of active layers 27 of multiple seventh transistors T7 through multiple eighth vias V8 in a sub-pixel row, and an initial voltage is written into multiple seventh transistors T7 in a sub-pixel row. In an exemplary embodiment, since the second initial signal line 67 is connected with first regions 27-1 of active layers 27 of all seventh transistors in a sub-pixel row, it may be ensured that first electrodes of all the seventh transistors T7 in the sub-pixel row have a same potential, which is beneficial to improving uniformity of the panel, avoiding poor display of the display substrate, and ensuring the display effect of the display substrate. In an exemplary embodiment, the second initial signal line 67 may serve as the first electrode of the seventh transistor T7.

In an exemplary implementation mode, a first data connection line 68 may be in a shape of a polyline in which a main body portion extends along the first direction X. In an exemplary implementation mode, a first data connection line 68 is disposed between adjacent rows of sub-pixels. In an exemplary implementation mode, one end of a first data connection line 68 is configured to be connected with a second data connection line subsequently formed through a via, and the other end is configured to be connected with a data signal line subsequently formed through a via. In an exemplary implementation mode, as shown in FIG. 16d, one end of a first data connection line 68 is configured to be connected with a second data connection line formed subsequently through a via, and the other end is integrally formed with the fourth connection electrode 64, and is configured to be connected with a data signal line formed subsequently through a via. In an exemplary implementation mode, the fourth connection electrode 64 connected with the first data connection line 68 may be of a strip structure or a polyline structure extending along the second direction Y, as shown in FIGs. 16c and 16d, and one terminal of the fourth connection electrode 64 connected with the first data connection line 68 is electrically connected with a data signal line formed subsequently through a via, and the other terminal is integrally formed with the first data connection line 68.

In an exemplary implementation mode, a first data connection line 68 may be located between two adjacent initial signal connection lines 69 in the first direction X.

In an exemplary implementation mode, the initial signal connection line 69 may be of a strip structure in which a main body portion extends along the second direction Y, and the initial signal connection line 69 is disposed to be of an integrally formed structure with the second initial signal line 67. In an exemplary implementation mode, one or more columns of sub-pixels may be disposed between two adjacent initial signal connection lines 69, for example, two sub-pixels are disposed between two adjacent initial signal connection lines 69. In an exemplary implementation mode, the initial signal connection line 69 connects multiple second initial signal lines 67 arranged along the second direction Y into an integrated structure, so that the multiple second initial signal lines 67 have a same potential, which is beneficial to improving uniformity of the panel, avoiding poor display of the display substrate, improving low gray-scale image quality, and ensuring the display effect of the display substrate.

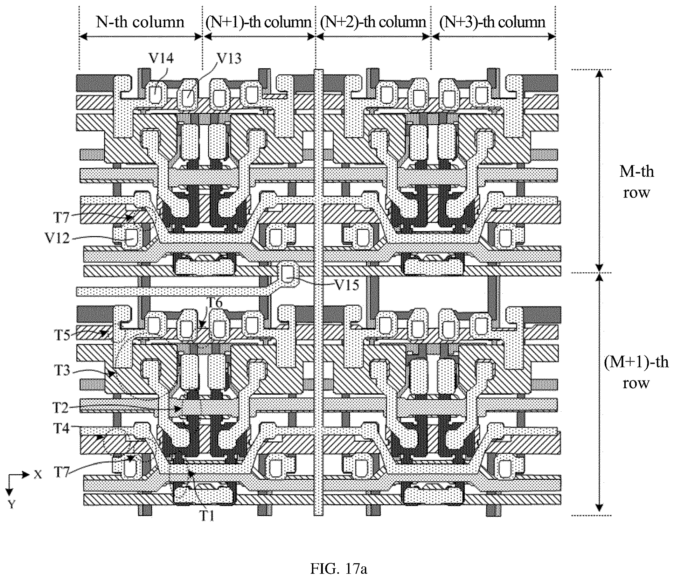

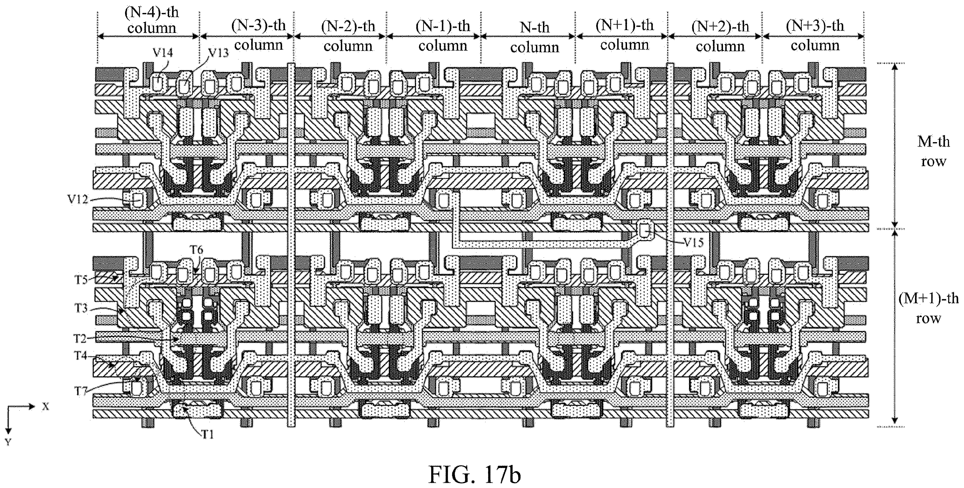

(110) Patterns of a seventh insulation layer and a first planarization layer are formed. In an exemplary embodiment, forming the patterns of the seventh insulation layer and the first planarization layer may include: first depositing a seventh insulation thin film on the base substrate on which the aforementioned patterns are formed, and then coating a first planarization thin film, patterning the first planarization thin film and the seventh insulation thin film through a patterning process to form a seventh insulation layer covering the pattern of the fourth conductive layer and the first planarization layer disposed on the seventh insulation layer. Multiple vias are disposed on the seventh insulation layer and the first planarization layer, as shown in FIGs. 17a and 17b. FIG. 17a is a planar structure view of eight sub-pixels, and FIG. 17b is a planar structure view of sixteen sub-pixels.

In an exemplary implementation mode, multiple vias in each sub-pixel at least include: a twelfth via V12, a thirteenth via V13, a fourteenth via V14, and a fifteenth via V15.

In an exemplary implementation mode, an orthographic projection of the twelfth via V12 on the base substrate is located within a range of an orthographic projection of the fourth connection electrode 64 on the base substrate. The first planarization layer and the seventh insulation layer within the twelfth via V12 are etched away to expose a surface of the fourth connection electrode 64. The twelfth via V12 is configured such that a data signal line subsequently formed is connected with the fourth connection electrode 64 through the via.

In an exemplary implementation mode, an orthographic projection of the thirteenth via V13 on the base substrate is located within a range of an orthographic projection of the fifth connection electrode 65 on the base substrate. The first planarization layer and the seventh insulation layer within the thirteenth via V13 are etched away to expose a surface of the fifth connection electrode 65. The thirteenth via V13 is configured such that an anode connection electrode of a light emitting element subsequently formed is connected with the fifth connection electrode 65 through the via.

In an exemplary implementation mode, an orthographic projection of the fourteenth via V14 on the base substrate is within a range of an orthographic projection of the sixth connection electrode 66 on the base substrate. The first planarization layer and the seventh insulation layer within the fourteenth via V14 are etched away to expose a surface of the sixth connection electrode 66. The fourteenth via V14 is configured such that a first power supply line formed subsequently is connected with the sixth connection electrode 66 through the via.

In an exemplary implementation mode, an orthographic projection of the fifteenth via V15 on the base substrate is located within a range of an orthographic projection of the first data connection line 68 on the base substrate. The first planarization layer and the seventh insulation layer within the fifteenth via V15 are etched away to expose a surface of the first data connection line 68. The fifteenth via V15 is configured such that a second data connection line formed subsequently is connected with the first data connection line 68 through the via.

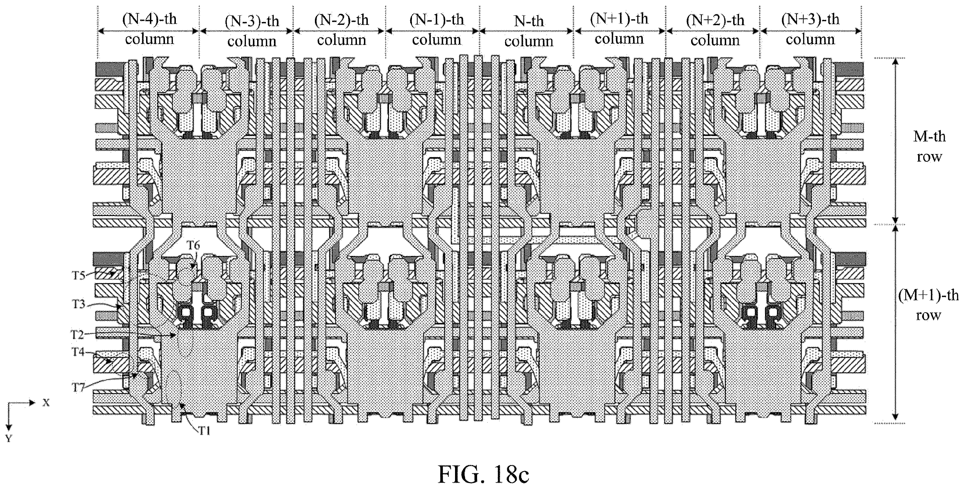

In an exemplary implementation mode, as shown in FIG. 17b, an orthographic projection, on the base substrate, of the twelfth via V12, on the fourth connection electrode 64, disposed to be connected with the first data connection line 68 is within a range of an orthographic projection of the first data connection line 68 (i.e., the fourth connection electrode 64) on the base substrate, and the first planarization layer and the seventh insulation layer within the twelfth via V12 are etched away, exposing a surface of the first data connection line 68 (i.e., the fourth connection electrode 64). The twelfth via V12 is configured such that a data signal line formed subsequently is connected with the first data connection line 68 (i.e., the fourth connection electrode 64) through the via. The first data connection line 68 and the fourth connection electrode 64 share a via and are connected with the data signal line formed subsequently, thereby saving space of a pixel drive circuit. As shown in FIGs. 17b and 18c, one end of the first data connection line 68 is integrally formed with the fourth connection electrode 64 and is electrically connected with a data signal line 71 through the twelfth via V12, and the other end is electrically connected with a second data connection line 74 through the fifteenth via V15.

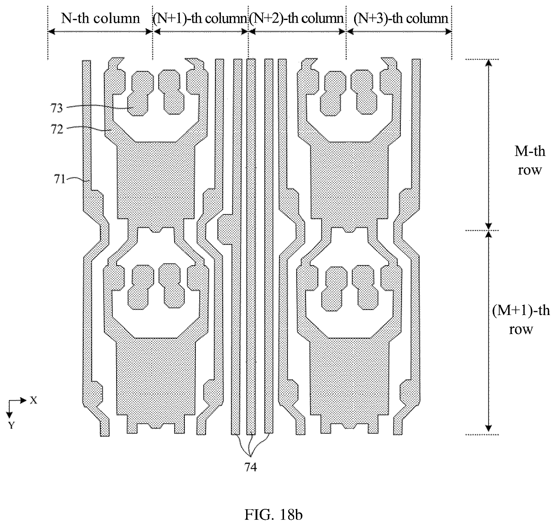

(111) A pattern of a fifth conductive layer is formed. In an exemplary embodiment, forming the fifth conductive layer may include: depositing a fifth conductive thin film on the base substrate on which the aforementioned patterns are formed, and patterning the fifth conductive thin film through a patterning process to form the fifth conductive layer disposed on the first planarization layer, as shown in FIG. 18a to FIG. 18c. FIG. 18a is a planar structure view of eight sub-pixels, FIG. 18c is a planar structure view of sixteen sub-pixels, and FIG. 18b is a planar schematic view of the fifth conductive layer in FIG. 18a. In an exemplary implementation mode, the fifth conductive layer may be referred to as a second source drain metal (SD2) layer.

In an exemplary embodiment, the fifth conductive layer at least includes: a data signal line 71, a first power supply line 72, an anode connection electrode 73, and a second data connection line 74. In an exemplary embodiment, the anode connection electrode 73 is an anode connection electrode of a light emitting element.

In an exemplary embodiment, the data signal line 71 is in a shape of a polyline in which a main body portion extends along the second direction Y, and the data signal line 71 is connected with the fourth connection electrode 64 through the twelfth via V12. Since the fourth connection electrode 64 is connected with the first region 24-1 of the active layer 24 of the fourth transistor T4 through a via, a connection between the data signal line 71 and the first electrode of the fourth transistor T4 is achieved, and a data signal is written into the fourth transistor T4.

In an exemplary embodiment, the first power supply line 72 is in a polyline shape in with a main body portion extends along the second direction Y. The first power supply line 72 is connected with the sixth connection electrode 66 through the fourteenth via V14. Since the sixth connection electrode 66 is connected with the second electrode plate 43 through a via, a connection between the first power supply line 72 and the second electrode plate 43 is achieved, and a power supply signal is written into the second electrode plate 43. Since the sixth connection electrode 66 is connected with the first region 25-1 of the active layer 25 of the fifth transistor T5 through a via, a connection between the first power supply line 72 and the first electrode of the fifth transistor T5 is achieved, and a power supply signal is written into the fifth transistor T5.

In an exemplary embodiment, the anode connection electrode 73 is connected with the fifth connection electrode 65 through the thirteenth via V13. Since the fifth connection electrode 65 is connected with the second region 26-2 of the active layer 26 of the sixth transistor T6 (which is also the second region 27-2 of the active layer 27 of the seventh transistor T7) through a via, a connection between the anode connection electrode 73, and the second electrode of the sixth transistor T6 and the second electrode of the seventh transistor is achieved.

In an exemplary embodiment, a main body portion of the second data connection line 74 extends along the second direction Y, and the second data connection line 74 is connected with the first data connection line 68 through the fifteenth via V15. In an exemplary implementation mode, a second data connection line 74 is disposed between two adjacent columns of sub-pixels. In an exemplary implementation mode, three second data connection lines 74 may be disposed between two adjacent columns of sub-pixels and three adjacent second data connection lines 74 are respectively connected with first data connection lines 68 in different sub-pixel rows through vias.

In an exemplary implementation mode, any second data connection line 74 is connected with the first data connection line 68 through the fifteenth via V15 in the display region, and is connected with an Integrated Circuit (IC) in a drive chip region in a bonding region.

In an exemplary implementation mode, taking 8 sub-pixels (2 sub-pixel rows and 4 sub-pixel columns) in a display region (AA) as an example, another preparation process of a display substrate may include following operations.

(201) A base substrate is prepared on a glass carrier plate. A preparation method is the same as the above (101), and will not be described here.

(202) A pattern of a shielding layer is formed. A preparation method is the same as the above (102), and will not be described here. The formed pattern of the shielding layer is shown in FIG. 9.

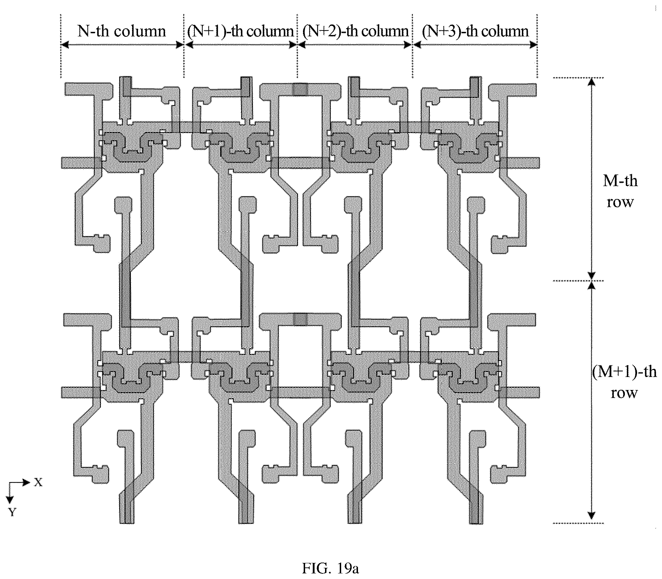

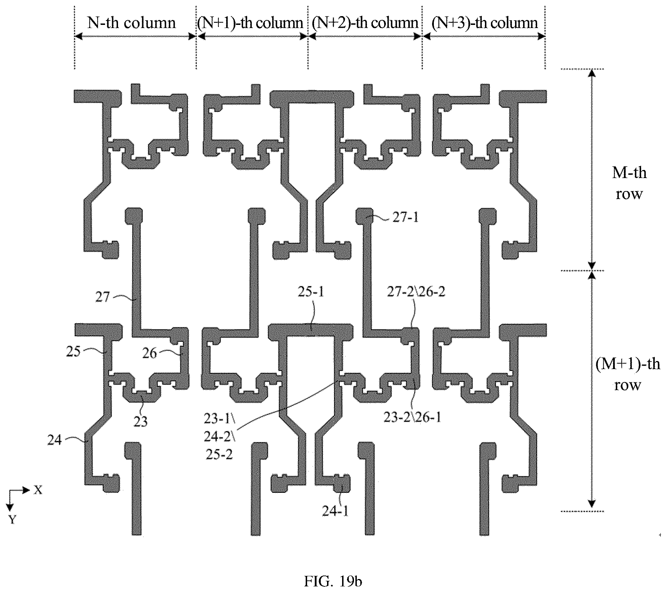

(203) A pattern of a first semiconductor layer is formed. In an exemplary implementation mode, forming the pattern of the first semiconductor layer may include: depositing sequentially a first insulation thin film and a first semiconductor thin film on the base substrate, on which the aforementioned pattern is formed, patterning the first semiconductor thin film through a patterning process to form a first insulation layer covering the pattern of the shielding layer, and the pattern of the first semiconductor layer disposed on the first insulation layer, as shown in FIGs. 19a and 19b. FIG. 19a is a planar structure view of eight sub-pixels, and FIG. 19b is a planar schematic view of the first semiconductor layer in FIG. 19a.

In an exemplary implementation mode, a pattern of a first semiconductor layer of each sub-pixel may include the active layer 23 of the third transistor T3 to the active layer 27 of the seventh transistor T7, and the active layer 23 of the third transistor T3 to the active layer 27 of the seventh transistor T7 are of an interconnected integrated structure.

In an exemplary implementation mode, in the first direction X, the active layer 24 of the fourth transistor T4 and the active layer 25 of the fifth transistor T5 are located on a same side of the active layer 23 of the third transistor T3, and the active layer 26 of the sixth transistor T6 is located on the other side of the active layer 23 of the third transistor T3; in the second direction Y, the active layer 24 of the fourth transistor T4 and the active layer 25 of the fifth transistor T5 are located on both sides of the active layer 23 of the third transistor T3, and the active layer 25 of the fifth transistor T5, the active layer 26 of the sixth transistor T6, and the active layer 27 of the seventh transistor T7 are located on a same side of the active layer 23 of the third transistor T3, and the active layer 27 of the seventh transistor T7 is located on a side of the active layer 26 of the sixth transistor T6 away from the active layer 23 of the third transistor T3.

In an exemplary implementation mode, taking a sub-pixel in an M-th row and an N-th column as an example for explanation: in the first direction X, the active layer 24 of the fourth transistor T4 and the active layer 25 of the fifth transistor T5 are located on a side of the active layer 23 of the third transistor T3 away from a sub-pixel in an (N+1)-th column, and the active layer 26 of the sixth transistor T6 is located on a side of the active layer 23 of the third transistor T3 away from a sub-pixel in an (N-1)-th column; in the second direction Y, the active layer 24 of the fourth transistor T4 is located on a side of the active layer 23 of the third transistor T3 away from a sub-pixel in an (M-1)-th row, the active layer 25 of the fifth transistor T5, the active layer 26 of the sixth transistor T6, and the active layer 27 of the seventh transistor T7 are located on a side of the active layer 23 of the third transistor T3 away from a sub-pixel in an (M+1)-th row, and the active layer 27 of the seventh transistor T7 is located on a side of the active layer 26 of the sixth transistor T6 away from the active layer 23 of the third transistor T3.

In an exemplary implementation mode, a shape of the active layer 23 of the third transistor T3 may be a "Q" shape, a shape of the active layer 24 of the fourth transistor T4 may be a shape of a polyline extending along the second direction Y, a middle portion of the polyline is bent toward a direction away from the active layer 31 of the third transistor T3, an end portion of the polyline is bent toward a direction close to the active layer 31 of the third transistor T3, a shape of the active layer 27 of the seventh transistor T7 may be an "I" shape, and the active layer 25 of the fifth transistor T5 and the active layer 26 of the sixth transistor T6 may have an "L" shape.

In an exemplary implementation mode, an active layer of each transistor may include a first region, a second region, and a channel region located between the first region and the second region. In an exemplary implementation mode, the first region 23-1 of the active layer 23 of the third transistor T3 may serve as the second region 24-2 of the active layer 24 of the fourth transistor T4 and the second region 25-2 of the active layer 25 of the fifth transistor T5, the second region 23-2 of the active layer 23 of the third transistor T3 may serve as the first region 26-1 of the active layer 26 of the sixth transistor T6, the second region 26-2 of the active layer 26 of the sixth transistor T6 may serve as the second region 27-2 of the active layer 27 of the seventh transistor T7, and the first region 24-1 of the active layer 24 of the fourth transistor T4, the first region 25-1 of the active layer 25 of the fifth transistor T5, and the first region 27-1 of the active layer 27 of the seventh transistor T7 may be disposed separately.

In an exemplary implementation mode, an orthographic projection of the active layer 23 of the third transistor T3 on the base substrate is at least partially overlapped with an orthographic projection of the shielding block 14 on the base substrate. In an exemplary implementation mode, an orthographic projection of the channel region of the active layer 23 of the third transistor T3 on the base substrate is within a range of the orthographic projection of the shielding block 14 on the base substrate.

In an exemplary implementation mode, a first region 25-1 of an active layer 25 of a fifth transistor T5 of an N-th column and a first region 25-1 of an active layer 25 of a fifth transistor T5 of an (N-1)-th column are connected with each other, and a first region 25-1 of an active layer 25 of a fifth transistor T5 of an (N+1)-th column and a first region 25-1 of an active layer 25 of a fifth transistor T5 of an (N+2)-th column are connected with each other. In an exemplary implementation mode, since a first region of an active layer of a fifth transistor in each sub-pixel is connected with a first power supply line formed subsequently, by forming first regions of active layers of fifth transistors of adjacent sub-pixels into an interconnected integrated structure, it may be ensured that first electrodes of the fifth transistors in the adjacent sub-pixels have a same potential, which is beneficial to improving uniformity of a panel and avoiding poor display of the display substrate, thereby ensuring a display effect of the display substrate.

In an exemplary implementation mode, a first semiconductor layer in the N-th column and a first semiconductor layer in the (N+1)-th column may be mirror symmetrical with respect to a first centerline, the first semiconductor layer in the (N+1)-th column and a first semiconductor layer in the (N+2)-th column may be mirror symmetrical with respect to a second centerline, and the first semiconductor layer in the (N+2)-th column and a first semiconductor layer in an (N+3)-th column may be mirror symmetrical with respect to a third centerline.

In an exemplary implementation mode, a first region 27-1 of an active layer 27 of a seventh transistor T7 in a sub-pixel of an i-th rows may be disposed in a sub-pixel of an (i-1)-th row, i=2, 3, ..., M+1.

In an exemplary implementation mode, the first semiconductor layer may be made of polycrystalline Silicon (p-Si), i.e., the third transistor T3 to the seventh transistor T7 may be LTPS thin film transistors. In an exemplary embodiment mode, the patterning the first semiconductor thin film through the patterning process may include: forming an amorphous silicon (a-si) thin film on the first insulation thin film, dehydrogenating the amorphous silicon thin film, and crystallizing the dehydrogenated amorphous silicon thin film to form a poly silicon thin film. Subsequently, the poly silicon thin film is patterned to form the pattern of the first semiconductor layer.

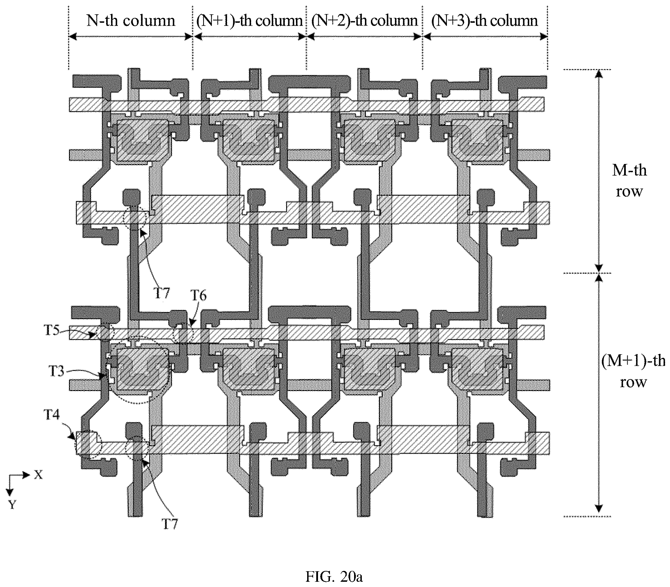

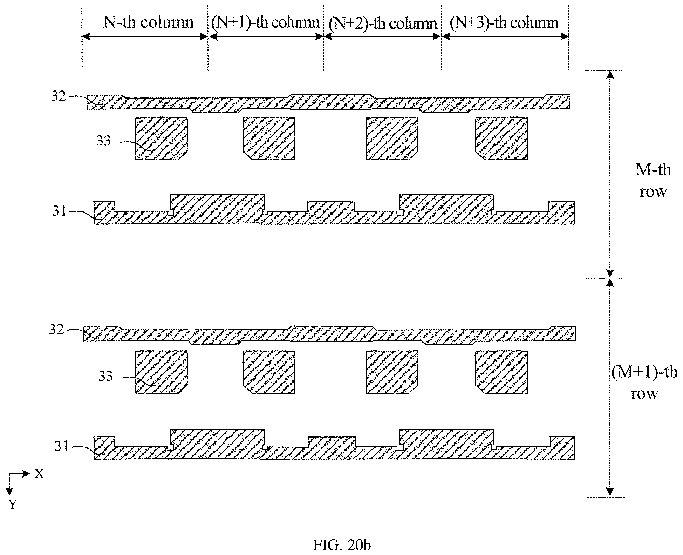

(204) A pattern of a first conductive layer is formed. In an exemplary implementation mode, forming the pattern of the first conductive layer may include: sequentially depositing a second insulation thin film and a first conductive thin film on the base substrate on which the above-mentioned patterns are formed, and patterning the first conductive thin film through a patterning process to form a second insulation layer that covers the pattern of the first semiconductor layer and the pattern of the first conductive layer disposed on the second insulation layer, as shown in FIG. 20a and FIG. 20b, and FIG. 20b is a planar schematic diagram of the first conductive layer in FIG. 20a. In an exemplary implementation mode, the first conductive layer may be referred to as a first gate metal (GATE1) layer.

In an exemplary implementation mode, the pattern of the first conductive layer may at least include a first scan signal line 31, a light emitting control line 32, a first electrode plate 33 of a storage capacitor, the first scan signal line 31 and a main body portion of the light emitting control line 32 may extend along the first direction X, and in a same sub-pixel, the light emitting control line 32, the first electrode plate 33 of the storage capacitor, and the first scan signal line 31 are arranged along the second direction Y.

In an exemplary implementation mode, in the second direction Y, the first scan signal line 31 and the light emitting control line 32 are located on both sides of the first electrode plate 33 of the storage capacitor. For example, in the second direction, the light emitting control line 32, the first electrode plate 33, and the first scan signal line 31 are sequentially arranged.

Taking a sub-pixel in an M-th row and an N-th row as an example, in the second direction Y, the light emitting control line 32 may be located on a side of a first electrode plate 33 of a storage capacitor in a present sub-pixel close to a sub-pixel of an (M-1)-th row; the first scan signal line 31 may be located on a side of the first electrode plate 33 of the storage capacitor in the present sub-pixel close to a sub-pixel of an (M+1)-th row.

In an exemplary implementation mode, the first electrode plate 33 may be located between the light emitting control line 32 and the first scan signal line 31, the first electrode plate 33 may be in a rectangular shape, corners of the rectangular shape may be provided with chamfers, and there is an overlapping region between an orthographic projection of the first electrode plate 33 on the base substrate and an orthographic projection of the active layer of the third transistor T3 on the base substrate. In an exemplary embodiment, the first electrode plate 33 may simultaneously serve as an electrode plate of the storage capacitor and a control electrode of the third transistor T3.

In an exemplary implementation mode, a region where the light emitting control line 32 is overlapped with the active layer of the fifth transistor T5 serves as a control electrode of the fifth transistor T5, a region where the light emitting control line 32 is overlapped with the active layer of the sixth transistor T6 serves as a control electrode of the sixth transistor T6, a region where the first scan signal line 31 is overlapped with the active layer of the fourth transistor T4 serves as a control electrode of the fourth transistor T4, and a region where the first scan signal line 31 is overlapped with the active layer of the seventh transistor T7 serves as a control electrode of the seventh transistor T7.

In an exemplary implementation mode, the first scan signal line 31 and the light emitting control line 32 may be designed with an equal width or with non-equal widths, thereby not only a layout of a pixel structure may be facilitated, but also a parasitic capacitance between signal lines may be reduced.

In an exemplary implementation mode, after the pattern of the first conductive layer is formed, the semiconductor layer may be subjected to a conductive treatment by using the first conductive layer as a shield. The semiconductor layer, in a region which is shielded by the first conductive layer, forms channel regions of the third transistor T3 to the seventh transistor T7, and the semiconductor layer, in a region which is not shielded by the first conductive layer, is made to be conductive, that is, first regions and second regions of the active layer 23 of the third transistor T3 to the active layer 27 of the seventh transistor T8 are all made to be conductive.

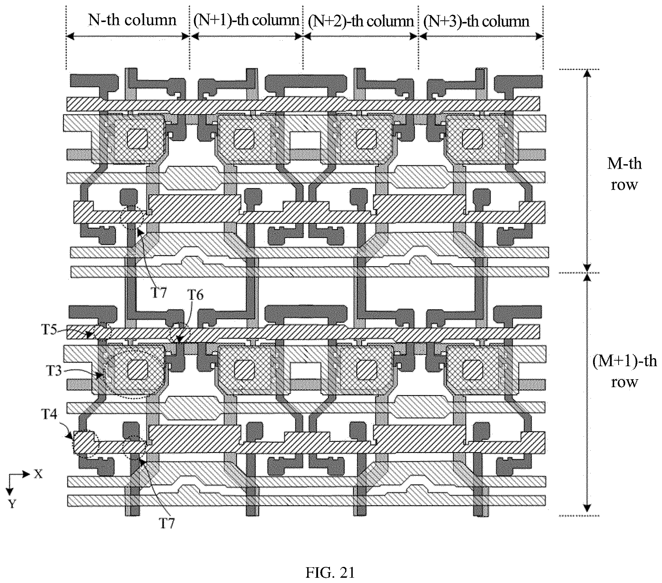

(205) A pattern of a second conductive layer is formed. A preparation method is the same as the above (105), and will not be described here. The formed pattern of the second conductive layer is shown in FIG. 12b, and FIG. 21 is a planar structure view of eight sub-pixels.

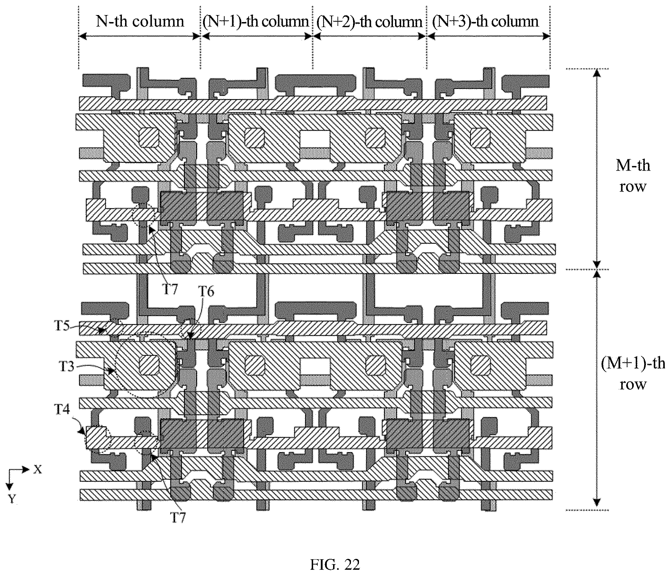

(206) A pattern of a second semiconductor layer is formed. A preparation method is the same as the above (106), and will not be described here. The formed pattern of the second conductive layer is shown in FIG. 13b, and FIG. 22 is a planar structure view of eight sub-pixels.

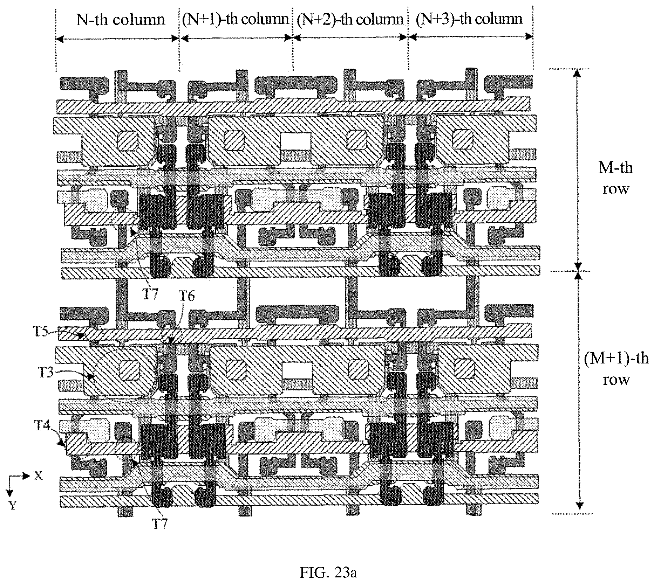

(207) A pattern of a third conductive layer is formed. In an exemplary implementation mode, forming the pattern of the third conductive layer may include: depositing sequentially a fifth insulation thin film and a third conductive thin film on the base substrate, on which the aforementioned patterns are formed, patterning the third conductive thin film through a patterning process to form a fifth insulation layer covering the second semiconductor layer and the pattern of the third conductive layer disposed on the fifth insulation layer, as shown in FIG. 23a to FIG. 23b, wherein FIG. 23a is a planar structure view of eight sub-pixels, and FIG. 23b is a planar schematic view of the third conductive layer in FIG. 23a. In an exemplary implementation mode, the third conductive layer may be referred to as a third gate metal (GATE3) layer.

In an exemplary implementation mode, the pattern of the third conductive layer at least includes a second scan signal line 51 and a third scan signal line 52, the second scan signal line 51, the third scan signal line 52, and a main body portion of a switch connection electrode 53 may extend along the first direction X, and the third scan signal line 52, the switch connection electrode 53, and the second scan signal line 51 are arranged in sequence along the second direction Y.

In an exemplary implementation mode, a region where the second scan signal line 51 is overlapped with the active layer 21 of the first transistor T1 serves as a control electrode of the first transistor T1, and a region where the third scan signal line 52 is overlapped with the active layer 22 of the second transistor T2 serves as a control electrode of the second transistor T2.

In an exemplary implementation mode, the switch connection electrode 53 is connected with a second initial signal line 67 formed subsequently through a via, so that potentials of multiple second initial signal lines 67 of a same row of sub-pixels are the same, and a display effect is improved.

In an exemplary implementation mode, signals of the first shielding line 41 and the second scan signal line 51 may be the same, i.e., the first shielding line 41 and the second scan signal line 51 are connected in parallel and connected with a same signal source, so that the first shielding line 41 may serve as a bottom gate electrode (i.e., a bottom control electrode) of the first transistor T1, forming the first transistor T1 with a double-gate structure.

In an exemplary implementation mode, signals of the second shielding line 42 and the third scan signal line 52 may be the same, i.e., the second shielding line 42 and the third scan signal line 52 are connected in parallel and connected with a same signal source, so that the second shielding line 42 may serve as a bottom gate electrode (i.e., a bottom control electrode) of the second transistor T2, forming the second transistor T2 with a double-gate structure.

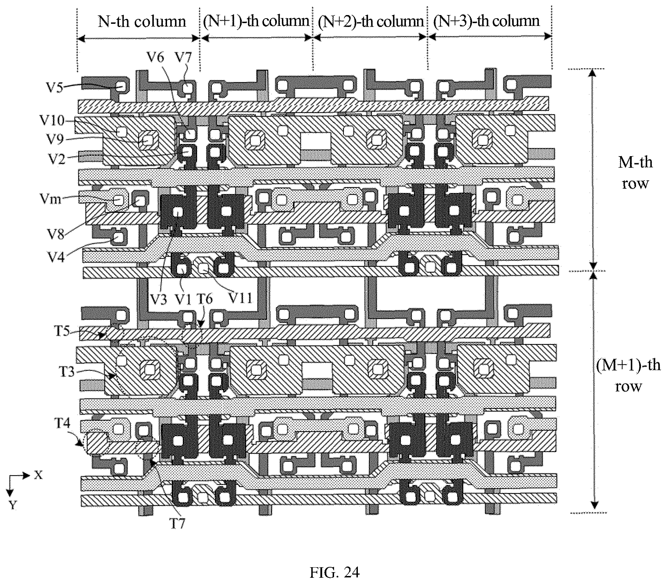

(208) A pattern of a sixth insulation layer is formed. In an exemplary implementation mode, forming the pattern of the sixth insulation layer may include: depositing a sixth insulation thin film on the base substrate on which the aforementioned patterns are formed, patterning the sixth insulation thin film through a patterning process to form a sixth insulation layer covering the third conductive layer, wherein the sixth insulation layer is provided with multiple vias, as shown in FIG. 24, FIG. 24 is a planar structure view of eight sub-pixels.

In an exemplary implementation mode, multiple vias of each sub-pixel at least include: a first via V1, a second via V2, a third via V3, a fourth via V4, a fifth via V5, a sixth via V6, a seventh via V7, an eighth via V8, a ninth via V9, a tenth via V10, an eleventh via V 11, and a switch via Vm.

In an exemplary implementation mode, an orthographic projection of the first via V1 on the base substrate is located within a range of an orthographic projection of the active layer 21 of the first transistor T1 on the base substrate, the sixth insulation layer and the fifth insulation layer within the first via V1 are etched away, exposing a surface of a first region 21-1 of the active layer 21 of the first transistor T1. The first via V1 is configured such that a first electrode of the first transistor T1 subsequently formed is connected with the active layer 21 of the first transistor T1 through the via.

In an exemplary implementation mode, an orthographic projection of the second via V2 on the base substrate is located within a range of an orthographic projection of the active layer 22 of the second transistor T2 on the base substrate, the sixth insulation layer and the fifth insulation layer within the second via V2 are etched away, exposing a surface of a second region 22-2 of the active layer 22 of the second transistor T2. The second via V2 is configured such that a second electrode of the second transistor T2 subsequently formed is connected with the active layer 22 of the second transistor T2 through the via.

In an exemplary implementation mode, an orthographic projection of the third via V3 on the base substrate is located within a range of an orthographic projection of the active layer 22 of the second transistor T2 on the base substrate, the sixth insulation layer and the fifth insulation layer within the third via V3 are etched away, exposing a surface of a first region 22-1 of the active layer 22 of the second transistor T2 (which is also a second region 21-2 of the active layer 21 of the first transistor T1). The third via V3 is configured such that a second electrode of the first transistor T1 formed subsequently is connected with the active layer 21 of the first transistor T1 through the via, and a first electrode of the second transistor T2 formed subsequently is connected with the active layer 22 of the second transistor T2 through the via.

In an exemplary implementation mode, an orthographic projection of the fourth via V4 on the base substrate is located within a range of an orthographic projection of the active layer 24 of the fourth transistor T4 on the base substrate, the sixth insulation layer, the fifth insulation layer, the fourth insulation layer, the third insulation layer, and the second insulation layer within the fourth via V4 are etched away, exposing a first region 24-1 of the active layer 24 of the fourth transistor T4. The fourth via V4 is configured such that a first electrode of the fourth transistor T4 subsequently formed is connected with the active layer 24 of the fourth transistor T4 through the via.

In an exemplary implementation mode, an orthographic projection of the fifth via V5 on the base substrate is located within a range of an orthographic projection of the active layer 25 of the fifth transistor T5 on the base substrate, the sixth insulation layer, the fifth insulation layer, the fourth insulation layer, the third insulation layer, and the second insulation layer within the fifth via V5 are etched away, exposing a surface of a first region 25-1 of the active layer 25 of the fifth transistor T5. The fifth via V5 is configured such that a first electrode of the fifth transistor T5 subsequently formed is connected with the active layer 25 of the fifth transistor T5 through the via.

In an exemplary implementation mode, an orthographic projection of the sixth via V6 on the base substrate is located within a range of an orthographic projection of the active layer 26 of the sixth transistor T6 on the base substrate, and the sixth insulation layer, the fifth insulation layer, the fourth insulation layer, the third insulation layer, and the second insulation layer within the sixth via V6 are etched away, exposing a surface of a first region 26-1 of the active layer 26 of the sixth transistor T6 (which is also a second region of the active layer 23 of the third transistor T3). The sixth via V6 is configured such that a first electrode of the sixth transistor T6 subsequently formed is connected with the active layer 26 of the sixth transistor T6 through the via, and a second electrode of the third transistor T3 subsequently formed is connected with the active layer 23 of the third transistor T3 through the via.

In an exemplary implementation mode, an orthographic projection of the seventh via V7 on the base substrate is located within a range of an orthographic projection of the active layer 26 of the sixth transistor T6 on the base substrate, and the sixth insulation layer, the fifth insulation layer, the fourth insulation layer, the third insulation layer, and the second insulation layer within the seventh via V7 are etched away, exposing a surface of a second region 26-2 of the active layer 26 of the sixth transistor T6 (which is also a second region 27-2 of the active layer 27 of the seventh transistor T7). The seventh via V7 is configured such that a second electrode of the sixth transistor T6 subsequently formed is connected with the active layer 26 of the sixth transistor T6 through the via, and a second electrode of the seventh transistor T7 subsequently formed is connected with the active layer 27 of the seventh transistor T7 through the via.

In an exemplary implementation mode, an orthographic projection of the eighth via V8 on the base substrate is located within a range of an orthographic projection of the active layer 27 of the seventh transistor T7 on the base substrate, and the sixth insulation layer, the fifth insulation layer, the fourth insulation layer, the third insulation layer, and the second insulation layer within the eighth via V8 are etched away, exposing a surface of a first region 27-1 of the active layer 27 of the seventh transistor T7. The eighth via V8 is configured such that a first electrode of the seventh transistor T7 subsequently formed is connected with the active layer 27 of the seventh transistor T7 through the via.

In an exemplary implementation mode, an orthographic projection of the ninth via V9 on the base substrate is located within a range of an orthographic projection of an opening 44 on the base substrate, and the sixth insulation layer, the fifth insulation layer, the fourth insulation layer, and the third insulation layer within the ninth via V9 are etched away to expose a surface of the first electrode plate 33. The ninth via V9 is configured such that a second electrode of the first transistor T1 subsequently formed is connected with the first electrode plate 33 through the via.

In an exemplary implementation mode, the tenth via V10 is located within a range of an orthographic projection of the second electrode plate 43 on the base substrate, and the sixth insulation layer, fifth insulation layer, and the fourth insulation layer within the tenth via V10 are etched away to expose a surface of the second electrode plate 43. The tenth via V10 is configured such that a sixth connection electrode subsequently formed is connected with the second electrode plate 43 through the via. In an exemplary embodiment, there may be multiple tenth vias V10 used as power supply vias, and the multiple tenth vias V10 may be sequentially arranged along the second direction Y or the first direction X, thereby increasing reliability of a connection between the first power supply line and the second electrode plate 43.

In an exemplary implementation mode, an orthographic projection of the eleventh via V11 on the base substrate is within a range of an orthographic projection of the first initial signal line 45 on the base substrate, the sixth insulation layer, the fifth insulation layer, and the fourth insulation layer within the eleventh via V11 are etched away, exposing a surface of the first initial signal line 45. The eleventh via V11 is configured such that a first electrode of the first transistor T1 subsequently formed an orthographic projection of the first initial signal line 45 through the via.

In an exemplary implementation mode, an orthographic projection of the switch via Vm on the base substrate is within a range of an orthographic projection of the switch connection electrode 53 on the base substrate, and the sixth insulation layer, the fifth insulation layer, and the fourth insulation layer within the switch via Vm are etched away to expose a surface of the switch connection electrode 53. The switch via Vm is configured such that two adjacent second initial signal lines of a same row formed subsequently are connected through the via.

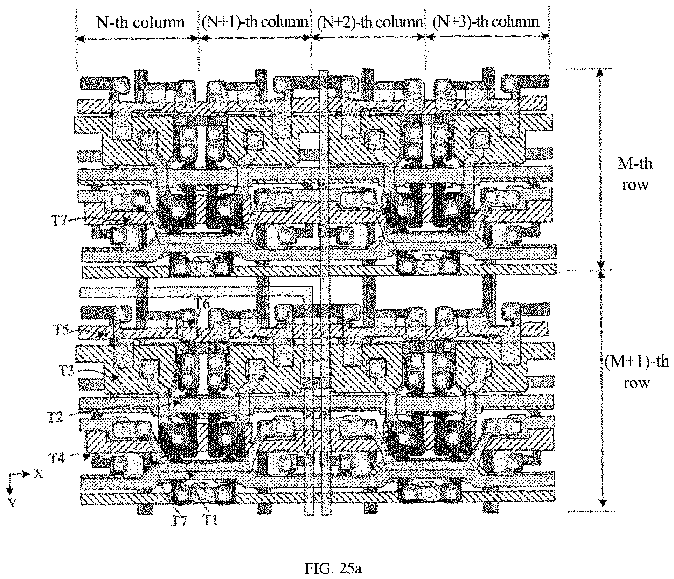

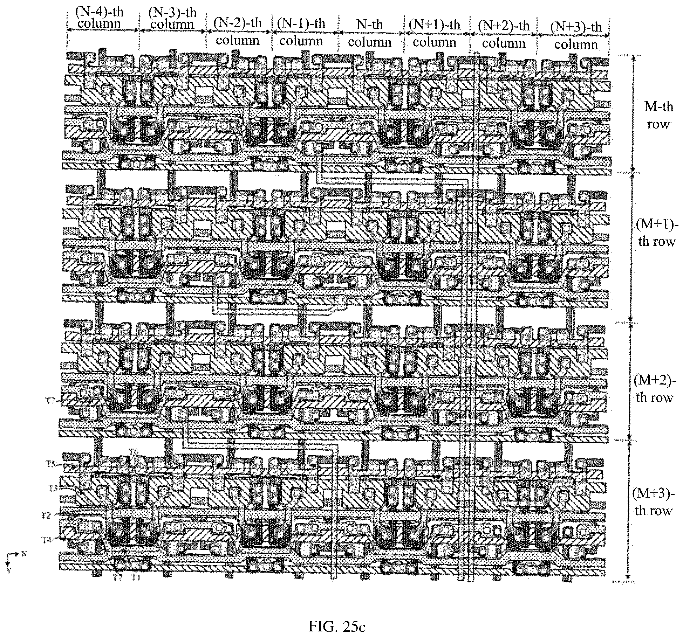

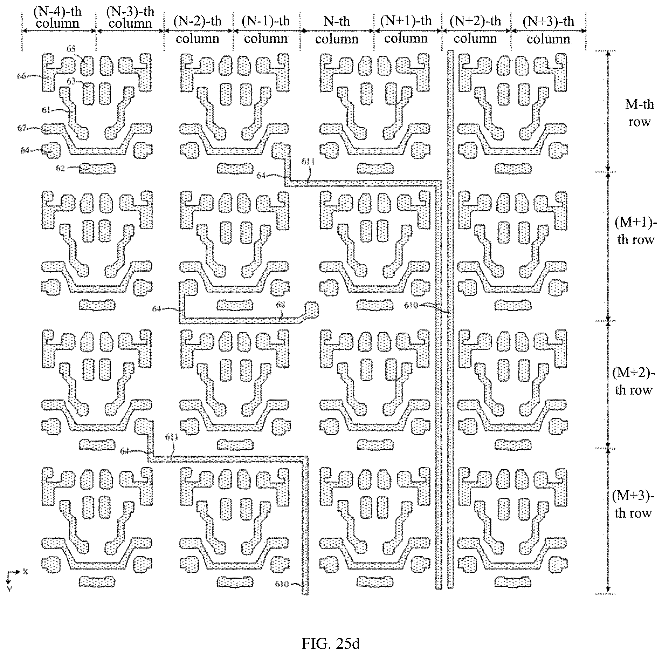

(209) A pattern of a fourth conductive layer is formed. In an exemplary embodiment, forming the pattern of the fourth conductive layer may include: depositing a fourth conductive thin film on the base substrate on which the aforementioned patterns are formed, patterning the fourth conductive thin film through a patterning process to form a fourth conductive layer disposed on the sixth insulation layer, as shown in FIG. 25a to FIG. 25d. FIG. 25a is a planar structure view of eight sub-pixels, FIG. 25b is a planar schematic view of the fourth conductive layer in FIG. 25a, FIG. 25c is a planar structure view of thirty-two sub-pixels, and FIG. 25d is a planar schematic view of the fourth conductive layer in FIG. 25c. In an exemplary implementation mode, the fourth conductive layer may be referred to as a first source drain metal (SD1) layer.

In an exemplary implementation mode, the fourth conductive layer at least includes a first connection electrode 61, a second connection electrode 62, a third connection electrode 63, a fourth connection electrode 64, a fifth connection electrode 65, a sixth connection electrode 66, a second initial signal line 67, a first data connection line 68, a third data connection line 610, and a fourth data connection line 611.

In an exemplary implementation mode, the first connection electrode 61 is in a shape of a polyline in which a main body portion extends along the second direction Y, a first terminal thereof is connected with the second region 21-2 of the active layer 21 of the first transistor T1 (which is also the first region 22-1 of the active layer 22 of the second transistor T2 ) through the third via V3, and a second terminal thereof is connected with the first electrode plate 33 through the ninth via V9, so that the first electrode plate 33, the second electrode of the first transistor T1, and the first electrode of the second transistor T2 have a same potential. In an exemplary embodiment, the first connection electrode 61 may be used as the second electrode of the first transistor T1 and the first electrode of the second transistor T2.

In an exemplary implementation mode, the second connection electrode 62 may be in a strip shape in with a main body portion extends along the first direction X, the second connection electrode 62 is connected with the first region 21-1 of the active layer 21 of the first transistor T1 through the first via V1, and is connected, through an eleventh via V11 in a sub-pixel row, with a first initial signal line 45 in a sub-pixel of the row. In an exemplary embodiment, the second connection electrode 62 may serve as the first electrode of the first transistor T1, and the second connection electrode 62 is configured to be connected with the first initial signal line 45 and the active layer 21 of the first transistor T1.

In an exemplary implementation mode, an N-th column and an (N+1)-th column share a same second connection electrode 62, and an (N+2)-th column and an (N+3)-th column share a same second connection electrode 62. In an exemplary implementation mode, since a second connection electrode 62 in each sub-pixel is connected with the first initial signal line 45, by sharing a same second connection electrode 62 with adjacent sub-pixels to form an interconnected integrated structure, it may be ensured that second connection electrodes 62 of the adjacent sub-pixels have a same potential, which is beneficial to improving uniformity of a panel, avoiding poor display of the display substrate, and ensuring a display effect of the display substrate.

In an exemplary implementation mode, one terminal of the third connection electrode 63 is connected with the second region 22-2 of the active layer 22 of the second transistor T2 through the second via V2, and the other terminal of the third connection electrode 63 is connected with the second region 23-2 of the active layer 23 of the third transistor T3 (which is also the first region 26-1 of the active layer 26 of the sixth transistor T6) through the sixth via V6. In an exemplary embodiment, the third connection electrode 63 may simultaneously serve as the second electrode of the second transistor T2, the second electrode of the third transistor T3, and the first electrode of the sixth transistor T6, so that the second electrode of the second transistor T2, the second electrode of the third transistor T3, and the first electrode of the sixth transistor T6 have a same potential.

In an exemplary implementation mode, the fourth connection electrode 64 is connected with the first region 24-1 of the active layer 24 of the fourth transistor T4 through the fourth via V4. In an exemplary embodiment, the fourth connection electrode 64 may serve as the first electrode of the fourth transistor T4, and is configured to be connected with a data signal line formed subsequently.

In an exemplary implementation mode, the sixth connection electrode 66 is connected with the first region 25-1 of the active layer 25 of the fifth transistor T5 through the fifth via V5, and the sixth connection electrode 66 is connected with the second electrode plate 43 through the tenth via V10. In an exemplary embodiment, the sixth connection electrode 66 may serve as the first electrode of the fifth transistor T5, and is configured to be connected with a first power supply line formed subsequently.

In an exemplary implementation mode, the fifth connection electrode 65 is connected with the second region 26-2 of the active layer 26 of the sixth transistor T6 (which is also the second region 27-2 of the active layer 27 of the seventh transistor T7) through the seventh via V7. In an exemplary embodiment, the fifth connection electrode 65 may serve as the second electrode of the sixth transistor T6 and the second electrode of the seventh transistor T7, and the fifth connection electrode 65 is configured to be connected with an anode connection electrode of a light emitting element formed subsequently.

In an exemplary implementation mode, the second initial signal line 67 may be in a polyline shape in which a main body portion extends along the first direction X, the second initial signal line 67 is connected with first regions 27-1 of active layers 27 of seventh transistors T7 of two adjacent columns through an eighth via V8 in a sub-pixel row, and an initial voltage is written into seventh transistors T7 of two adjacent columns in a sub-pixel row; the second initial signal line 67 is connected with the switch connection electrode 53 through the switch via Vm, and the switch connection electrode 53 electrically connects multiple second initial signal lines 67 in a same row with each other, so that multiple second initial signal lines 67 in a same sub-pixel row have a same potential, which is beneficial to improving uniformity of the panel and avoiding poor display of the display substrate. In an exemplary embodiment, the second initial signal line 67 may be used as the first electrode of the seventh transistor T7.

In an exemplary implementation mode, the first data connection line 68 may be in a shape of a polyline or a strip in which a main body portion extends along the first direction X. In an exemplary implementation mode, the first data connection line 68 is disposed between adjacent rows of sub-pixels. In an exemplary implementation mode, one end of the first data connection line 68 is configured to be connected with a second data connection line subsequently formed through a via, and the other end is configured to be connected with a data signal line subsequently formed through a via. In an exemplary implementation mode, as shown in FIG. 25d, one end of the first data connection line 68 may be of an integrally formed structure with one of fourth data connection electrodes 64, and the other end may be electrically connected with a second data connection line subsequently formed through a via. In an exemplary implementation mode, as shown in FIG. 25d, the fourth connection electrode 64 connected with the first data connection line 68 may be of a strip structure or a polyline-typed structure extending along the second direction Y, one terminal thereof is integrally formed with the first data connection line 68, and the other terminal thereof is electrically connected with a data signal line formed subsequently through the twelfth via V12.

In an exemplary implementation mode, the fourth data connection line 611 may be in a polyline shape or a strip shape in which a main body portion extends along the first direction X. In an exemplary implementation mode, the fourth data connection line 611 is disposed between adjacent rows of sub-pixels. In an exemplary implementation mode, one end of the fourth data connection line 611 is connected with the third data connection line 610, and the other end is integrally formed with one of fourth connection electrodes, and is configured to be connected with a data signal line formed subsequently through a via. In an exemplary implementation mode, as shown in FIG. 25d, the fourth connection electrode 64 connected with the fourth data connection line 611 may be of a strip structure or a polyline-typed structure extending along the second direction Y, one terminal thereof is integrally formed with the fourth data connection line 611, and the other terminal thereof is electrically connected with a data signal line formed subsequently through the twelfth via V12.

A main body portion of the third data connection line 610 extends along the second direction Y, and one end of the third data connection line 610 is connected with the fourth data connection line 611, and the other end is connected with a drive chip in a bonding region. In an exemplary implementation mode, the third data connection line 610 is disposed between two adjacent columns of sub-pixels. In an exemplary implementation mode, two third data connection lines 610 may be disposed between two adjacent columns of sub-pixels and two adjacent third data connection lines 610 are respectively connected with fourth data connection lines 611 in different sub-pixel rows.

In an exemplary implementation mode, any third data connection line 610 is connected with the fourth data connection line 611 in the display region, and is connected with an Integrated Circuit (IC) in a drive chip region in the bonding region.

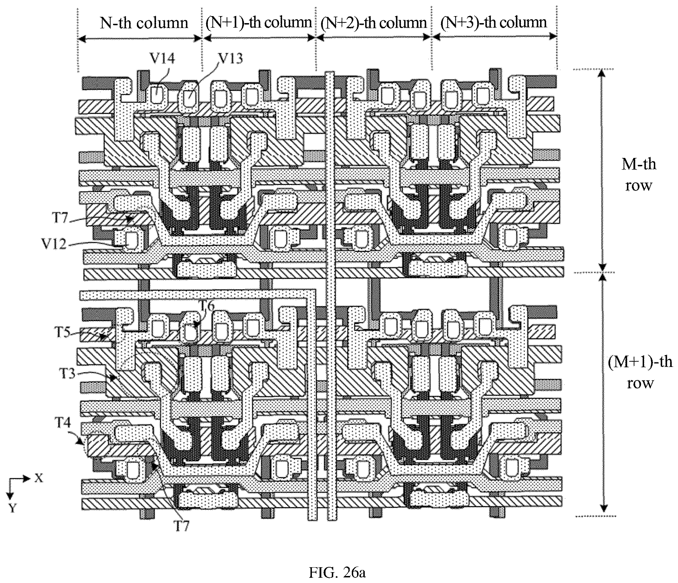

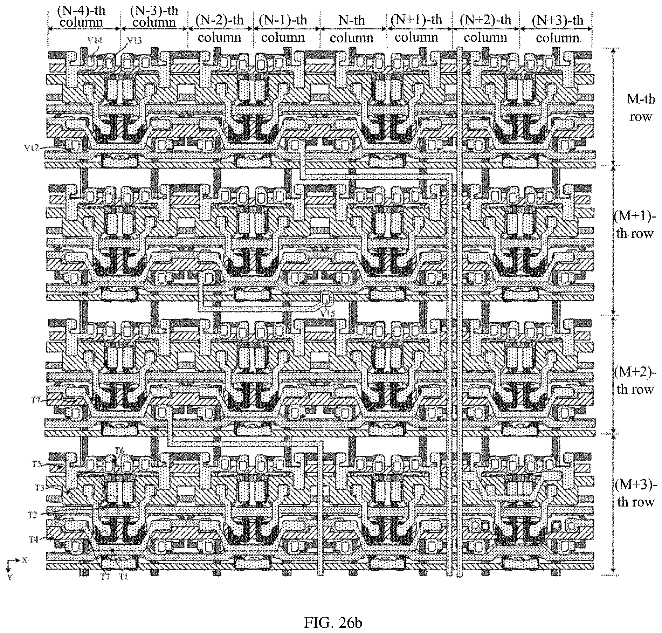

(210) Patterns of a seventh insulation layer and a first planarization layer are formed. In an exemplary implementation mode, forming the patterns of the seventh insulation layer and the first planarization layer may include: first depositing a seventh insulation thin film on the base substrate on which the aforementioned patterns are formed, and then coating a first planarization thin film, patterning the first planarization thin film and the seventh insulation thin film through a patterning process to form the seventh insulation layer covering the pattern of the fourth conductive layer and the first planarization layer disposed on the seventh insulation layer. Multiple vias are disposed on the seventh insulation layer and the first planarization layer, as shown in FIGs. 26a and 26b. FIG. 26a is a planar structure view of eight sub-pixels, and FIG. 26b is a planar structure view of thirty-two sub-pixels.

In an exemplary implementation mode, multiple vias in each sub-pixel at least include a twelfth via V12, a thirteenth via V13, a fourteenth via V14, and a fifteenth via V15.

In an exemplary implementation mode, an orthographic projection of the twelfth via V12 on the base substrate is located within a range of an orthographic projection of the fourth connection electrode 64 on the base substrate. The first planarization layer and the seventh insulation layer within the twelfth via V12 are etched away to expose a surface of the fourth connection electrode 64. The twelfth via V12 is configured such that a data signal line subsequently formed is connected with the fourth connection electrode 64 through the via. The first data connection line 68 and the fourth connection electrode 64 share a via (V12) to be connected with the data signal line formed subsequently, thereby saving space of a pixel drive circuit.

In an exemplary implementation mode, an orthographic projection of the thirteenth via V13 on the base substrate is located within a range of an orthographic projection of the fifth connection electrode 65 on the base substrate. The first planarization layer and the seventh insulation layer within the thirteenth via V13 are etched away to expose a surface of the fifth connection electrode 65. The thirteenth via V13 is configured such that an anode connection electrode of a light emitting element subsequently formed is connected with the fifth connection electrode 65 through the via.

In an exemplary implementation mode, an orthographic projection of the fourteenth via V14 on the base substrate is within a range of an orthographic projection of the sixth connection electrode 66 on the base substrate. The first planarization layer and the seventh insulation layer within the fourteenth via V14 are etched away to expose a surface of the sixth connection electrode 66. The fourteenth via V14 is configured such that a first power supply line formed subsequently is connected with the sixth connection electrode 66 through the via.

In an exemplary implementation mode, an orthographic projection of the fifteenth via V15 on the base substrate is located within a range of an orthographic projection of the first data connection line 68 on the base substrate. The first planarization layer and the seventh insulation layer within the fifteenth via V15 are etched away to expose a surface of the first data connection line 68. The fifteenth via V15 is configured such that a second data connection line formed subsequently is connected with the first data connection line 68 through the via.

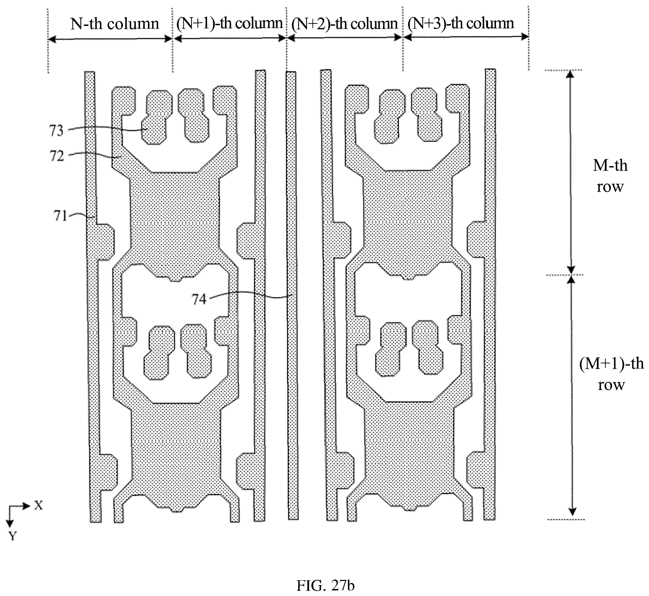

(211) A pattern of a fifth conductive layer is formed. In an exemplary implementation mode, forming the fifth conductive layer may include: depositing a fifth conductive thin film on the base substrate on which the aforementioned patterns are formed, and patterning the fifth conductive thin film through a patterning process to form the fifth conductive layer disposed on the first planarization layer, as shown in FIG. 27a to FIG.27c. FIG. 27a is a planar structure view of eight sub-pixels, FIG. 27b is a planar schematic view of the fifth conductive layer in FIG. 27a, and FIG. 27c is a planar structure view of thirty-two sub-pixels. In an exemplary implementation mode, the fifth conductive layer may be referred to as a second source drain metal (SD2) layer.

In an exemplary implementation mode, the fifth conductive layer at least includes: a data signal line 71, a first power supply line 72, an anode connection electrode 73, and a second data connection line 74. In an exemplary embodiment, the anode connection electrode 73 is an anode connection electrode of a light emitting element.

In an exemplary embodiment, a main body portion of the data signal line 71 extends along the second direction Y, and the data signal line 71 is connected with the fourth connection electrode 64 through the twelfth via V12. Since the fourth connection electrode 64 is connected with the first region 24-1 of the active layer 24 of the fourth transistor T4 through a via, a connection between the data signal line 71 and the first electrode of the fourth transistor T4 is achieved, and a data signal is written into the fourth transistor T4.

In an exemplary embodiment, the first power supply line 72 is in a polyline shape in with a main body portion extends along the second direction Y. The first power supply line 72 is connected with the sixth connection electrode 66 through the fourteenth via V14. Since the sixth connection electrode 66 is connected with the second electrode plate 43 through a via, a connection between the first power supply line 72 and the second electrode plate 43 is achieved, and a power supply signal is written into the second electrode plate 43. Since the sixth connection electrode 66 is connected with the first region 25-1 of the active layer 25 of the fifth transistor T5 through a via, a connection between the first power supply line 72 and the first electrode of the fifth transistor T5 is achieved, and a power supply signal is written into the fifth transistor T5.

In an exemplary embodiment, the anode connection electrode 73 is connected with the fifth connection electrode 65 through the thirteenth via V13. Since the fifth connection electrode 65 is connected with the second region 26-2 of the active layer 26 of the sixth transistor T6 (which is also the second region 27-2 of the active layer 27 of the seventh transistor T7) through a via, connections between the anode connection electrode 73 and the second electrode of the sixth transistor T6 as well as the second electrode of the seventh transistor are achieved.

In an exemplary embodiment, a main body portion of the second data connection line 74 extends along the second direction Y, and the second data connection line 74 is connected with the first data connection line 68 through the fifteenth via V15. In an exemplary implementation mode, the second data connection line 74 is disposed between two adjacent columns of sub-pixels. In an exemplary implementation mode, one second data connection line 74 may be disposed between two adjacent columns of sub-pixels.

In an exemplary implementation mode, in a plane where the display substrate is located, two third data connection lines 610 and one second data connection line 74 are disposed between two adjacent rows of sub-pixels, and in the first direction X, the second data connection line 74 is disposed between the two third data connection lines 610. Two third data connection lines 610 between two adjacent columns of sub-pixels are respectively connected with two fourth data connection lines 611 located in two first spaces R1, and one second data connection line 74 is connected with a first data connection line 68 in a first space R1 through a via.

As shown in FIGs. 8c and 27c, which are 16 sub-pixels (2 sub-pixel rows and 8 sub-pixel columns) in the display region (AA) prepared through the above (201) to (211), in a structure shown in FIG. 8c, in a second space R2 between an (N+3)-th column of pixels and an (N+4)-th column of pixels, and a second space R2 between an (N+5)-th column of pixels and an (N+6)-th column of pixels, in a same second space R2, a quantity of third data connection lines 610 is one, a quantity of second data connection lines 74 is two, in the plane where the display substrate is located, two second data connection lines 74 are located on both sides of a third data connection line 610 in the first direction X, and two second data connection lines 74 in the same second space R2 are connected with different first data connection lines 68. In a second space R2 between an (N+1)-th column of pixels and an (N+2)-th column of pixels, in a same second space R2, a quantity of third data connection lines 610 is two, a quantity of second data connection lines 74 is one, in the plane where the display substrate is located, in the first direction X, two third data connection lines 610 are located on both sides of a second data connection line 74, and the two third data connection lines 610 in the same second space R2 are connected with different fourth data connection lines 611.

As shown in FIG. 27c, which is thirty-two sub-pixels (4 sub-pixel rows and 8 sub-pixel columns) in the display region (AA) prepared through the above (201) to (211), in a structure shown in FIG. 27c, in a second space R2 between an (N+1)-th column of pixels and an (N+2)-th column of pixels, and a second space R2 between an (N-3)-th column of pixels and an (N-2)-th column of pixels, in a same second space R2, a quantity of third data connection lines 610 is two, a quantity of second data connection line 74 is one, in the plane where the display substrate is located, in the first direction X, the two third data connection lines 610 are located on both sides of a second data connection line 74, and the two third data connection lines 610 in the same second space R2 are connected with different fourth data connection lines 611; in a second space R2 between an (N-1)-th column of pixels and an N-th column of pixels, in a same second space R2, a quantity of second data connection lines 74 is two and a quantity of third data connection lines 610 is one, in the plane where the display substrate is located, in the first direction X, two second data connection lines 74 are located on both sides of a third data connection line 610, and the two second data connection lines 74 in the same second space R2 are connected with different first data connection lines 68.

So far, preparation of a drive circuit layer prepares completed on the base substrate. In an exemplary implementation mode, in a plane perpendicular to the display substrate, the drive circuit layer may include a shielding layer, a first semiconductor layer, a first conductive layer, a second conductive layer, a second semiconductor layer, a third conductive layer, a fourth conductive layer, and a fifth conductive layer that are sequentially disposed on the base substrate.

In an exemplary implementation mode, the drive circuit layer may include the first insulation layer, the second insulation layer, the third insulation layer, the fourth insulation layer, the fifth insulation layer, the sixth insulation layer, the seventh insulation layer, and the first planarization layer, the first insulation layer is disposed between the shielding layer and the first semiconductor layer, the second insulation layer is disposed between the first semiconductor layer and the first conductive layer, the third insulation layer is disposed between the first conductive layer and the second conductive layer, the fourth insulation layer is disposed between the second conductive layer and the second semiconductor layer, the fifth insulation layer is disposed between the second semiconductor layer and the third conductive layer, the sixth insulation layer is disposed between the third conductive layer and the fourth conductive layer, and the seventh insulation layer and the first planarization layer are disposed between the fourth conductive layer and the fifth conductive layer.

In an exemplary implementation mode, after the preparation of the drive circuit layer is completed, a light emitting structure layer is prepared on the drive circuit layer, and a preparation process of the light emitting structure layer may include following operations. A pattern of a second planarization layer is formed and at least an anode via is disposed on the second planarization layer. A pattern of an anode is formed and the anode is connected with an anode connection electrode through the anode via. An anode pixel definition layer, and the pixel definition layer is provided with a pixel opening, and the pixel opening exposes the anode. An organic emitting layer is formed using an evaporation or inkjet printing process, and a cathode is formed on the organic emitting layer. An encapsulation layer is formed, wherein the encapsulation layer may include a first encapsulation layer, a second encapsulation layer, and a third encapsulation layer that are stacked, the first encapsulation layer and the third encapsulation layer may be made of an inorganic material, the second encapsulation layer may be made of an organic material, and the second encapsulation layer is disposed between the first encapsulation layer and the third encapsulation layer to ensure that external water vapor cannot enter the light emitting structure layer.

In an exemplary implementation mode, the shielding layer, the first conductive layer, the second conductive layer, the third conductive layer, the fourth conductive layer, and the fifth conductive layer may be made of a metal material, such as any one or more of Argentum (Ag), Copper (Cu), Aluminum (Al), and Molybdenum (Mo), or an alloy material of the above metals, such as an Aluminum Neodymium alloy (AlNd) or a Molybdenum Niobium alloy (MoNb), and may be of a single-layer structure or a multi-layer composite structure, such as Mo/Cu/Mo and Ti/Al/Ti. The first insulation layer, the second insulation layer, the third insulation layer, the fourth insulation layer, the fifth insulation layer, the sixth insulation layer, and the seventh insulation layer may be made of any one or more of Silicon Oxide (SiOx), Silicon Nitride (SiNx), and Silicon Oxynitride (SiON), and may be a single layer, a multi-layer, or a composite layer. The first insulation layer may be referred to as a buffer layer to improve a water and oxygen resistance capability of the base substrate, the second insulation layer, the third insulation layer, the forth insulation later, and the fifth insulation layer may be referred to as Gate Insulation (GI) layers, the sixth insulation layer may be referred to as an Interlayer Dielectric (ILD) layer, and the seventh insulation layer is referred to as a Passivation (PVX) layer.

Structures and preparation processes shown in the aforementioned embodiments of the present disclosure are only exemplary explanations. In an exemplary implementation mode, a corresponding structure may be changed and a patterning process may be increased or reduced according to actual needs. A display substrate of an embodiment of the present disclosure may be applied to another display apparatus with a pixel drive circuit, such as a quantum dot display. The present disclosure is not limited here.

The present disclosure also provides a display apparatus which includes the display substrate according to any one of the aforementioned embodiments. The display apparatus may be any product or component with a display function, such as a mobile phone, a tablet computer, a television, a display, a laptop computer, a digital photo frame, or a navigator.

The present disclosure also provides a preparation method of a display substrate, wherein the display substrate includes a display region and a bonding region connected with the display region, wherein the display region includes multiple data signal lines and K rows and L columns of sub-pixels, wherein both K and L are positive integers greater than 1; multiple first spaces are included between K sub-pixel rows and multiple second spaces are included between L sub-pixel columns, wherein a first space is located between two adjacent sub-pixel rows, a second space is located between two adjacent sub-pixel columns, at least one first space is provided with a first data connection line, at least one second space is provided with at least one second data connection line, on a plane parallel to the display substrate, the first data connection line extends along a first direction, the second data connection line extends along a second direction, and the first direction intersects with the second direction. The preparation method includes: electrically connecting one end of the first data connection line with one of the data signal lines, and electrically connecting the other end with one second data connection line; electrically connecting one end of the second data connection line with the first data line, and electrically connecting the other end with the bonding region.

According to the base substrate and the display apparatus provided by the embodiments of the present disclosure, the display region of the display substrate includes multiple data signal lines and K rows and L columns of sub-pixels, wherein both K and L are positive integers greater than 1; multiple first spaces are included between K sub-pixel rows, multiple second spaces are included between L sub-pixel columns, a first space is located between two adjacent sub-pixel rows, a second space is located between two adjacent sub-pixel columns, at least one first space is provided with a first data connection line, and at least one second space is provided with at least one second data connection line; one end of the first data connection line is electrically connected with one of the data signal lines, and the other end is electrically connected with one second data connection line; one end of the second data connection line is electrically connected with the first data line, and the other end is electrically connected with the bonding region; the first data connection line and the second data connection line are introduced into the display region, which reduces a bezel of the display substrate to a great extent and is beneficial to achievement of a narrow bezel of a display product.

The drawings of the embodiments of the present disclosure only involve structures involved in the embodiments of the present disclosure, and other structures may be referred to usual designs.

The embodiments of the present disclosure, that is, features in the embodiments, may be combined with each other to obtain new embodiments if there is no conflict.

Although implementation modes disclosed in the embodiments of the present disclosure are described above, contents are only implementation modes for facilitating understanding the embodiments of the present disclosure, and are not intended to limit the embodiments of the present disclosure. Any person skilled in the art to which the embodiments of the present disclosure pertain may make any modification and variation in forms and details of implementation without departing from the spirit and scope disclosed in the embodiments of the present disclosure. Nevertheless, the scope of patent protection of the embodiments of the present disclosure shall still be subject to the scope defined in the appended claims.

**Claims**

1. A display substrate, comprising a display region and a bonding region connected with the display region, wherein the display region comprises a plurality of data signal lines and K rows and L columns of sub-pixels, both K and L are positive integers greater than 1; a plurality of first spaces are comprised between K sub-pixel rows and a plurality of second spaces are comprised between L sub-pixel columns, wherein a first space is located between two adjacent sub-pixel rows, a second space is located between two adjacent sub-pixel columns, at least one first space is provided with a first data connection line, at least one second space is provided with at least one second data connection line, on a plane parallel to the display substrate, the first data connection line extends along a first direction, the second data connection line extends along a second direction, and the first direction intersects with the second direction;

   one end of the first data connection line is electrically connected with one of the data signal lines, and the other end is electrically connected with one of second data connection lines; one end of the second data connection line is electrically connected with the first data connection line, and the other end is electrically connected with the bonding region.

2. The display substrate according to claim 1, wherein the first space is further provided with a fourth data connection line and the second space is further provided with a third data connection line;

   a same second space is provided with at least one second data connection line and at least one third data connection line;

   the fourth data connection line extends along the first direction, one end is electrically connected with a data signal line, and the other end is connected with the third data connection line; the third data connection line extends along the second direction, one end is connected with the fourth data connection line, and the other end is electrically connected with the bonding region;

   wherein the first data connection line and the second data connection line are connected through a via, and the third data connection line and the fourth data connection line are of an integrally formed structure.

3. The display substrate according to claim 2, wherein in the same second space, a quantity of third data connection lines is one, a quantity of second data connection lines is two, in a plane where the display substrate is located, in the first direction, two second data connection lines are located on both sides of a third data connection line, and two second data connection lines in the same second space are connected with different first data connection lines; or, in the same second space, a quantity of third data connection lines is two, a quantity of second data connection lines is one, in the plane where the display substrate is located, in the first direction, two third data connection lines are located on both sides of a second data connection line, and two third data connection lines in the same second space are connected with different fourth data connection lines.

4. The display substrate according to claim 1, wherein in a same second space, a quantity of the second data connection lines is three, and the three second data connection lines are respectively connected with three different first data connection lines.

5. The display substrate according to claim 1, wherein at least one sub-pixel comprises a pixel drive circuit, in a plane perpendicular to the display substrate, the display substrate comprises a base substrate, and a first semiconductor layer, a first conductive layer, a second conductive layer, a second semiconductor layer, a third conductive layer, a fourth conductive layer, and a fifth conductive layer which are sequentially stacked on the base substrate;

   the first semiconductor layer comprises: active layers of a plurality of low temperature poly silicon transistors located in the pixel drive circuit;

   the first conductive layer comprises: control electrodes of the plurality of poly silicon transistors and a first electrode plate of a storage capacitor located in the pixel drive circuit;

   the second conductive layer comprises: a second electrode plate of the storage capacitor located in the pixel drive circuit;

the second semiconductor layer comprises: active layers of a plurality of oxide transistors located in the pixel drive circuit;

the third conductive layer comprises: control electrodes of the plurality of oxide transistors located in the pixel drive circuit;

the fourth conductive layer comprises the first data connection line, and first electrodes and second electrodes of the plurality of low temperature poly silicon transistors and first electrodes and second electrodes of the plurality of oxide transistors located in the pixel drive circuit; and

the fifth conductive layer comprises a data signal line, a first power supply line, and the second data connection line.

6. The display substrate according to claim 5, wherein the display substrate further comprises a light emitting element, the plurality of low temperature poly silicon transistors comprise a seventh transistor for resetting an anode of the light emitting element, the third conductive layer further comprises a switch connection electrode, the fourth conductive layer further comprises a plurality of second initial signal lines, in a plane where the fourth conductive layer is located, a main body portion of a second initial signal line is in a polyline shape extending along the first direction, the plurality of second initial signal lines are arranged in an array along the first direction and the second direction, the second initial signal line is connected with an active layer of the seventh transistor in the first semiconductor layer through a via and multiplexed as a first electrode of the seventh transistor; in a same sub-pixel row, two adjacent second initial signal lines are connected with a same switch connection electrode through a switch via.

7. The display substrate according to claim 6, wherein the switch connection electrode extends along the first direction, and there is an overlapping region between an orthographic projection of the switch connection electrode on the base substrate and an orthographic projection of one of the second spaces on the base substrate.

8. The display substrate according to claim 6, wherein the fourth conductive layer further comprises a fourth data connection line and a third data connection line, an orthographic projection of the fourth data connection line on the base substrate is at least partially overlapped with an orthographic projection of one of the first spaces on the base substrate, and the orthographic projection of the fourth data connection line on the base substrate is not overlapped with an orthographic projection of the first data connection line on the base substrate; an orthographic projection of the third data connection line on the base substrate is at least partially overlapped with an orthographic projection of one of the second spaces on the base substrate;

the third data connection line extends along the second direction, one end is connected with the fourth data connection line, and the other end is electrically connected with the bonding region; the fourth data connection line extends along the first direction, one end is connected with the third data connection line, and the other end is electrically connected with one of the data signal lines in the fifth conductive layer through a via.

9. The display substrate according to claim 8, wherein in a same second space, a quantity of third data connection lines is one, a quantity of second data connection lines is two, and an orthographic projection of a third data connection line on the base substrate is located between orthographic projections of two second data connection lines on the base substrate;

or, in a same second space, a quantity of third data connection lines is two, a quantity of second data connection lines is one, and an orthographic projection of a second data connection line on the base substrate is located between orthographic projections of two third data connection lines on the base substrate;

there is an overlapping region between orthographic projections of a second data connection line and a third data connection line on the base substrate and an orthographic projection of the switch connection electrode on the base substrate, and there is no overlapping region between the orthographic projections of the second data connection line and the third data connection line on the base substrate and an orthographic projection of the second initial signal line on the base substrate.

10. The display substrate according to any one of claims 6 to 9, wherein the pixel drive circuit further comprises: a first transistor to a sixth transistor, and a storage capacitor;

on a plane parallel to the display substrate, in a same pixel drive circuit, in the first direction, the sixth transistor is located on one side of the storage capacitor, and the fifth transistor and the fourth transistor are located on the other side of the storage capacitor; in the second direction, the fifth transistor, the sixth transistor, and the seventh transistor are located on a same side of the storage capacitor, the fourth transistor, the first transistor, and the second transistor are located on the other side of the storage capacitor, and the seventh transistor is located on a side of the sixth transistor away from the storage capacitor, the first transistor is located on a side of the second transistor away from the storage capacitor, and there is an overlapping region between an orthographic projection of the storage capacitor on the base substrate and an orthographic projection of the third transistor on the base substrate; a seventh transistor in an i-th row of sub-pixels is disposed in an (i-1)-th row of sub-pixels, wherein i=2, 3, ..., K;

in the second direction, in two sub-pixel rows adjacent to the first data connection line, a first transistor of a previous sub-pixel row and a fifth transistor and a sixth transistor of a next sub-pixel row are located on both sides of the first data connection line, and a seventh transistor of the next sub-pixel row and the first transistor of the previous sub-pixel row are located on a same side of the first data connection line; in two sub-pixel rows adjacent to the fourth data connection line, a first transistor of a previous sub-pixel row, and a fifth transistor and a sixth transistor of a next sub-pixel row are located on both sides of the fourth data connection line, and a seventh transistor of the next sub-pixel row and the first transistor of the previous sub-pixel row are located on a same side of the fourth data connection line; in the first direction, a total number of second data connection lines and third data connection lines is three, three data connection lines are arranged along the first direction line, two data connection lines located on both sides are symmetrical with respect to a data connection lines located at a middle position, and in a same sub-pixel row, a first transistor to a seventh transistor and a storage capacitor in two sub-pixel columns adjacent to a second data connection line and a third data connection line located in a same second space are symmetrical with respect to a data connection line located at a middle position.

11. The display substrate according to claim 10, wherein in the fourth conductive layer, the fourth data connection line is of an integrally formed structure with a first electrode of a fourth transistor in one of pixel drive circuits, and the first electrode of the fourth transistor integrally formed with the fourth data connection line is of a strip structure or a polyline structure, and extends along the second direction, one terminal is connected with the fourth data connection line, and the other terminal is electrically connected with a data signal line in the fifth conductive layer through a via; one end of the fourth data connection line is connected with the first electrode of the fourth transistor, and the other end is connected with the third data connection line;

the first data connection line is of an integrally formed structure with a first electrode of one of fourth transistors, and the first electrode of the fourth transistor integrally formed with the first data connection line is of a strip structure or a polyline structure, and extends along the second direction, one terminal is connected with the first data connection line, and the other terminal is electrically connected with a data signal line in the fifth conductive layer through a via; one end of the first data connection line is connected with the first electrode of the fourth transistor, and the other end is electrically connected with a second data connection line in the fifth conductive layer through a via.

12. The display substrate according to claim 5, wherein in a same second space, a quantity of second data connection lines is three, and orthographic projections of three second data connection lines on the base substrate are not overlapped, the three second data connection lines are electrically connected with first data connection lines in three different first spaces in the fourth conductive layer through three different vias, respectively; the display substrate further comprises a light emitting element, and the pixel drive circuit further comprises: a seventh transistor for resetting an anode of the light emitting element; the fourth conductive layer further comprises an initial signal connection line and a plurality of second initial signal lines; a second initial signal line is connected with an active layer of a seventh transistor in the first semiconductor layer through a via and multiplexed as a first electrode of the seventh transistor; in a plane where the fourth conductive layer is located, a main body portion of the second initial signal line is in a polyline shape extending along the first direction, and the plurality of second initial signal lines are arranged along the second direction; the initial signal connection line extends along the second direction and is integrally formed with the plurality of second initial signal lines.

13. The display substrate according to claim 12, wherein among the three second data connection lines, there is an overlapping region between an orthographic projection of a second data connection line at a middle position on the base substrate and an orthographic projection of the initial signal connection line on the base substrate, and there is an overlapping region between orthographic projections of second data connection lines located on both sides on the base substrate and an orthographic projection of the second initial signal line on the base substrate.

14. The display substrate according to claim 12 or 13, wherein the pixel drive circuit further comprises: a first transistor to a sixth transistor, and a storage capacitor;

on a plane parallel to the display substrate, in a same pixel drive circuit, in the first direction, the sixth transistor is located on one side of the storage capacitor, and the fifth transistor and the fourth transistor are located on the other side of the storage capacitor; in the second direction, the fifth transistor, the sixth transistor, and the seventh transistor are located on a same side of the storage capacitor, the fourth transistor, the first transistor, and the second transistor are located on the other side of the storage capacitor, and the seventh transistor is located on a side of the sixth transistor away from the storage capacitor, the first transistor is located on a side of the second transistor away from the storage capacitor, and there is an overlapping region between an orthographic projection of the storage capacitor on the base substrate and an orthographic projection of the third transistor on the base substrate; a seventh transistor in an i-th row of sub-pixels is disposed in an (i-1)-th row of sub-pixels, wherein i=2, 3, ..., K;

in the second direction, in two sub-pixel rows adjacent to the first data connection line, a first transistor of a previous sub-pixel row and a fifth transistor and a sixth transistor of a next sub-pixel row are located on both sides of the first data connection line, and a seventh transistor of the next sub-pixel row and the first transistor of the previous sub-pixel row are located on a same side of the first data connection line; in the first direction, three second data connection lines are arranged in sequence, second data connection lines located on both sides are symmetrical with respect to a second data connection line located at a middle position, and in a same sub-pixel row, a first transistor to a seventh transistor and a storage capacitor in two sub-pixel columns adjacent to three second data connection lines are symmetrical with respect to a second data connection line located at a middle position.

15. The display substrate according to claim 14, wherein in the fourth conductive layer, the first data connection line is of an integrally formed structure with a first electrode of one of fourth transistors, and the first electrode of the fourth transistor integrally formed with the first data connection line is of a strip structure or a polyline structure, and extends along the second direction, one terminal is connected with the first data connection line, and the other terminal is electrically connected with a data signal line in the fifth conductive layer through a via; one end of the first data connection line is connected with the first electrode of the fourth transistor, and the other end is electrically connected with a second data connection line in the fifth conductive layer through a via.

16. The display substrate according to any one of claims 5 to 9 and 11 to 12, wherein there is an overlapping region between an orthographic projection of one end of the first data connection line on the base substrate and an orthographic projection of one of second data connection lines on the base substrate, the one end of the first data connection line is electrically connected with the second data connection line through a via in the overlapping region of projections, there is an overlapping region between an orthographic projection of the other end on the base substrate and an orthographic projection of one of the data signal lines on the base substrate, and the other end is electrically connected with the data signal line through a via in the overlapping region of projections.

17. A display apparatus, comprising a display substrate according to any one of claims 1 to 16.

FIG. 1

FIG. 2

P    P3 P1 P2 P4

FIG. 3

FIG. 4

FIG. 5

FIG. 6

FIG. 7a

FIG. 7b

FIG. 8a

FIG. 8b

FIG. 8c

N-th column | (N+1)-th column | (N+2)-th column | (N+3)-th column

12

14

11

13

13

12

12

M-th row

(M+1)-th row

X

Y

FIG. 9

FIG. 10a

FIG. 10b

FIG. 11a

N-th column | (N+1)-th column | (N+2)-th column | (N+3)-th column

32

33

31

M-th row

32

33

31

X

Y

(M+1)-th row

FIG. 11b

FIG. 12a

FIG. 12b

FIG. 13a

N-th column | (N+1)-th column | (N+2)-th column | (N+3)-th column

22-2

22

21-2/22-1

21

21-1

M-th row

(M+1)-th row

X

Y

FIG. 13b

FIG. 14a

N-th column | (N+1)-th column | (N+2)-th column | (N+3)-th column

52

51

M-th row

(M+1)-th row

X

Y

FIG. 14b

FIG. 15

N-th column | (N+1)-th column | (N+2)-th column | (N+3)-th column

M-th row

(M+1)-th row

T7

T6

T5

T3

T2

T4

T7

T1

X

Y

FIG. 16a

N-th column | (N+1)-th column | (N+2)-th column | (N+3)-th column

65

66

63

61

69

67

64

62

68

M-th
row

(M+1)-th
row

X

Y

FIG. 16b

FIG. 16c

FIG. 16d

FIG. 17a

EP 4 415 500 A1

FIG. 17b

FIG. 18a

N-th column | (N+1)-th column | (N+2)-th column | (N+3)-th column

73

72

71

M-th row

(M+1)-th row

X

Y

74

FIG. 18b

FIG. 18c

FIG. 19a

N-th column | (N+1)-th column | (N+2)-th column | (N+3)-th column

M-th row

(M+1)-th row

27-1

27

25-1

27-2\26-2

25

26

23

23-1\
24-2\
25-2

23-2\26-1

24

24-1

X

Y

FIG. 19b

FIG. 20a

FIG. 20b

N-th column | (N+1)-th column | (N+2)-th column | (N+3)-th column

M-th row

(M+1)-th row

T7  T6

T5

T3

T4

X

Y

T7

FIG. 21

FIG. 22

FIG. 23a

FIG. 23b

FIG. 24

FIG. 25a

N-th column | (N+1)-th column | (N+2)-th column | (N+3)-th column

M-th row

(M+1)-th row

65
66
63
61
610
67
64
62
611
610

X
Y

FIG. 25b

FIG. 25c

FIG. 25d

FIG. 26a

FIG. 26b

FIG. 27a

FIG. 27b

FIG. 27c

## INTERNATIONAL SEARCH REPORT

| | International application No. |
|---|---|
| | **PCT/CN2022/118241** |

**A. CLASSIFICATION OF SUBJECT MATTER**

H10K50/10(2023.01)i;G09G3/32(2016.01)i

According to International Patent Classification (IPC) or to both national classification and IPC

**B. FIELDS SEARCHED**

Minimum documentation searched (classification system followed by classification symbols)

IPC: H10K50，G09G3，G09F9

Documentation searched other than minimum documentation to the extent that such documents are included in the fields searched

Electronic data base consulted during the international search (name of data base and, where practicable, search terms used)

CNABS, CNTXT, VEN, ENTXT, ENTXTC, USTXT: 显示, 面板, 基板, 绑定, 邦定, 数据, 相邻, 空间, 水平, 垂直, 竖直, 像素行, 连接线, 第二, display, panel, substrate, bonding, data, adjacent, room, space, horizontal, vertical, pixel, connect+, line, second

**C. DOCUMENTS CONSIDERED TO BE RELEVANT**

| Category* | Citation of document, with indication, where appropriate, of the relevant passages | Relevant to claim No. |
|---|---|---|
| Y | CN 114730538 A (BOE TECHNOLOGY GROUP CO., LTD. et al.) 08 July 2022 (2022-07-08) description, paragraphs 82-210, and figures 1-20b | 1-17 |
| Y | CN 113268176 A (WUHAN CHINA STAR OPTOELECTRONICS TECHNOLOGY CO., LTD. et al.) 17 August 2021 (2021-08-17) description, paragraph 34, and figure 4 | 1-17 |
| Y | CN 114497151 A (WUHAN CHINA STAR OPTOELECTRONICS SEMICONDUCTOR DISPLAY TECHNOLOGY CO., LTD.) 13 May 2022 (2022-05-13) description, paragraphs 40-81, and figures 1-7 | 1-17 |
| Y | CN 114648921 A (YUNGU (GU'AN) TECHNOLOGY CO., LTD.) 21 June 2022 (2022-06-21) description, paragraphs 40-100, and figures 1-14 | 1-17 |
| Y | CN 114695491 A (BOE TECHNOLOGY GROUP CO., LTD. et al.) 01 July 2022 (2022-07-01) description, paragraphs 54-85, and figures 1-22 | 1-17 |

☑ Further documents are listed in the continuation of Box C. ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **28 February 2023** | **03 March 2023** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| Facsimile No. **(86-10)62019451** | Telephone No. |

Form PCT/ISA/210 (second sheet) (July 2022)

**EP 4 415 500 A1**

<div align="center">

**INTERNATIONAL SEARCH REPORT**

</div>

| International application No. |
| --- |
| **PCT/CN2022/118241** |

**C.     DOCUMENTS CONSIDERED TO BE RELEVANT**

| Category* | Citation of document, with indication, where appropriate, of the relevant passages | Relevant to claim No. |
| --- | --- | --- |
| Y | CN 114784082 A (BOE TECHNOLOGY GROUP CO., LTD. et al.) 22 July 2022 (2022-07-22) <br> description, paragraphs 47-306, and figures 1-26 | 1-17 |
| Y | CN 114937686 A (BOE TECHNOLOGY GROUP CO., LTD. et al.) 23 August 2022 (2022-08-23) <br> description, paragraphs 56-361, and figures 1-44 | 1-17 |
| Y | CN 115004376 A (BOE TECHNOLOGY GROUP CO., LTD. et al.) 02 September 2022 (2022-09-02) <br> description, paragraphs 95-275, and figures 1-26c | 1-17 |
| A | US 2011017994 A1 (AU OPTRONICS CORP.) 27 January 2011 (2011-01-27) <br> entire document | 1-17 |

Form PCT/ISA/210 (second sheet) (July 2022)

**INTERNATIONAL SEARCH REPORT**
Information on patent family members

International application No.

**PCT/CN2022/118241**

| Patent document cited in search report | | | Publication date (day/month/year) | Patent family member(s) | | | Publication date (day/month/year) |
|---|---|---|---|---|---|---|---|
| CN | 114730538 | A | 08 July 2022 | None | | | |
| CN | 113268176 | A | 17 August 2021 | None | | | |
| CN | 114497151 | A | 13 May 2022 | None | | | |
| CN | 114648921 | A | 21 June 2022 | None | | | |
| CN | 114695491 | A | 01 July 2022 | None | | | |
| CN | 114784082 | A | 22 July 2022 | None | | | |
| CN | 114937686 | A | 23 August 2022 | None | | | |
| CN | 115004376 | A | 02 September 2022 | None | | | |
| US | 2011017994 | A1 | 27 January 2011 | US | 7982219 | B2 | 19 July 2011 |
| | | | | TW | 201104325 | A | 01 February 2011 |
| | | | | TWI | 396026 | B | 11 May 2013 |

Form PCT/ISA/210 (patent family annex) (July 2022)